(19) Europäisches Patentamt
European Patent Office
Office européen des brevets

(11) **EP 3 367 456 B1**

(12) **EUROPEAN PATENT SPECIFICATION**

(45) Date of publication and mention of the grant of the patent:
**26.03.2025 Bulletin 2025/13**

(21) Application number: **18158782.5**

(22) Date of filing: **27.02.2018**

(51) International Patent Classification (IPC):
***H10K 85/60*** *(2023.01)* ***C09K 11/06*** *(2006.01)*
*H10K 50/11* *(2023.01)* *H10K 101/20* *(2023.01)*
*H10K 102/00* *(2023.01)*

(52) Cooperative Patent Classification (CPC):
**C09K 11/06; H10K 50/11; H10K 85/6574;**
H10K 85/633; H10K 85/654; H10K 2101/20;
H10K 2102/00

(54) **ORGANIC LIGHT-EMITTING DEVICE**
ORGANISCHE LICHTEMITTIERENDE VORRICHTUNG
DISPOSITIF ÉLECTROLUMINESCENT ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.02.2017 KR 20170026476**
**26.02.2018 KR 20180022853**

(43) Date of publication of application:
**29.08.2018 Bulletin 2018/35**

(73) Proprietor: **Samsung Electronics Co., Ltd.**
**Suwon-si, Gyeonggi-do 16677 (KR)**

(72) Inventors:
- **IHN, Sooghang**
  **16678 Gyeonggi-do, (KR)**
- **SON, Wonjoon**
  **16678 Gyeonggi-do, (KR)**
- **KANG, Hosuk**
  **16678 Gyeonggi-do, (KR)**
- **SIM, Myungsun**
  **16678 Gyeonggi-do, (KR)**
- **KIM, Sunghan**
  **16678 Gyeonggi-do, (KR)**
- **NUMATA, Masaki**
  **16678 Gyeonggi-do, (KR)**
- **MIYAZAKI, Hiroshi**
  **16678 Gyeonggi-do, (KR)**
- **LEE, Saeyoun**
  **16678 Gyeonggi-do, (KR)**
- **JEON, Soonok**
  **16678 Gyeonggi-do, (KR)**

(74) Representative: **Elkington and Fife LLP**
**Prospect House**
**8 Pembroke Road**
**Sevenoaks, Kent TN13 1XR (GB)**

(56) References cited:
**EP-A1- 2 733 761** **EP-A1- 2 733 762**
**EP-A1- 3 020 783** **US-A1- 2012 241 732**

- **IN HO LEE ET AL: "High efficiency blue fluorescent organic light-emitting diodes using a conventional blue fluorescent emitter", JOURNAL OF MATERIALS CHEMISTRY C: MATERIALS FOR OPTICAL AND ELECTRONIC DEVICES, vol. 3, no. 34, 1 January 2015 (2015-01-01), UK, pages 8834 - 8838, XP055488135, ISSN: 2050-7526, DOI: 10.1039/C5TC01626F**
- **RAFAEL GÓMEZ-BOMBARELLI ET AL: "Design of efficient molecular organic light-emitting diodes by a high-throughput virtual screening and experimental approach", NATURE MATERIALS, vol. 15, no. 10, 1 October 2016 (2016-10-01), GB, pages 1120 - 1127, XP055488129, ISSN: 1476-1122, DOI: 10.1038/nmat4717**
- **HIROKI UOYAMA ET AL: "Highly efficient organic light-emitting diodes from delayed fluorescence", NATURE, vol. 492, no. 7428, 12 December 2012 (2012-12-12), London, pages 234 - 238, XP055048388, ISSN: 0028-0836, DOI: 10.1038/nature11687**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 367 456 B1

## Description

FIELD OF THE INVENTION

One or more embodiments relate to an organic light-emitting device.

BACKGROUND OF THE INVENTION

Organic light-emitting devices (OLEDs) are self-emission devices that produce full-color images, and also have wide viewing angles, high contrast ratios, short response times, as well as excellent characteristics in terms of brightness, driving voltage, and response speed.

An example of such organic light-emitting devices may include an anode, a cathode, and an organic layer that is disposed between the anode and the cathode, wherein the organic layer includes an emission layer. A hole transport region may be disposed between the anode and the emission layer, and an electron transport region may be disposed between the emission layer and the cathode. Holes provided from the anode may move toward the emission layer through the hole transport region, and electrons provided from the cathode may move toward the emission layer through the electron transport region. Carriers, such as holes and electrons, recombine in an emission layer to produce excitons. These excitons transit from an excited state to a ground state, thereby generating light.

Various types of organic light emitting devices are known. Documents EP 2 733 762 A1, US 2012/0241732 A1, IN HO LEE ET AL: "High efficiency blue fluorescent organic light-emitting diodes using a conventional blue fluorescent emitter", JOURNAL OF MATERIALS CHEMISTRY C: MATERIALS FOR OPTICAL AND ELECTRONIC DEVICES, vol. 3, no. 34, 1 January 2015 (2015-01-01), pages 8834-8838, RAFAEL GOMEZ-BOMBARELLI ET AL: "Design of efficient molecular organic light-emitting diodes by a high-throughput virtual screening and experimental approach", NATURE MATERIALS, vol. 15, no. 10, 1 October 2016 (2016-10-01), pages 1120-1127 and Hiroki Uoyama ET AL: "Highly efficient organic light-emitting diodes from delayed fluorescence", Nature, vol. 492, no. 7428, 12 December 2012 (2012-12-12), pages 234-238 disclose OLED devices comprising a light emitting layer with a host and a thermally activated delayed fluorescence emitter.

However, there still remains a need in OLEDs having low driving voltage, high efficiency, high brightness, and long lifespan.

SUMMARY OF THE INVENTION

One or more embodiments include an organic light-emitting device that includes a host and a dopant satisfying a certain condition and has excellent characteristics in terms of external quantum efficiency and roll-off ratio.

Additional aspects will be set forth in part in the description which follows and, in part, will be apparent from the description, or may be learned by practice of the presented embodiments.

According to the invention, an organic light-emitting device includes:

a first electrode;
a second electrode facing the first electrode; and
an organic layer that is disposed between the first electrode and the second electrode, wherein the organic layer includes an emission layer,
wherein the emission layer includes a thermally activated delayed fluorescence (TADF) emitter and a host and the TADF emitter is different from the host, the host does not comprise DPEPO, and
the TADF emitter satisfies Condition 1-1 or Condition 1-2:

Condition 1-1
a condition that n1 is one, and
Condition 1-2
a condition that, when n1 is two or more, $(I_1 / I_2) \times 100(\%)$ is less than 110%. In Condition 1-1 and Condition 1-2, $I_1$ (arbitrary units) is emission intensity at the shortest peak emission wavelength in a photoluminescence spectrum 1,
1) when n2 is one, $I_2$ (arbitrary units) is emission intensity at the same peak emission wavelength as the shortest emission wavelength of the photoluminescence spectrum 1 in the photoluminescence spectrum 2, and 2) when n2 is two or more, $I_2$ (arbitrary units) is emission intensity at the shortest peak emission wavelength in a photoluminescence spectrum 2,
the photoluminescence spectrum 1 is a photoluminescence spectrum of a film 1 that is doped with 15 percent by volume of the TADF emitter in a matrix with the host included in the emission layer and has a thickness of 50

nanometers, and
the photoluminescence spectrum 2 is a photoluminescence spectrum of a film 2 that is doped with 15 percent by volume of the TADF emitter in a matrix with DPEPO and has a thickness of 50 nanometers:
DPEPO

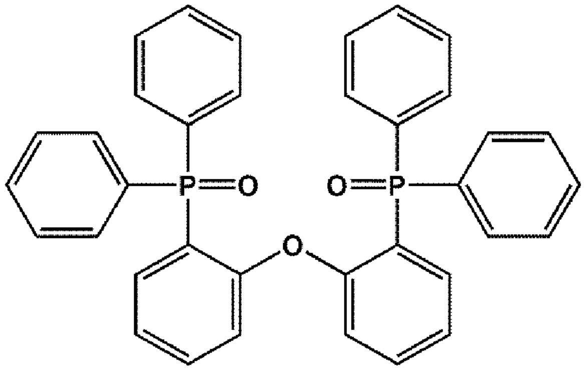

.

n1 is the number of distinguishable emission peaks in the photoluminescence spectrum 1, and n2 is the number of distinguishable emission peaks in the photoluminescence spectrum 2, and the TADF emitter is a compound of Formula (1) as defined in claim 1.

## BRIEF DESCRIPTION OF THE DRAWINGS

These and/or other aspects will become apparent and more readily appreciated from the following description of the embodiments, taken in conjunction with the accompanying drawings in which:

FIG. 1 is a schematic view of an organic light-emitting device according to an embodiment;
FIGS. 2 to 7 are graphs of intensity (arbitrary units, a.u.) versus wavelength (nanometers, nm), which illustrate photoluminescence spectra of film 1, 2, 3, 4, A, and B;
FIGS. 8 to 13 are tables showing attachment-detachment overlap densities of rotamers (10x°) of Compounds 1, 2, 3, 4, A, and B;
FIG. 14 is a graph showing rotational conformational energy (electron volts, eV), CTosc (electron volts, eV), LEosc (electron volts, eV), a charge transfer state (CT) energy level (electron volts, eV), and a locally excited state (LE) energy level (electron volts, eV) with respect to each rotamer (10x°) of Compound 1;
FIG. 15 is a graph showing rotational conformational energy (electron volts, eV), CTosc (electron volts, eV), LEosc (electron volts, eV), a CT energy level (electron volts, eV), and an LE energy level (electron volts, eV) with respect to each rotamer (10x°) of Compound 2;
FIG. 16 is a graph showing rotational conformational energy (electron volts, eV), CTosc (electron volts, eV), LEosc (electron volts, eV), a CT energy level (electron volts, eV), and an LE energy level (electron volts, eV) with respect to each rotamer (10x°) of Compound 4;
FIG. 17 is a graph showing rotational conformational energy (electron volts, eV), CTosc (electron volts, eV), LEosc (electron volts, eV), a CT energy level (electron volts, eV), and an LE energy level (electron volts, eV) with respect to each rotamer (10x°) of Compound A; and
FIG. 18 is a graph showing rotational conformational energy (electron volts, eV), CTosc (electron volts, eV), LEosc (electron volts, eV), a CT energy level (electron volts, eV), and an LE energy level (electron volts, eV) with respect to each rotamer (10x°) of Compound B.

## DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly in contact

with the other element or intervening elements may be present therebetween. In contrast, when an element is referred to as being "directly on" another element, there are no intervening elements present.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

The terminology used herein is for the purpose of describing particular embodiments only and is not intended to be limiting. As used herein, the singular forms "a," "an," and "the" are intended to include the plural forms as well, unless the context clearly indicates otherwise.

The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within $\pm$ 30%, 20%, 10%, 5% of the stated value.

In an embodiment, an organic light-emitting device is provided. The organic light-emitting device, according to an embodiment, may include:

a first electrode;
a second electrode facing the first electrode; and
an organic layer that is disposed between the first electrode and the second electrode, wherein the organic layer includes an emission layer,
wherein the emission layer includes a thermally activated delayed fluorescence (TADF) emitter and a host and the TADF emitter is different from the host, the host does not comprise DPEPO, provided that the TADF emitter satisfies Condition 1-1 or Condition 1-2:

Condition 1-1
a condition that n1 is one, and
Condition 1-2
a condition that, when n1 is two or more, $(I_1 / I_2)$ x 100(%) is less than 110%. In Condition 1-1 and Condition 1-2, $I_1$ (a.u.) is emission intensity at the shortest peak emission wavelength in a photoluminescence spectrum 1, wherein "a.u." denotes "arbitrary units",
1) when n2 is one, $I_2$ (a.u.) is emission intensity at the same emission wavelength as the shortest peak emission wavelength of the photoluminescence spectrum 1 in the photoluminescence spectrum 2, and 2) when n2 is two or more, $I_2$ (a.u.) is emission intensity at the shortest peak emission wavelength in a photoluminescence spectrum 2,
the photoluminescence spectrum 1 is a photoluminescence spectrum of a film 1 that is doped with 15 percent by volume (vol%) of the TADF emitter in a matrix with the host included in the emission layer and has a thickness of 50 nanometers (nm), and
the photoluminescence spectrum 2 is a photoluminescence spectrum of a film 2 that is doped with 15 vol% of the TADF emitter in a matrix with DPEPO and has a thickness of 50 nm:

DPEPO

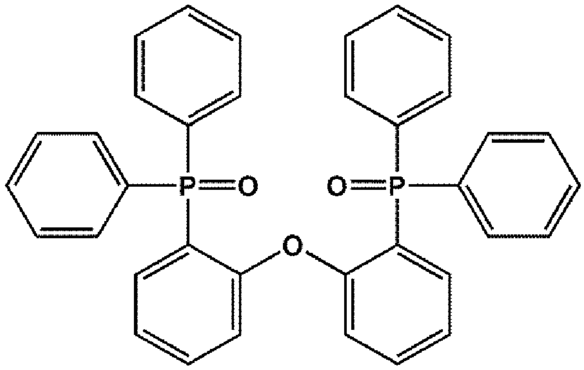

.

n1 is the number of distinguishable emission peaks in the photoluminescence spectrum 1, and n2 is the number of distinguishable emission peaks in the photoluminescence spectrum 2.

For example, the $I_1$ and the $I_2$ may have same unit.

When the TADF emitter satisfies Condition 1-1 or Condition 1-2, the TADF emitter may have excellent delayed fluorescence characteristics without severe dual fluorescence.

In accordance with the invention the TADF emitter is a compound represented by Formula 1:

Formula 1 $R_1\text{-}(D_2)_{d1}\text{-}D_1\text{-}(L_1)_{a1}\text{-}A_1$.

In Formula 1,

$L_1$ may be selected from:

a single bond, a cyclopentane group, a cyclohexane group, a cycloheptane group, a cyclooctane group, a cyclopenpentene group, a cyclohexene group, a cycloheptene group, a benzene group, a naphthalene group, a fluorene group, a phenanthrene group, an anthracene group, a fluoranthene group, a triphenylene group, a pyrene group, a chrysene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyradizine group, an iso-indole group, an indole group, an indazole group, a purine group, a quinoline group, an isoquinoline group, a benzoquinoline group, a quinoxaline group, a quinazoline group, a cinnoline group, a phenanthroline group, a benzimidazole group, a benzofuran group, a benzothiophene group, a benzoxazole group, an isobenzoxazole group, a triazole group, a tetrazole group, an oxadiazole group, a triazine group, a dibenzofuran group, a dibenzothiophene group, a benzocarbazole group, a dibenzocarbazole group, an imidazopyridine group, an imidazopyrimidine group, an azaindole group, an azaindene group, an azabenzofuran group, an azabenzothiophene group, an azacarbazole group, an azafluorene group, an azadibenzofuran group, and an azadibenzothiophene group; and

a cyclopentane group, a cyclohexane group, a cycloheptane group, a cyclooctane group, a cyclopenpentene group, a cyclohexene group, a cycloheptene group, a benzene group, a naphthalene group, a fluorene group, a phenanthrene group, an anthracene group, a fluoranthene group, a triphenylene group, a pyrene group, a chrysene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyradizine group, an iso-indole group, an indole group, an indazole group, a purine group, a quinoline group, an isoquinoline group, a benzoquinoline group, a quinoxaline group, a quinazoline group, a cinnoline group, a phenanthroline group, a benzimidazole group, a benzofuran group, a benzothiophene group, a benzoxazole group, an isobenzoxazole group, a triazole group, a tetrazole group, an oxadiazole group, a triazine group, a dibenzofuran group, a dibenzothiophene group, a benzocarbazole group, a dibenzocarbazole group, an imidazopyridine group, an imidazopyrimidine group, an azaindole group, an azaindene group, an azabenzofuran group, an azabenzothiophene group, an azacarbazole group, an azafluorene group, an azadibenzofuran group, and an azadibenzothiophene group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a ($C_1$-$C_{20}$ alkyl)phenyl group, a di($C_1$-$C_{20}$ alkyl)phenyl group, a tri($C_1$-$C_{20}$ alkyl)phenyl group, a ($C_6$-$C_{20}$ aryl)phenyl group, a di($C_6$-$C_{20}$ aryl)phenyl group, a tri($C_6$-$C_{20}$ aryl)phenyl

group, a ($C_3$-$C_{20}$ heteroaryl)phenyl group, a di($C_3$-$C_{20}$ heteroaryl)phenyl group, a pyridinyl group, a ($C_1$-$C_{20}$ alkyl) pyridinyl group, a di($C_1$-$C_{20}$ alkyl)pyridinyl group, a ($C_6$-$C_{20}$ aryl)pyridinyl group, a di($C_6$-$C_{20}$ aryl)pyridinyl group, a ($C_3$-$C_{20}$ heteroaryl)pyridinyl group, a di($C_3$-$C_{20}$ heteroaryl)pyridinyl group, a pyrimidinyl group, a ($C_1$-$C_{20}$ alkyl) pyrimidinyl group, a di($C_1$-$C_{20}$ alkyl)pyrimidinyl group, a ($C_6$-$C_{20}$ aryl)pyrimidinyl group, a di($C_6$-$C_{20}$ aryl)pyrimidinyl group, a ($C_3$-$C_{20}$ heteroaryl)pyrimidinyl group, a di($C_3$-$C_{20}$ heteroaryl)pyrimidinyl group, a triazinyl group, a ($C_1$-$C_{20}$ alkyl)triazinyl group, a di($C_1$-$C_{20}$ alkyl)triazinyl group, a ($C_6$-$C_{20}$ aryl)triazinyl group, a di($C_6$-$C_{20}$ aryl)triazinyl group, a ($C_3$-$C_{20}$ heteroaryl)triazinyl group, and a di($C_3$-$C_{20}$ heteroaryl)triazinyl group,

a1 may be an integer from 1 to 5,

$D_1$ and $D_2$ may each be an electron donor group,

d1 may be an integer from 0 to 5,

$A_1$ is selected from a substituted or unsubstituted $\pi$-electron-depleted nitrogen-containing $C_2$ -$C_{60}$ heterocyclic group and a sulphonyl-containing group, and

$R_1$ may be selected from:

hydrogen, deuterium, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_5$-$C_{60}$ carbocyclic group, and a $\pi$ electron-depleted nitrogen-free $C_2$-$C_{60}$ heterocyclic group; and a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_5$-$C_{60}$ carbocyclic group, and a $\pi$ electron-depleted nitrogen-free $C_2$-$C_{60}$ heterocyclic group, each substituted with at least one selected from deuterium, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_5$-$C_{60}$ carbocyclic group, a ($C_1$-$C_{10}$ alkyl)$C_5$-$C_{60}$ carbocyclic group, a di($C_1$-$C_{10}$ alkyl)$C_5$-$C_{60}$ carbocyclic group, a (phenyl)$C_5$-$C_{60}$ carbocyclic group, a di(phenyl)$C_5$-$C_{60}$ carbocyclic group, a (biphenyl)$C_5$-$C_{60}$ carbocyclic group, a di(biphenyl)$C_5$-$C_{60}$ carbocyclic group, a $\pi$ electron-depleted nitrogen-free $C_2$-$C_{60}$ heterocyclic group, a ($C_1$-$C_{10}$ alkyl) $\pi$ electron-depleted nitrogen-free $C_2$-$C_{60}$ heterocyclic group, a di($C_1$-$C_{10}$ alkyl) $\pi$ electron-depleted nitrogen-free $C_2$-$C_{60}$ heterocyclic group, a (phenyl) $\pi$ electron-depleted nitrogen-free $C_2$-$C_{60}$ heterocyclic group, a di(phenyl) $\pi$ electron-depleted nitrogen-free $C_2$-$C_{60}$ heterocyclic group, a (biphenyl) $\pi$ electron-depleted nitrogen-free $C_2$-$C_{60}$ heterocyclic group, and a di(biphenyl) $\pi$ electron-depleted nitrogen-free $C_2$-$C_{60}$ heterocyclic group,

provided that,

i) d1 is an integer from 1 to 5; or

ii) when d1 is zero, $A_1$ is selected from groups represented by Formulae 3-6(1), 3-10(8), and 3-12(24):

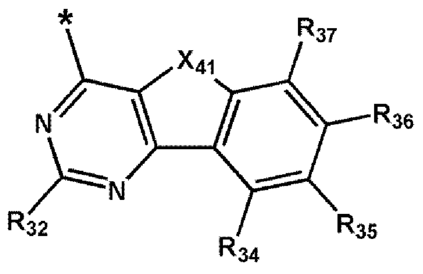

Formula 3-6(1)

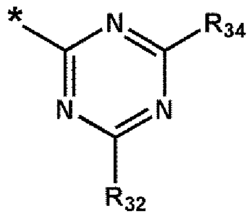

Formula 3-10(8)

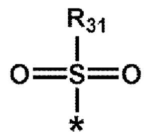

Formula 3-12(24)

.

In Formulae 3-6(1), 3-10(8), and 3-12(24),

$X_{41}$ may **be** N($R_{41}$), C($R_{42}$)($R_{43}$), O, **or** S,

$R_{31}$, $R_{32}$, $R_{34}$ to $R_{37}$ and $R_{41}$ to $R_{43}$ may each independently be selected from hydrogen, deuterium, -F, -Cl, -Br, -I, $-CD_3$, $-CD_2H$, $-CDH_2$, $-CF_3$, $-CF_2H$, - $CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a ($C_1$-$C_{20}$ alkyl)phenyl group, a di($C_1$-$C_{20}$ alkyl)phenyl group, a tri($C_1$-$C_{20}$ alkyl)phenyl group, a ($C_6$-$C_{20}$ aryl)phenyl group, a di($C_6$-$C_{20}$ aryl)phenyl group, a tri($C_6$-$C_{20}$ aryl)phenyl group, a ($C_3$-$C_{20}$ heteroaryl)phenyl group, a di($C_3$-$C_{20}$ heteroaryl)phenyl group, a pyridinyl group, a ($C_1$-$C_{20}$ alkyl)pyridinyl group, a di($C_1$-$C_{20}$ alkyl)pyridinyl group, a ($C_6$-$C_{20}$ aryl)pyridinyl group, a di($C_6$-$C_{20}$ aryl)pyridinyl group, a ($C_3$-$C_{20}$ heteroaryl)pyridinyl group, a di($C_3$-$C_{20}$ heteroaryl) pyridinyl group, a pyrimidinyl group, a ($C_1$-$C_{20}$ alkyl)pyrimidinyl group, a di($C_1$-$C_{20}$ alkyl)pyrimidinyl group, a ($C_6$-$C_{20}$ aryl)pyrimidinyl group, a di($C_6$-$C_{20}$ aryl)pyrimidinyl group, a ($C_3$-$C_{20}$ heteroaryl)pyrimidinyl group, a di($C_3$-$C_{20}$ heteroaryl)pyrimidinyl group, a triazinyl group, a ($C_1$-$C_{20}$ alkyl)triazinyl group, a di($C_1$-$C_{20}$ alkyl)triazinyl group, a

$(C_6-C_{20}$ aryl)triazinyl group, a di($C_6-C_{20}$ aryl)triazinyl group, a ($C_3-C_{20}$ heteroaryl)triazinyl group, and a di($C_3-C_{20}$ heteroaryl)triazinyl group, and

* indicates a binding site to a neighboring atom.

Formula 1 may be understood by referring to the description provided below.

In an embodiment, the TADF emitter, which is a compound represented by Formula 1, may satisfy Condition 2-1, when assuming that rotamer (0°) is a molecular structure that the TADF emitter has in a gas-phase isolated molecular state, a constant $\alpha$ is an angle between a first plane including $D_1$ and a second plane including $A_1$ in the rotamer (0°), rotamer (10x°) is a molecular structure that the TADF emitter has in a state in which the angle between the first plane and the second plane is changed to $\alpha$ + 10x°, and x is an integer satisfying $-18 \leq x \leq 18$:

Condition 2-1

a condition that attachment-detachment overlap densities of the rotamer (10x°) are all less than 0.65.

In one or more embodiments, the TADF emitter, which is a compound represented by Formula 1, may satisfy Condition 2-2, when assuming that rotamer (0°) is a molecular structure that the TADF emitter has in a gas-phase isolated molecular state, a constant $\alpha$ is an angle between a first plane including $D_1$ and a second plane including $A_1$ in the rotamer (0°), rotamer (10x°) is a molecular structure that the TADF emitter has in a state in which the angle between the first plane and the second plane is changed to $\alpha$ + 10x°, and x is an integer satisfying $-18 \leq x \leq 18$:

Condition 2-2

a condition that at least one 10x, of which an attachment-detachment overlap density of the rotamer (10x°) is 0.65 or more, is present, and rotamer (10x°) for all values 10x, of which an attachment-detachment overlap density of rotamer (10x°) is 0.65 or more, have i) rotational conformational energy of 0.15 eV or more, ii) CTosc greater than LEosc, or iii) rotational conformational energy of 0.15 eV or more and CTosc greater than LEosc.

In Condition 2-2, LEosc is oscillator strength in a locally excited state of the corresponding rotamer (10x°), and CTosc is oscillator strength in a charge transfer state of the corresponding rotamer (10x°).

When the TADF emitter satisfies Condition 2-1 or Condition 2-2, light emission from the locally excited state, which reduces delayed fluorescence, is minimized, and thus, the organic light-emitting device may emit excellent delayed fluorescence.

In Condition 2-1 and Condition 2-2,

1) the attachment-detachment overlap density,
2) the rotational conformational energy,
3) LEosc (oscillator strength in the locally excited state of the rotamer (10x°)), and
4) CTosc (oscillator strength in the charge transfer state of the rotamer (10x°)) were evaluated by density functional theory (DFT) and time-dependent DFT (TD-DFT) methods of a Gaussian program in which a structure was optimized at a CAM-B3LYP/6-31G(d,p).

Hereinafter, Formula 1 will be described.

$L_1$ in Formula 1 may be selected from:

a single bond, a benzene group, a naphthalene group, a fluorene group, a pyridine group, a pyrazine group, a pyrimidine group, a pyradizine group, a quinoline group, an isoquinoline group, a benzoquinoline group, a quinoxaline group, a quinazoline group, and a triazine group; and

a benzene group, a naphthalene group, a fluorene group, a pyridine group, a pyrazine group, a pyrimidine group, a pyradizine group, a quinoline group, an isoquinoline group, a benzoquinoline group, a quinoxaline group, a quinazoline group, and a triazine group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1-C_{20}$ alkyl group, a $C_1-C_{20}$ alkoxy group, a phenyl group, a ($C_1-C_{20}$ alkyl)phenyl group, a di($C_1-C_{20}$ alkyl)phenyl group, a ($C_6-C_{20}$ aryl)phenyl group, a di($C_6-C_{20}$ aryl)phenyl group, a ($C_3-C_{20}$ heteroaryl)phenyl group, a di($C_3-C_{20}$ heteroaryl)phenyl group, a pyridinyl group, a ($C_1-C_{20}$ alkyl)pyridinyl group, a di($C_1-C_{20}$ alkyl)pyridinyl group, a ($C_6-C_{20}$ aryl)pyridinyl group, a di($C_6-C_{20}$ aryl)pyridinyl group, a ($C_3-C_{20}$ heteroaryl)pyridinyl group, a di($C_3-C_{20}$ heteroaryl)pyridinyl group, a pyrimidinyl group, a ($C_1-C_{20}$ alkyl)pyrimidinyl group, a di($C_1-C_{20}$ alkyl)pyrimidinyl group, a ($C_6-C_{20}$ aryl)pyrimidinyl group, a di($C_6-C_{20}$ aryl)pyrimidinyl group, a ($C_3-C_{20}$ heteroaryl)pyrimidinyl group, a di($C_3-C_{20}$ heteroaryl)pyrimidinyl group, a triazinyl group, a ($C_1-C_{20}$

alkyl)triazinyl group, a di($C_1$-$C_{20}$ alkyl)triazinyl group, a ($C_6$-$C_{20}$ aryl)triazinyl group, a di($C_6$-$C_{20}$ aryl)triazinyl group, a ($C_3$-$C_{20}$ heteroaryl)triazinyl group, and a di($C_3$-$C_{20}$ heteroaryl)triazinyl group, and
a1 may be 1 or 2.

In one or more embodiments, $L_1$ in Formula 1 may be selected from:

a single bond, a benzene group, a pyridine group, a pyrimidine group, and a triazine group; and
a benzene group, a pyridine group, a pyrimidine group, and a triazine group, each substituted with at least one selected from deuterium, -F, -Cl, -Br, -I, - $CD_3$, -$CD_2H$, -$CDH_2$, -$CF_3$, -$CF_2H$, -$CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a ($C_1$-$C_{20}$ alkyl)phenyl group, a di($C_1$-$C_{20}$ alkyl)phenyl group, a ($C_6$-$C_{20}$ aryl)phenyl group, a di($C_6$-$C_{20}$ aryl)phenyl group, a ($C_3$-$C_{20}$ heteroaryl)phenyl group, a di($C_3$-$C_{20}$ heteroaryl)phenyl group, a pyridinyl group, a ($C_1$-$C_{20}$ alkyl)pyridinyl group, a di($C_1$-$C_{20}$ alkyl)pyridinyl group, a ($C_6$-$C_{20}$ aryl)pyridinyl group, a di($C_6$-$C_{20}$ aryl)pyridinyl group, a ($C_3$-$C_{20}$ heteroaryl)pyridinyl group, a di($C_3$-$C_{20}$ heteroaryl)pyridinyl group, a pyrimidinyl group, a ($C_1$-$C_{20}$ alkyl)pyrimidinyl group, a di($C_1$-$C_{20}$ alkyl)pyrimidinyl group, a ($C_6$-$C_{20}$ aryl)pyrimidinyl group, a di($C_6$-$C_{20}$ aryl)pyrimidinyl group, a ($C_3$-$C_{20}$ heteroaryl)pyrimidinyl group, a di($C_3$-$C_{20}$ heteroaryl)pyrimidinyl group, a triazinyl group, a ($C_1$-$C_{20}$ alkyl)triazinyl group, a di($C_1$-$C_{20}$ alkyl)triazinyl group, a ($C_6$-$C_{20}$ aryl)triazinyl group, a di($C_6$-$C_{20}$ aryl)triazinyl group, a ($C_3$-$C_{20}$ heteroaryl)triazinyl group, and a di($C_3$-$C_{20}$ heteroaryl)triazinyl group, and
a1 may be 1 or 2, but embodiments of the present disclosure are not limited thereto.

$D_1$ and $D_2$ in Formula 1 may each independently be selected from groups represented by Formulae 11-1 to 11-4:

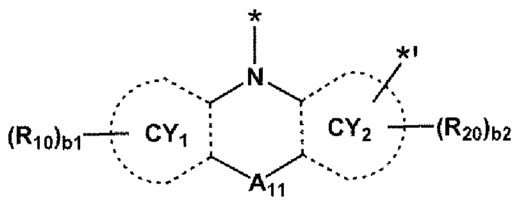

Formula 11-1

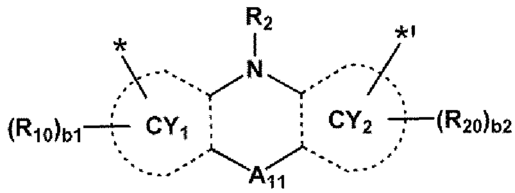

Formula 11-2

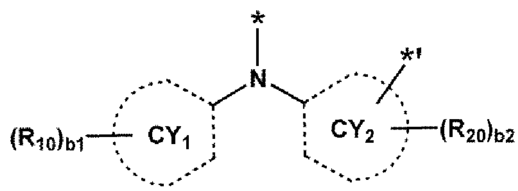

Formula 11-3

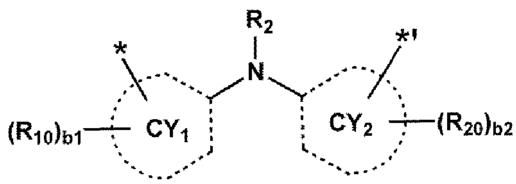

Formula 11-4

.

**In** Formulae 11-1 to 11-4,

$CY_1$ and $CY_2$ may each independently be a $C_5$-$C_{60}$ carbocyclic group or a $C_2$-$C_{60}$ heterocyclic group,
$A_{11}$ may be selected from:

a single bond, a $C_1$-$C_4$ alkylene group, and a $C_2$-$C_4$ alkenylene group; and
a $C_1$-$C_4$ alkylene group and a $C_2$-$C_4$ alkenylene group, each substituted with at least one selected from deuterium, a cyano group, a $C_1$-$C_{60}$ alkyl group, a $C_1$-$C_{60}$ alkoxy group, a phenyl group, a fluorenyl group, a carbazolyl group, a dibenzofuranyl group, and a dibenzothiophenyl group,
$R_2$, $R_{10}$, and $R_{20}$ may each independently be selected from:

hydrogen, deuterium, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group,

a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a furanyl group, a thiophenyl group, an indolyl group, a benzofuranyl group, a benzothiophenyl group, a carbazolyl group, a dibenzofuranyl group, a dibenzothiophenyl group, a benzocarbazolyl group, a naphthobenzofuranyl group, a naphthobenzothiophenyl group, a dibenzocarbazolyl group, a dinaphthofuranyl group, a dinaphthothiophenyl group, an indolocarbazolyl group, an indolodibenzofuranyl group, and an indolodibenzothiophenyl group; and

a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a furanyl group, a thiophenyl group, an indolyl group, a benzofuranyl group, a benzothiophenyl group, a carbazolyl group, a dibenzofuranyl group, a dibenzothiophenyl group, a benzocarbazolyl group, a naphthobenzofuranyl group, a naphthobenzothiophenyl group, a dibenzocarbazolyl group, a dinaphthofuranyl group, a dinaphthothiophenyl group, an indolocarbazolyl group, an indolodibenzofuranyl group, and an indolodibenzothiophenyl group, each substituted with at least one selected from deuterium, a $C_1$-$C_{20}$ alkyl group, a $C_1$-$C_{20}$ alkoxy group, a phenyl group, a biphenyl group, a terphenyl group, a naphthyl group, a fluorenyl group, a dimethylfluorenyl group, a diphenylfluorenyl group, a carbazolyl group, a phenylcarbazolyl group, a biphenylcarbazolyl group, a dibenzofuranyl group, and a dibenzothiophenyl group,

b1 and b2 may each independently be an integer from 0 to 3, and

* and *' each indicate a binding site to a neighboring atom.

For example, $CY_1$ and $CY_2$ may each independently be selected from a benzene group, a naphthalene group, an indene group, an indole group, a benzofuran group, a benzothiophene group, a fluorene group, a carbazole group, a dibenzofuran group, and a dibenzothiophene group, but embodiments of the present disclosure are not limited thereto.

In an embodiment, at least one of $CY_1$ and $CY_2$ may be a benzene group, but embodiments of the present disclosure are not limited thereto.

In an embodiment, $D_1$ and $D_2$ in Formula 1 may each independently be selected from groups represented by Formulae 11(1) to 11(19):

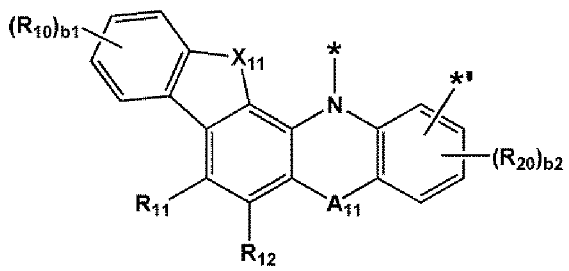

Formula 11(1)

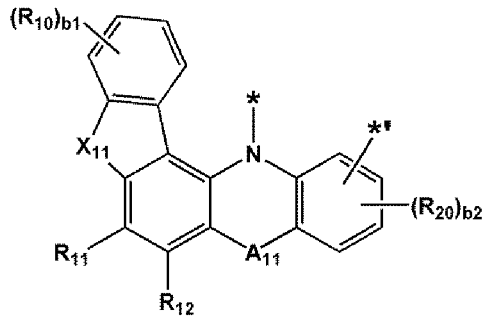

Formula 11(2)

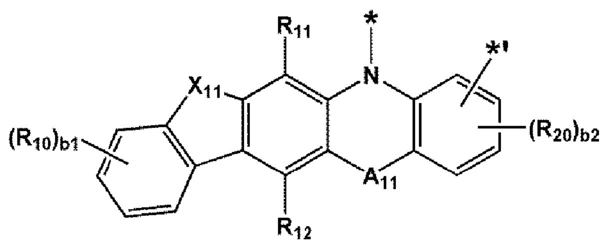

Formula 11(3)

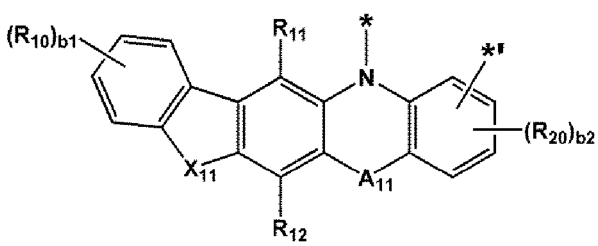

Formula 11(4)

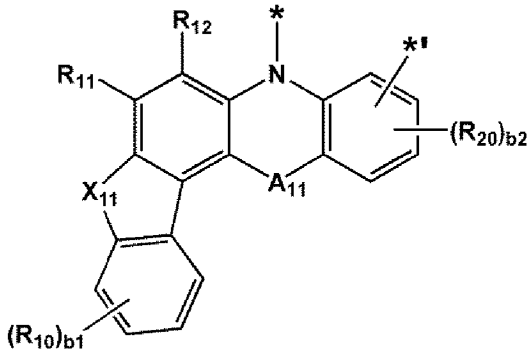

Formula 11(5)

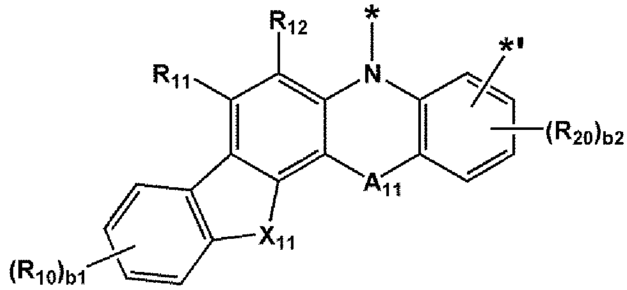

Formula 11(6)

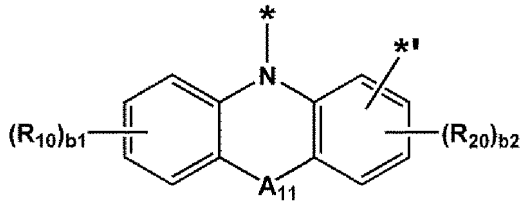

Formula 11(7)

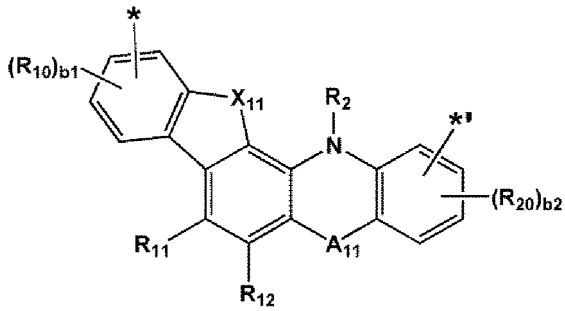

Formula 11(8)

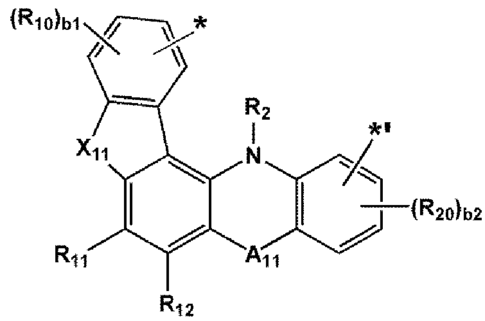

Formula 11(9)

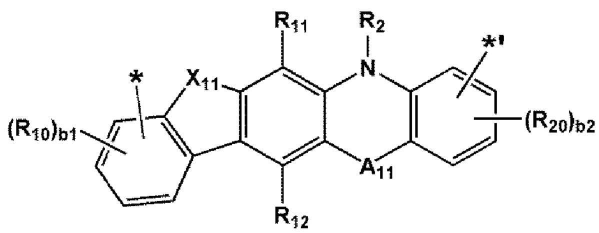

Formula 11(10)

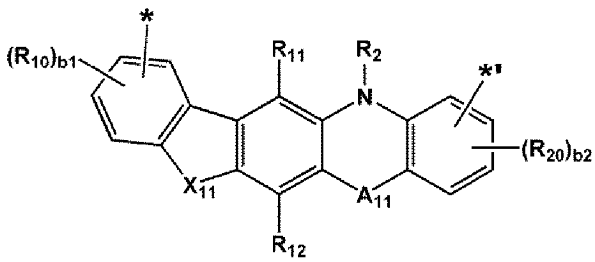

Formula 11(11)

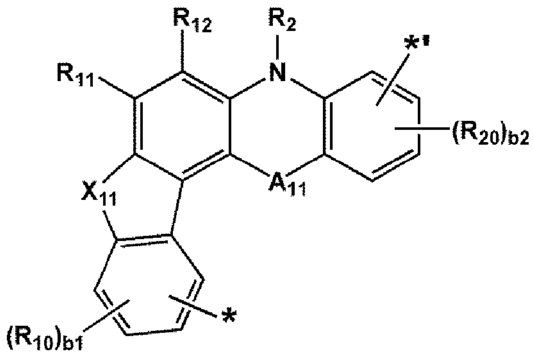

Formula 11(12)

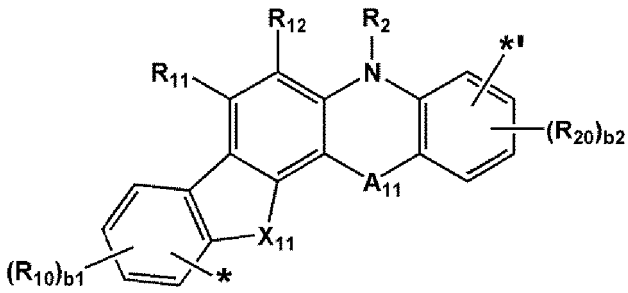

Formula 11(13)

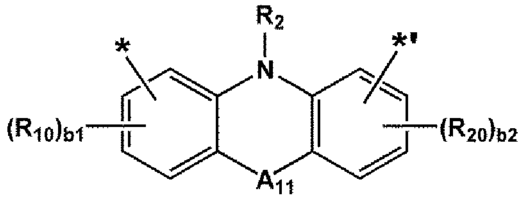

Formula 11(14)

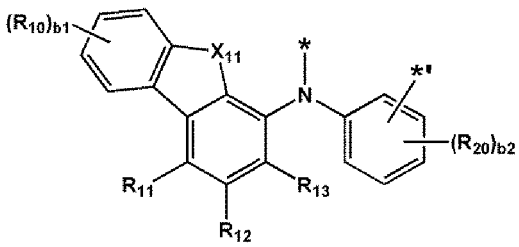

Formula 11(15)

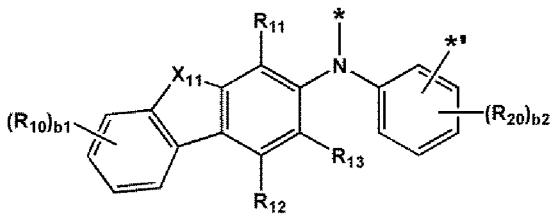

Formula 11(16)

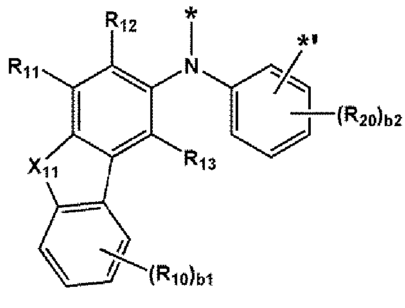

Formula 11(17)

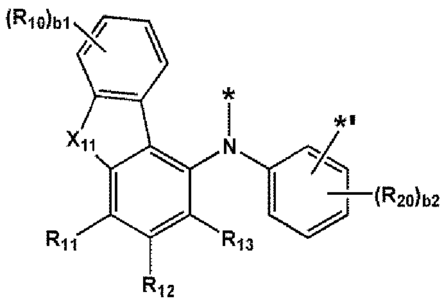

Formula 11(18)

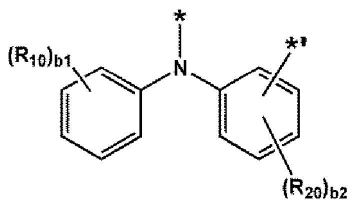

Formula 11(19)

.

In Formulae 11(1) to 11(19),

$X_{11}$ may be O, S, $C(R_{14})$, or $N(R_{15})(R_{16})$,
$A_{11}$, $R_2$, $R_{10}$, $R_{20}$, b1, and b2 are each independently the same as described herein,
$R_{11}$ to $R_{16}$ are each independently the same as described in connection with $R_{10}$, and
* and *' each indicate a binding site to a neighboring atom.

For example, $R_{10}$ to $R_{16}$ and $R_{20}$ in Formulae 11(1) to 11(19) may each independently be selected from hydrogen, deuterium, a cyano group, a $C_1$-$C_{20}$ alkyl group, a $C_1$-$C_{20}$ alkoxy group, a phenyl group, a biphenyl group, a terphenyl group, a naphthyl group, a fluorenyl group, a dimethylfluorenyl group, a diphenylfluorenyl group, a carbazolyl group, a

phenylcarbazolyl group, a biphenylcarbazolyl group, a dibenzofuranyl group, and a dibenzothiophenyl group, but embodiments of the present disclosure are not limited thereto.

d1 in Formula 1 may 0, 1, or 2.

In an embodiment, d1 in Formula 1 may be 0 or 1.

In one or more embodiments, d1 in Formula 1 may be 1, but embodiments of the present disclosure are not limited thereto.

$A_1$ in Formula 1 is a substituted or unsubstituted $\pi$ electron-depleted nitrogen-containing $C_2$-$C_{60}$ heterocyclic group or a sulphonyl-containing group.

For example, $A_1$ in Formula 1 may be selected from groups represented by Formulae 3-1 to 3-14 and a sulphonyl-containing group, but embodiments of the present disclosure are not limited thereto:

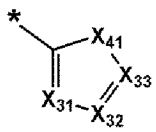
Formula 3-1

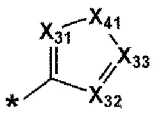
Formula 3-2

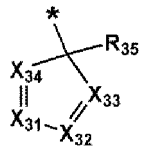
Formula 3-3

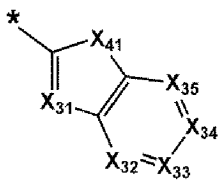
Formula 3-4

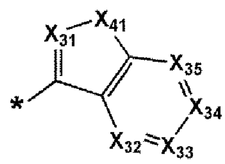
Formula 3-5

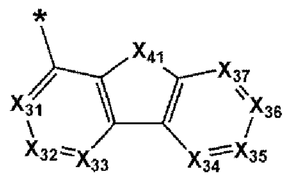
Formula 3-6

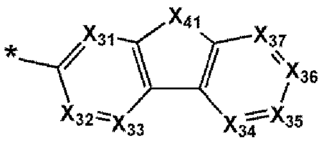
Formula 3-7

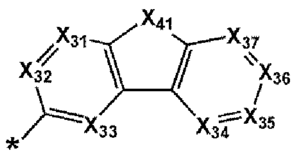
Formula 3-8

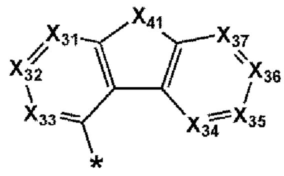
Formula 3-9

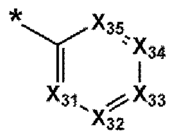
Formula 3-10

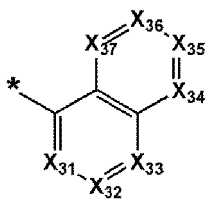
Formula 3-11

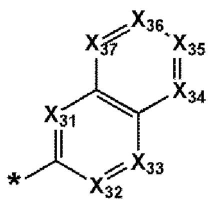
Formula 3-12

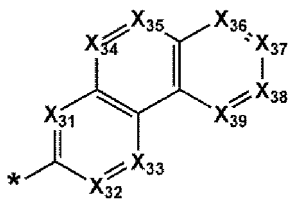
Formula 3-13

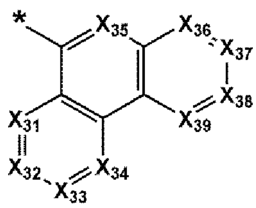
Formula 3-14

In Formulae 3-1 to 3-14, $X_{31}$ may be N or $C(R_{31})$, $X_{32}$ may be N or $C(R_{32})$, $X_{33}$ may be N or $C(R_{33})$, $X_{34}$ may be N or $C(R_{34})$, $X_{35}$ may be N or $C(R_{35})$, $X_{36}$ may be N or $C(R_{36})$, $X_{37}$ may be N or $C(R_{37})$, $X_{38}$ may be N or $C(R_{38})$, and $X_{39}$ may be N or $C(R_{39})$,

$X_{41}$ in Formulae 3-1, 3-2, and 3-4 to 3-9 may be $N(R_{41})$, $C(R_{42})(R_{43})$, O, or S, at least one of $X_{31}$ to $X_{33}$ in Formulae 3-1 and 3-2 is N, at least one of $X_{31}$ to $X_{34}$ in Formula 3-3 is N, at least one of $X_{31}$ to $X_{35}$ in Formulae 3-4, 3-5, and 3-10 is N, at least one of $X_{31}$ to $X_{37}$ in Formulae 3-6 to 3-9, 3-11, and 3-12 is N, and at least one of $X_{31}$ to $X_{39}$ in Formulae 3-13 and 3-14 is N,

$R_{31}$ to $R_{39}$ and $R_{41}$ to $R_{43}$ may each independently be selected from hydrogen, deuterium, -F, -Cl, -Br, -I, $-CD_3$, $-CD_2H$, $-CDH_2$, $-CF_3$, $-CF_2H$, - $CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a ($C_1$-$C_{20}$ alkyl) phenyl group, a di($C_1$-$C_{20}$ alkyl)phenyl group, a tri($C_1$-$C_{20}$ alkyl)phenyl group, a ($C_6$-$C_{20}$ aryl)phenyl group, a di($C_6$-$C_{20}$ aryl)phenyl group, a tri($C_6$-$C_{20}$ aryl)phenyl group, a ($C_3$-$C_{20}$ heteroaryl)phenyl group, a di($C_3$-$C_{20}$ heteroaryl)phenyl group, a pyridinyl group, a ($C_1$-$C_{20}$ alkyl)pyridinyl group, a di($C_1$-$C_{20}$ alkyl)pyridinyl group, a ($C_6$-$C_{20}$ aryl) pyridinyl group, a di($C_6$-$C_{20}$ aryl)pyridinyl group, a ($C_3$-$C_{20}$ heteroaryl)pyridinyl group, a di($C_3$-$C_{20}$ heteroaryl)pyridinyl group, a pyrimidinyl group, a ($C_1$-$C_{20}$ alkyl)pyrimidinyl group, a di($C_1$-$C_{20}$ alkyl)pyrimidinyl group, a ($C_6$-$C_{20}$ aryl) pyrimidinyl group, a di($C_6$-$C_{20}$ aryl)pyrimidinyl group, a ($C_3$-$C_{20}$ heteroaryl)pyrimidinyl group, a di($C_3$-$C_{20}$ heteroaryl) pyrimidinyl group, a triazinyl group, a ($C_1$-$C_{20}$ alkyl)triazinyl group, a di($C_1$-$C_{20}$ alkyl)triazinyl group, a ($C_6$-$C_{20}$ aryl) triazinyl group, a di($C_6$-$C_{20}$ aryl)triazinyl group, a ($C_3$-$C_{20}$ heteroaryl)triazinyl group, and a di($C_3$-$C_{20}$ heteroaryl) triazinyl group, and

* indicates a binding site to a neighboring atom.

In one or more embodiments, $A_1$ in Formula 1 may be selected from groups represented by Formulae 3-4(1) to 3-4(4), 3-5(1) to 3-5(4), 3-6(1), 3-7(1), 3-8(1), 3-9(1), 3-10(1) to 3-10(8), 3-11(1) to 3-11(23), and 3-12(1) to 3-12(24):

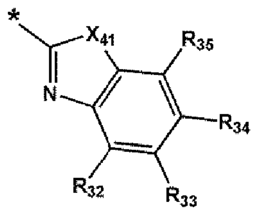
Formula 3-4(1)

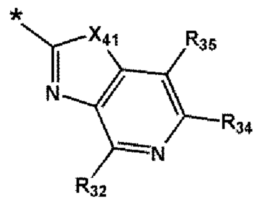
Formula 3-4(2)

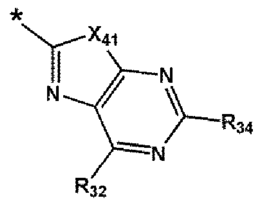
Formula 3-4(3)

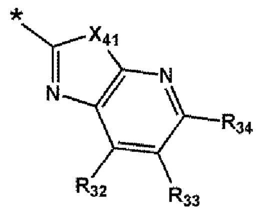
Formula 3-4(4)

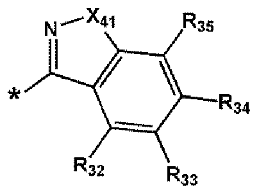
Formula 3-5(1)

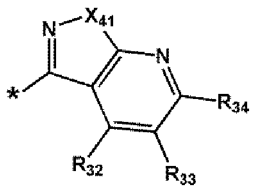
Formula 3-5(2)

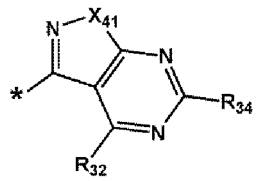
Formula 3-5(3)

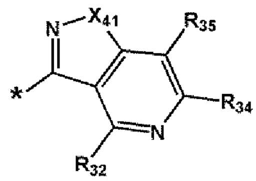
Formula 3-5(4)

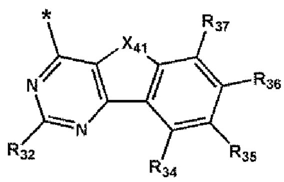
Formula 3-6(1)

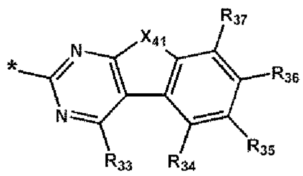
Formula 3-7(1)

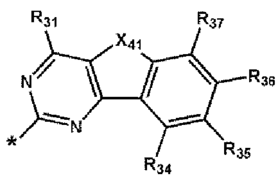
Formula 3-8(1)

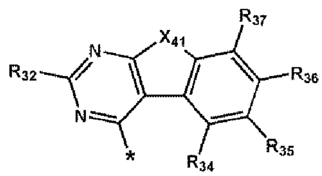
Formula 3-9(1)

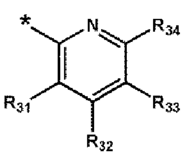
Formula 3-10(1)

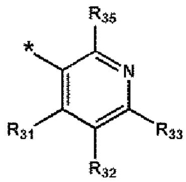
Formula 3-10(2)

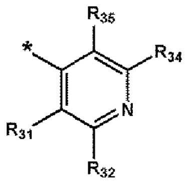
Formula 3-10(3)

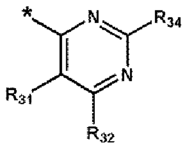
Formula 3-10(4)

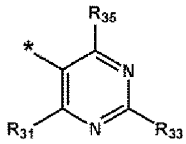
Formula 3-10(5)

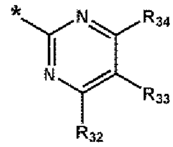
Formula 3-10(6)

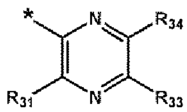
Formula 3-10(7)

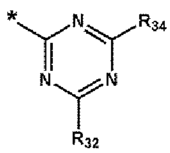
Formula 3-10(8)

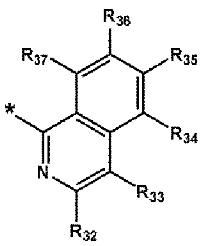
Formula 3-11(1)

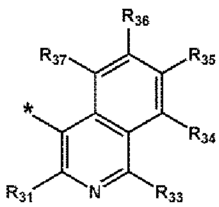
Formula 3-11(2)

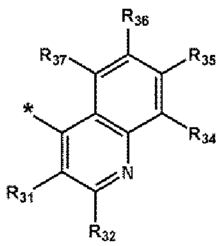
Formula 3-11(3)

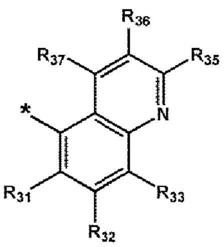
Formula 3-11(4)

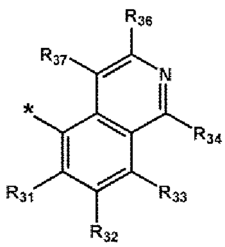
Formula 3-11(5)

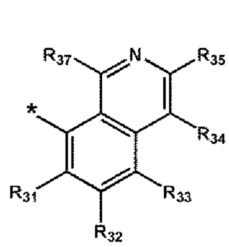
Formula 3-11(6)

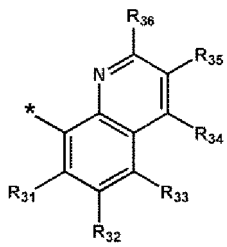
Formula 3-11(7)

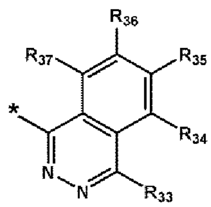
Formula 3-11(8)

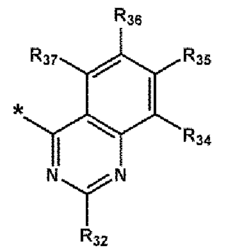
Formula 3-11(9)

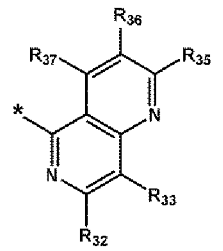
Formula 3-11(10)

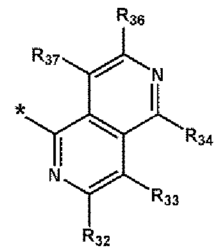
Formula 3-11(11)

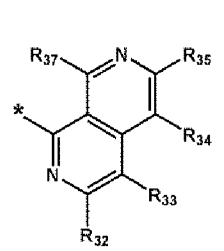
Formula 3-11(12)

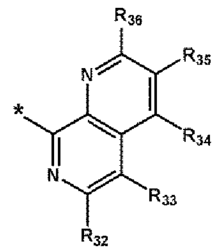
Formula 3-11(13)

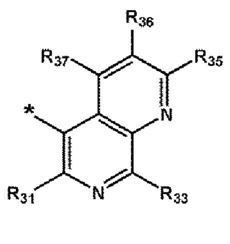
Formula 3-11(14)

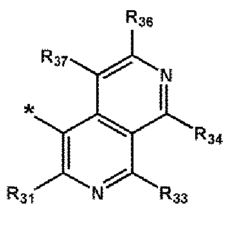
Formula 3-11(15)

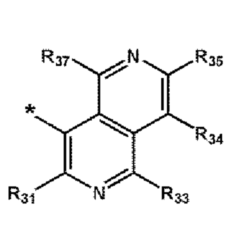
Formula 3-11(16)

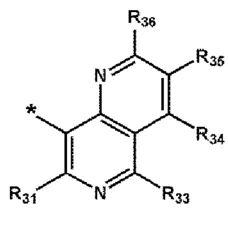
Formula 3-11(17)

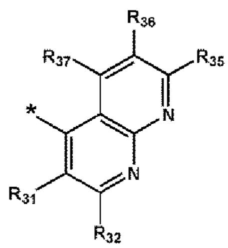
Formula 3-11(18)

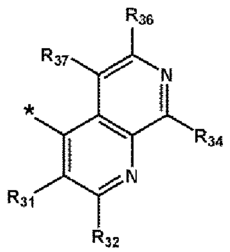
Formula 3-11(19)

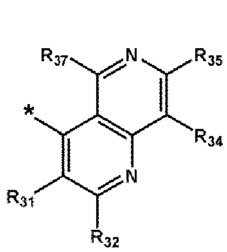
Formula 3-11(20)

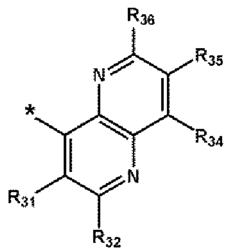
Formula 3-11(21)

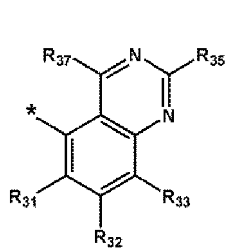
Formula 3-11(22)

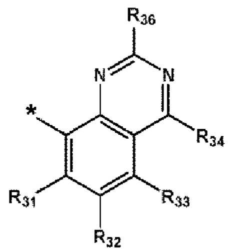
Formula 3-11(23)

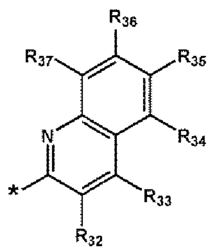
Formula 3-12(1)

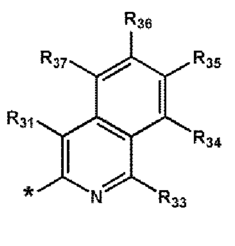
Formula 3-12(2)

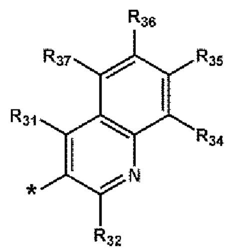
Formula 3-12(3)

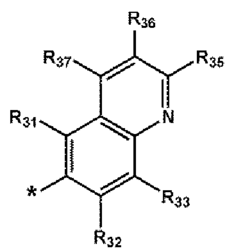
Formula 3-12(4)

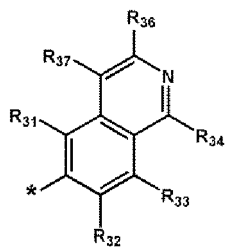
Formula 3-12(5)

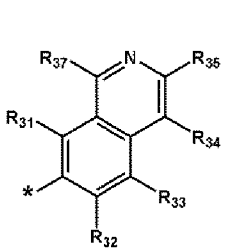
Formula 3-12(6)

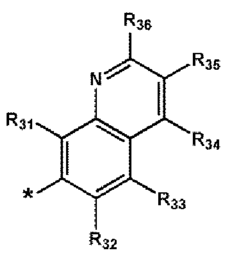
Formula 3-12(7)

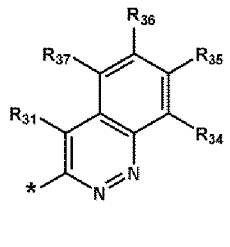
Formula 3-12(8)

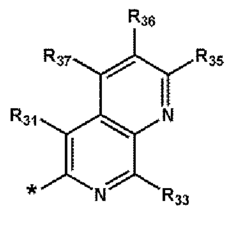
Formula 3-12(9)

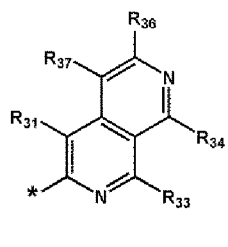
Formula 3-12(10)

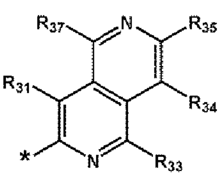
Formula 3-12(11)
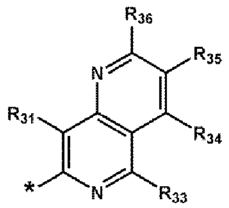
Formula 3-12(12)
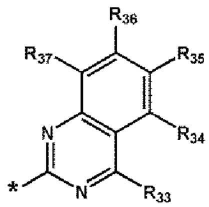
Formula 3-12(13)
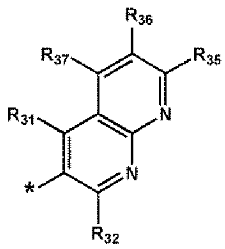
Formula 3-12(14)
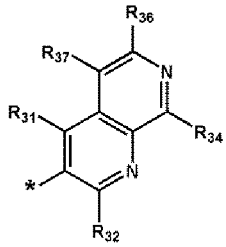
Formula 3-12(15)

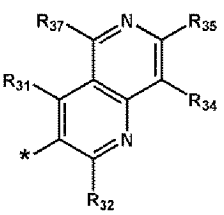
Formula 3-12(16)
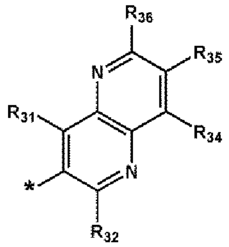
Formula 3-12(17)
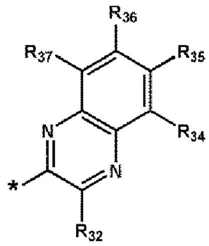
Formula 3-12(18)
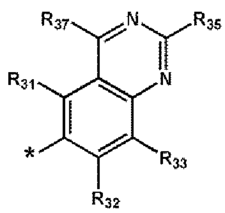
Formula 3-12(19)
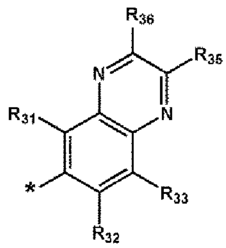
Formula 3-12(20)

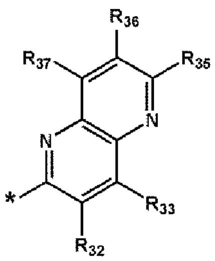
Formula 3-12(21)
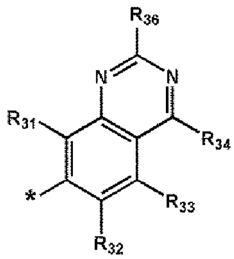
Formula 3-12(22)
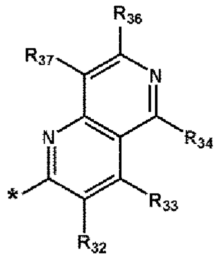
Formula 3-12(23)
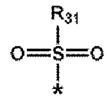
Formula 3-12(24).

In Formulae 3-4(1) to 3-4(4), 3-5(1) to 3-5(4), 3-6(1), 3-7(1), 3-8(1), 3-9(1), 3-10(1) to 3-10(8), 3-11(1) to 3-11(23), and 3-12(1) to 3-12(24), $X_{41}$ may be $N(R_{41})$, $C(R_{42})(R_{43})$, O, or S,

$R_{31}$ to $R_{37}$ and $R_{41}$ to $R_{43}$ are each independently the same as described herein, and
* indicates a binding site to a neighboring atom.

In one or more embodiments, $A_1$ in Formula 1 may be selected from groups represented by Formulae 3-6(1), 3-10(4), 3-10(8), and 3-12(24).

In one or more embodiments, $A_1$ in Formula 1 may be a triazine-containing group or a sulphonyl-containing group.

$R_1$ in Formula 1 may be selected from hydrogen, deuterium, a cyano group, a $C_1$-$C_{20}$ alkyl group, a $C_1$-$C_{20}$ alkoxy group, a phenyl group, a biphenyl group, a terphenyl group, a naphthyl group, a fluorenyl group, a dimethylfluorenyl group, a diphenylfluorenyl group, a carbazolyl group, a phenylcarbazolyl group, a biphenylcarbazolyl group, a dibenzofuranyl group, and a dibenzothiophenyl group.

The TADF emitter may be selected from Compounds 1 to 11, but embodiments of the present disclosure are not limited thereto:

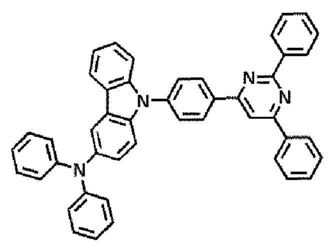
1
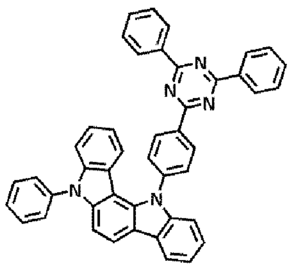
2
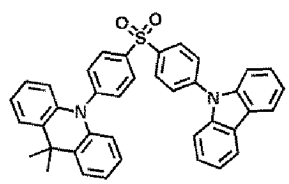
3

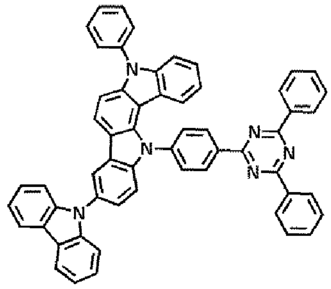

4

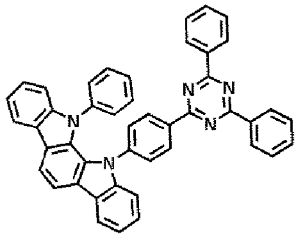

5

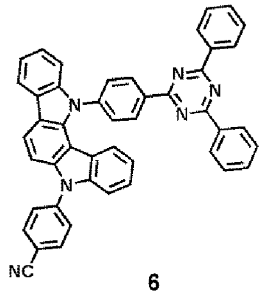

6

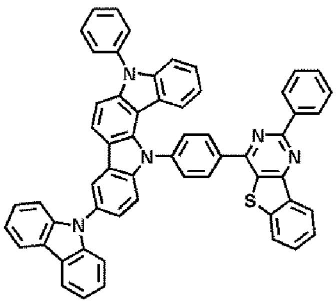

7

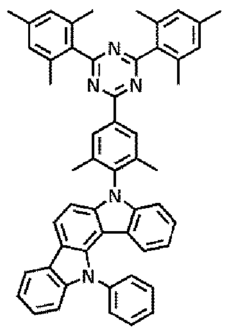

8

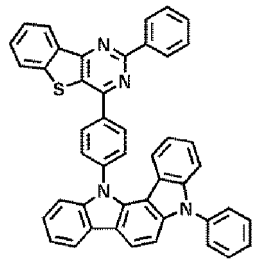

9

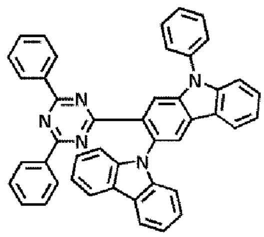

10

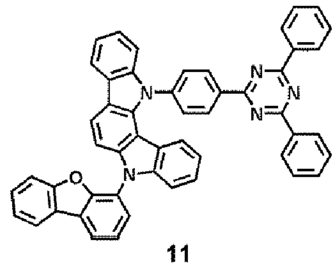

11

The host, which is usable in the emission layer together with the TADF emitter, may be selected from any hosts. In accordance with the invention the host does not include DPEPO.

For example, the host may include at least one compound selected from a fluorene-containing compound, a carbazole-containing compound, a dibenzofuran-containing compound, a dibenzothiophene-containing compound, an indenocarbazole-containing compound, an indolocarbazole-containing compound, a benzofurocarbazole-containing compound, a benzothienocarbazole-containing compound, an acridine-containing compound, a dihydroacridine-containing compound, a triindolobenzene-containing compound, a pyridine-containing compound, a pyrimidine-containing compound, a triazine-containing compound, a silicon-containing compound, a cyano group-containing compound, a phosphine oxide-containing compound, a sulfoxide-containing compound, and a sulphonyl-containing compound.

For example, the host may be a compound including at least one carbazole ring and at least one cyano group or a phosphine oxide-containing compound, but embodiments of the present disclosure are not limited thereto.

In an embodiment, the host may include at least one compound selected from Compounds H1 to H22 and H24 (host H23 does not form part of the invention), but embodiments of the present disclosure are not limited thereto:

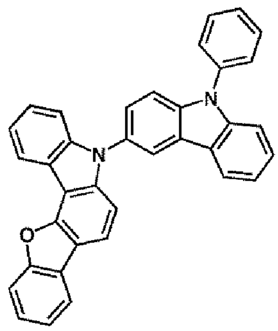

H1

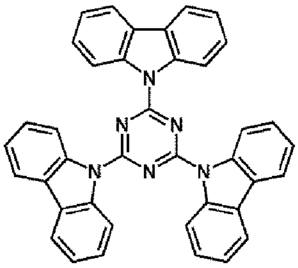

H2

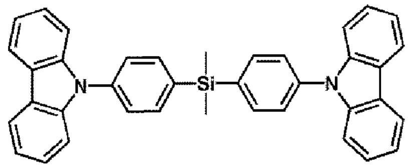

H3

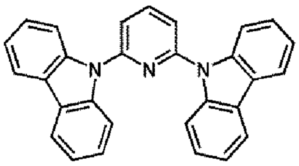

H4

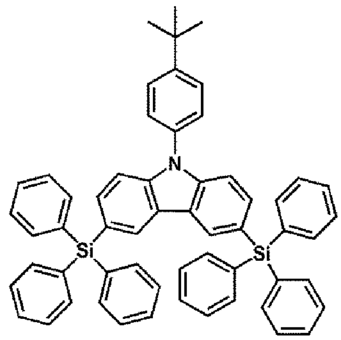

H5

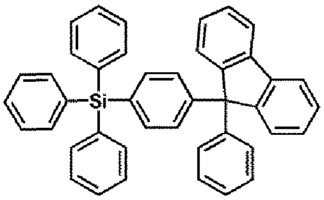

H6

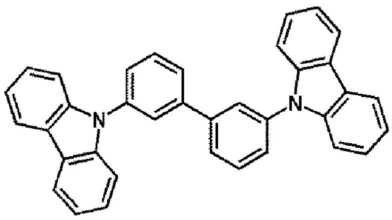

H7

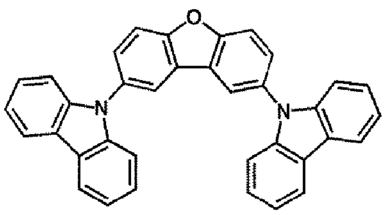

H8

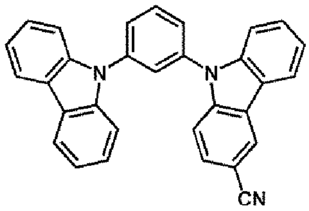

H9

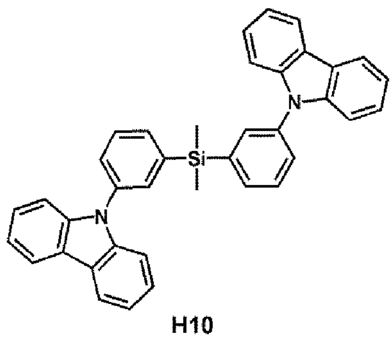

H10

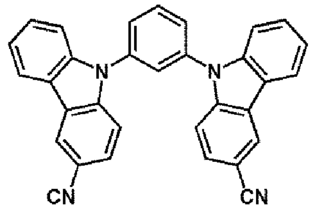

H11

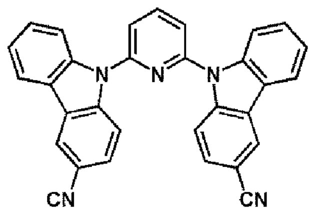

H12

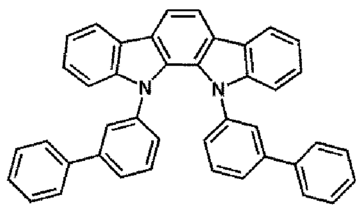

H13

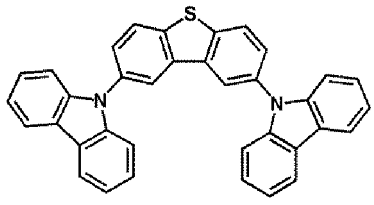

H14

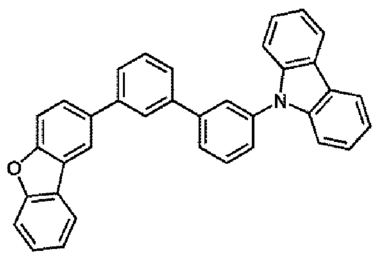

H15

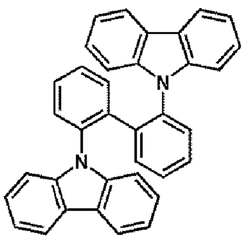

H16

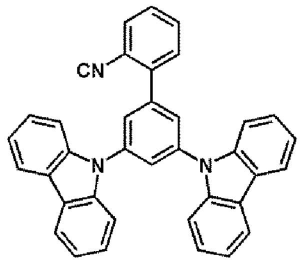

H17

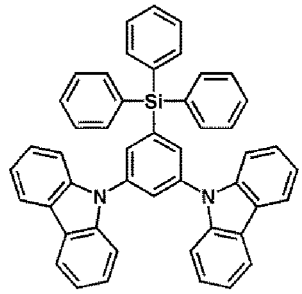

H18

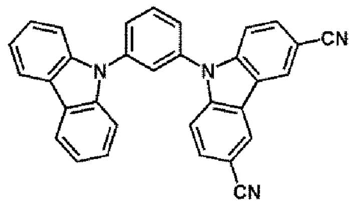

H19

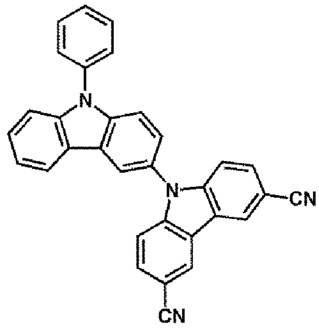

H20

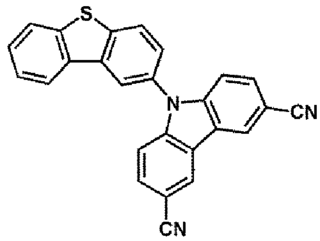

H21

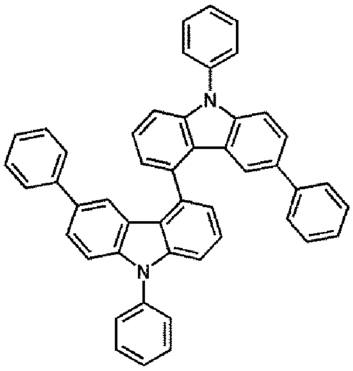

H22

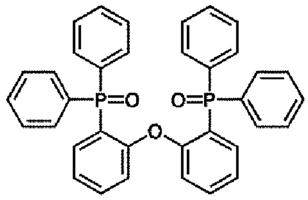

H23

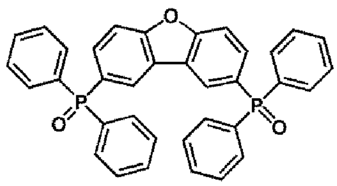

H24

.

A ratio of a delayed fluorescence component emitted from the TADF emitter with respect to a total emission component of the emission layer may be about 30% or more (about 33% or more in one example, about 48% or more in another example, about 74% or more in another embodiment).

An amount of the TADF emitter may be smaller than an amount of the host. For example, an amount of the TADF emitter in the emission layer may be generally selected within a range of about 0.01 parts by weight to about 20 parts by weight based on 100 parts by weight of the emission layer, but embodiments of the present disclosure are not limited thereto. While not wishing to be bound by theory, it is understood that when the amount of the TADF emitter is within this range, light emission may be provided without a quenching phenomenon.

FIG. 1 is a schematic view of an organic light-emitting device 10 according to an embodiment. Hereinafter, the structure of an organic light-emitting device according to an embodiment and a method of manufacturing an organic light-emitting device according to an embodiment will be described in connection with FIG. 1. The organic light-emitting device 10 includes a first electrode 11, an organic layer 15, and a second electrode 19, which are sequentially stacked.

A substrate may be additionally disposed under the first electrode 11 or above the second electrode 19. For use as the substrate, any substrate that is used in general organic light-emitting devices may be used, and the substrate may be a glass substrate or a transparent plastic substrate, each having excellent mechanical strength, thermal stability, transparency, surface smoothness, ease of handling, and water resistance.

The first electrode 11 may be formed by depositing or sputtering a material for forming the first electrode 11 on the

substrate. The first electrode 11 may be an anode. The material for forming the first electrode 11 may be selected from materials with a high work function to facilitate hole injection. The first electrode 11 may be a reflective electrode, a semi-transmissive electrode, or a transmissive electrode. The material for forming the first electrode may be, for example, indium tin oxide (ITO), indium zinc oxide (IZO), tin oxide ($SnO_2$), and zinc oxide (ZnO). In one or more embodiments, magnesium (Mg), aluminum (Al), aluminum-lithium (Al-Li), calcium (Ca), magnesium-indium (Mg-In), or magnesium-silver (Mg-Ag) may be used as the material for forming the first electrode.

The first electrode 11 may have a single-layered structure or a multi-layered structure including two or more layers. For example, the first electrode 11 may have a three-layered structure of ITO/Ag/ITO, but the structure of the first electrode 110 is not limited thereto.

The organic layer 15 is disposed on the first electrode 11.

The organic layer 15 may include a hole transport region, an emission layer, and an electron transport region.

The hole transport region may be disposed between the first electrode 11 and the emission layer.

The hole transport region may include at least one selected from a hole injection layer, a hole transport layer, an electron blocking layer, and a buffer layer.

The hole transport region may include only either a hole injection layer or a hole transport layer. In one or more embodiments, the hole transport region may have a hole injection layer/hole transport layer structure or a hole injection layer/hole transport layer/electron blocking layer structure, which are sequentially stacked in this stated order from the first electrode 11.

A hole injection layer may be formed on the first electrode 11 by using one or more suitable methods selected from vacuum deposition, spin coating, casting, or Langmuir-Blodgett (LB) deposition.

When a hole injection layer is formed by vacuum deposition, the deposition conditions may vary according to a compound that is used to form the hole injection layer, and the structure and thermal characteristics of the hole injection layer. For example, the deposition conditions may include a deposition temperature of about 100°C to about 500°C, a vacuum pressure of about $10^{-8}$ torr to about $10^{-3}$ torr, and a deposition rate of about 0.01 Å/sec to about 100 Å/sec. However, the deposition conditions are not limited thereto.

When the hole injection layer is formed using spin coating, coating conditions may vary according to the material used to form the hole injection layer, and the structure and thermal properties of the hole injection layer. For example, a coating speed may be from about 2,000 revolutions per minute (rpm) to about 5,000 rpm, and a temperature at which a heat treatment is performed to remove a solvent after coating may be from about 80°C to about 200°C. However, the coating conditions are not limited thereto.

Conditions for forming a hole transport layer and an electron blocking layer may be understood by referring to conditions for forming the hole injection layer.

The hole transport region may include at least one selected from m-MTDATA, TDATA, 2-TNATA, NPB, β-NPB, TPD, spiro-TPD, spiro-NPB, methylated-NPB, TAPC, HMTPD, 4,4',4"-tris(N-carbazolyl)triphenylamine (TCTA), polyaniline/dodecylbenzene sulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrene sulfonate) (PANI/PSS), a compound represented by Formula 201 below, and a compound represented by Formula 202 below:

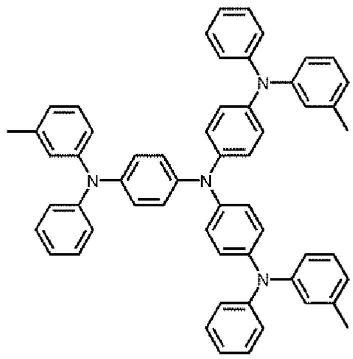

m-MTDATA

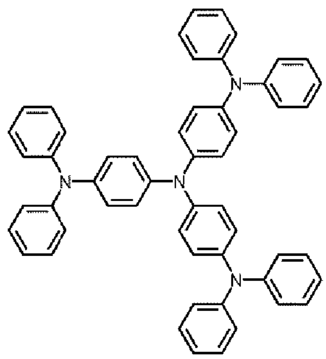

TDATA

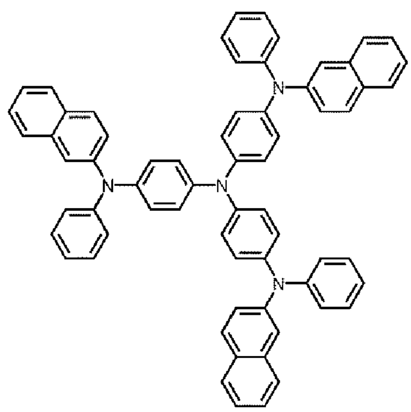

2-TNATA

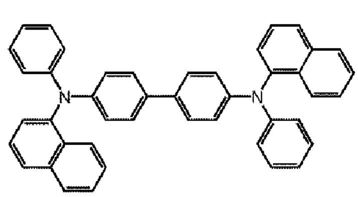

NPB

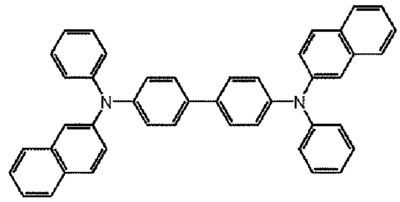

β-NPB

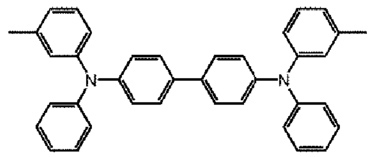

TPD

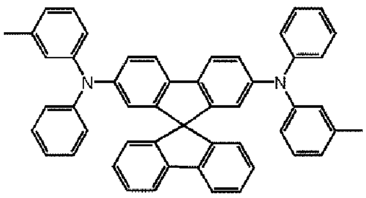

Spiro-TPD

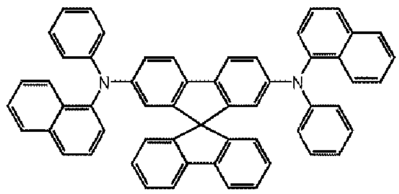

Spiro-NPB

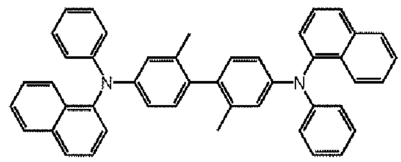

methylated NPB

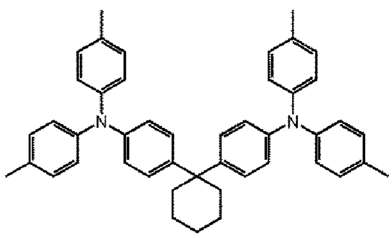

TAPC

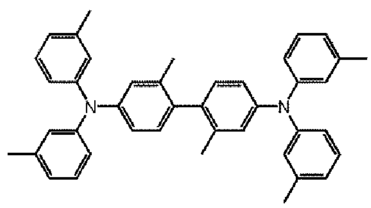

HMTPD

Formula 201

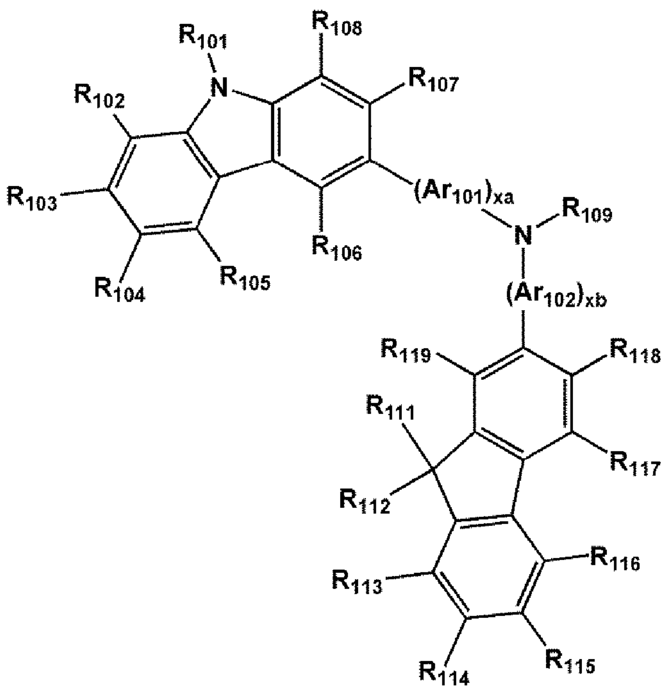

Formula 202

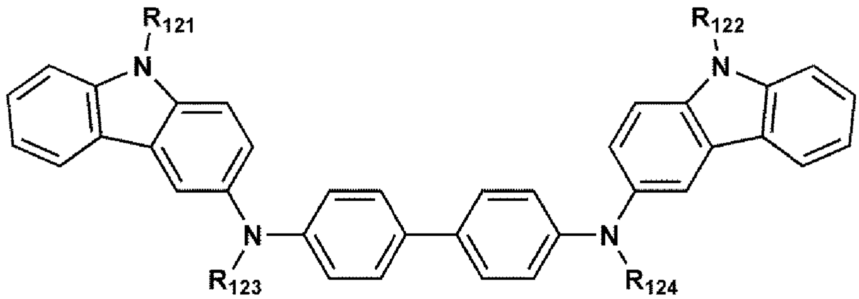

.

$Ar_{101}$ and $Ar_{102}$ in Formula 201 may each independently be selected from:

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group; and

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group.

xa and xb in Formula 201 may each independently be an integer from 0 to 5, or may be 0, 1, or 2. For example, xa is 1 and xb is 0, but xa and xb are not limited thereto. $R_{101}$ to $R_{108}$, $R_{111}$ to $R_{119}$, and $R_{121}$ to $R_{124}$ in Formulae 201 and 202 may each independently be selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, and a $C_1$-$C_{10}$ alkyl group (for example, a methyl group, an ethyl group, a propyl group, a butyl group, a pentyl group, a hexyl group, and so on), or a $C_1$-$C_{10}$ alkoxy group (for example, a methoxy group, an ethoxy group, a propoxy group, a butoxy group, a pentoxy group, and so on);

a $C_1$-$C_{10}$ alkyl group and a $C_1$-$C_{10}$ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;

a phenyl group, a naphthyl group, an anthracenyl group, a fluorenyl group, and a pyrenyl group; and

a phenyl group, a naphthyl group, an anthracenyl group, a fluorenyl group, and a pyrenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, and a $C_1$-$C_{10}$ alkoxy group,

but embodiments of the present disclosure are not limited thereto.

$R_{109}$ in Formula 201 may be selected from:

a phenyl group, a naphthyl group, an anthracenyl group, and a pyridinyl group; and

a phenyl group, a naphthyl group, an anthracenyl group, and a pyridinyl group, each substituted with at least one selected from deuterium, -F, -Cl, - Br, -I, a hydroxyl group, a cyano group, a nitro group, an amino group, an amidino

group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, and a pyridinyl group.

According to an embodiment, the compound represented by Formula 201 may be represented by Formula 201A, but embodiments of the present disclosure are not limited thereto:

Formula 201A

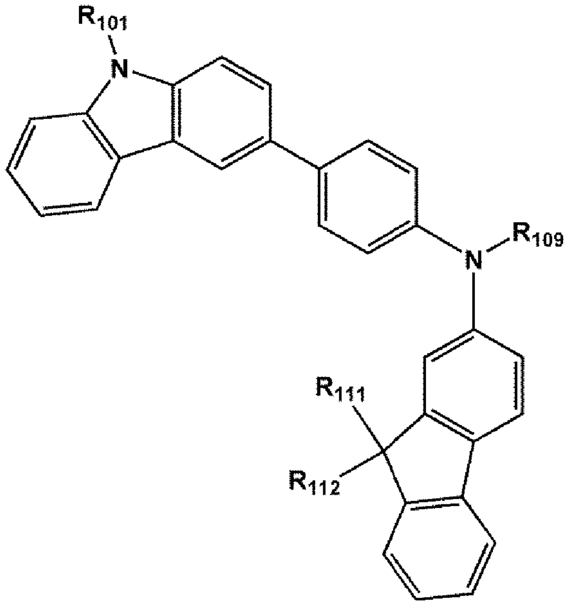

$R_{101}$, $R_{111}$, $R_{112}$, and $R_{109}$ in Formula 201A may be understood by referring to the description provided herein.

For example, the compound represented by Formula 201, and the compound represented by Formula 202 may include compounds HT1 to HT20 illustrated below, but are not limited thereto.

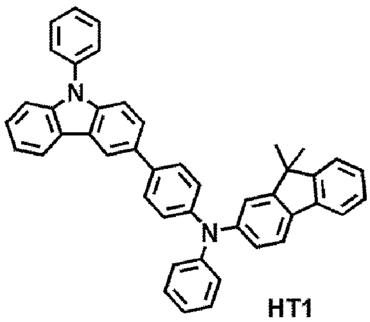

HT1

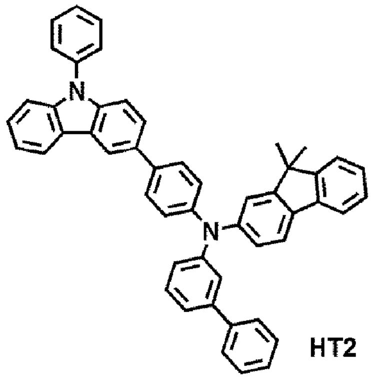

HT2

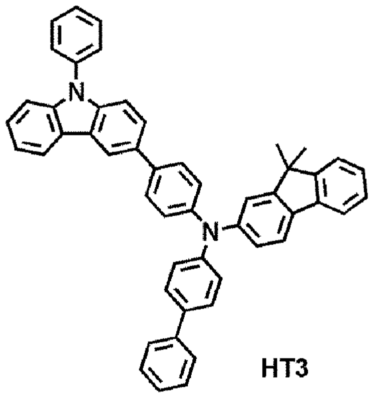

HT3

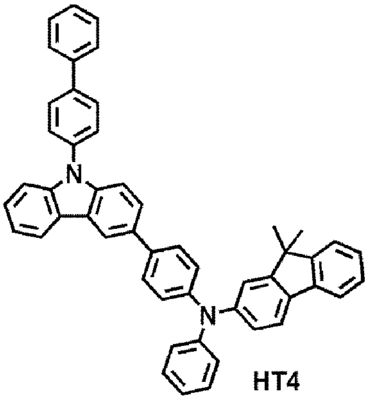

HT4

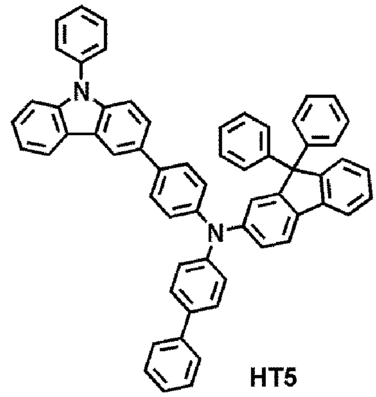

HT5

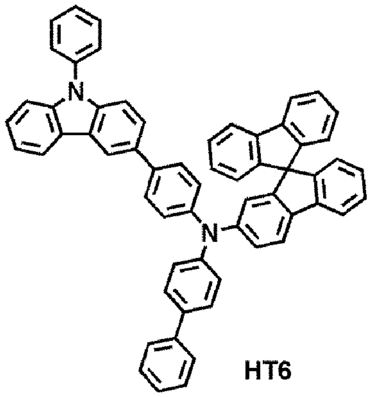

HT6

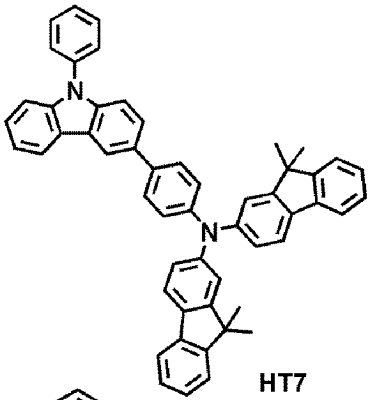

HT7

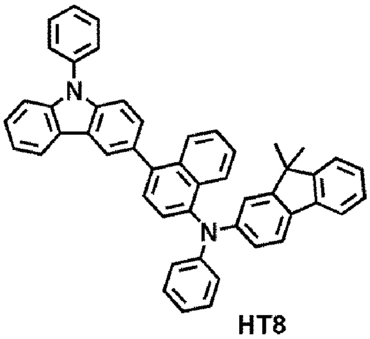

HT8

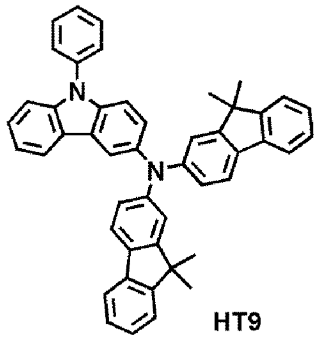

HT9

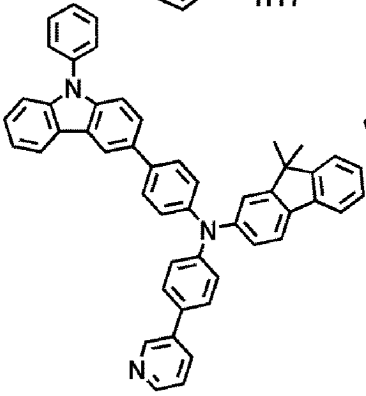

HT10

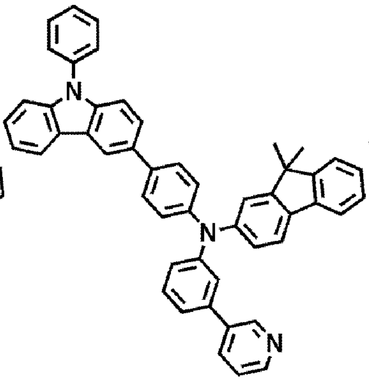

HT11

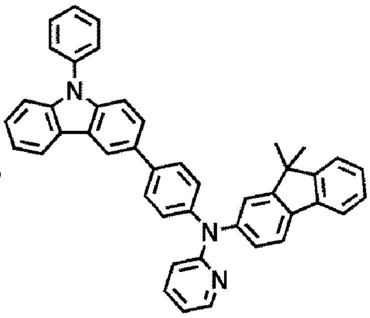

HT12

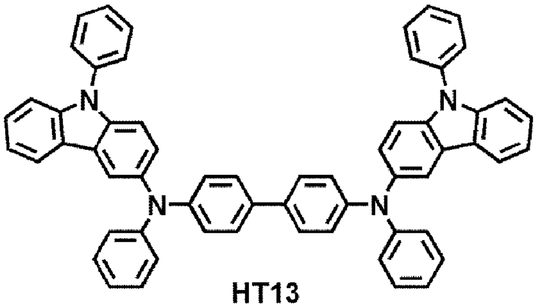

HT13

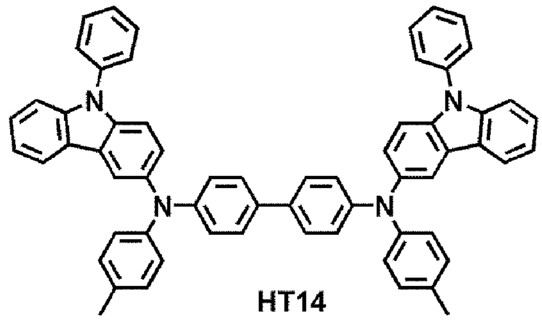

HT14

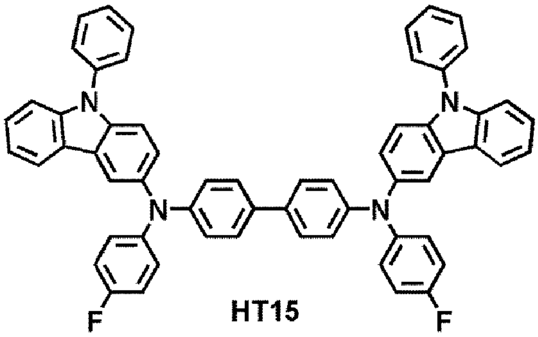

HT15

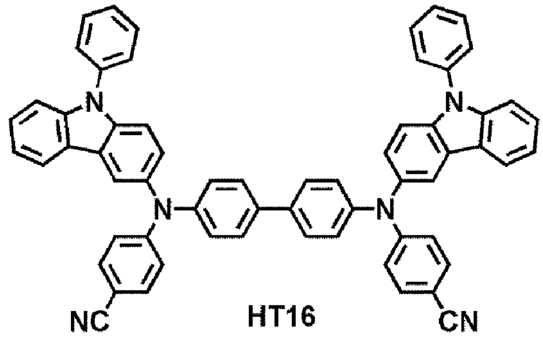

HT16

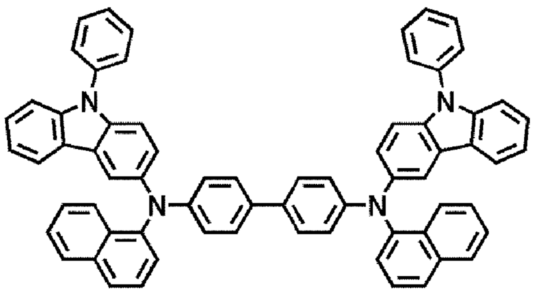

HT17

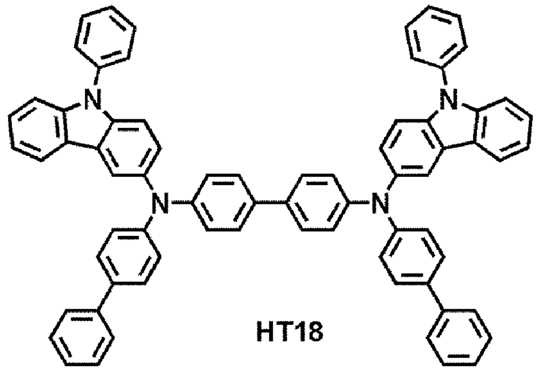

HT18

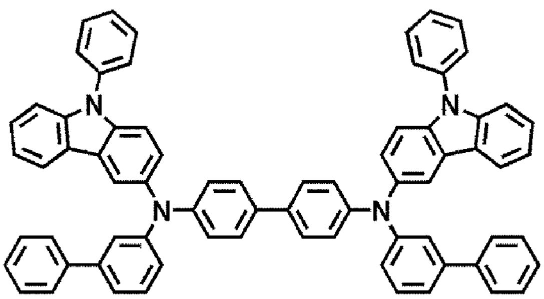

HT19

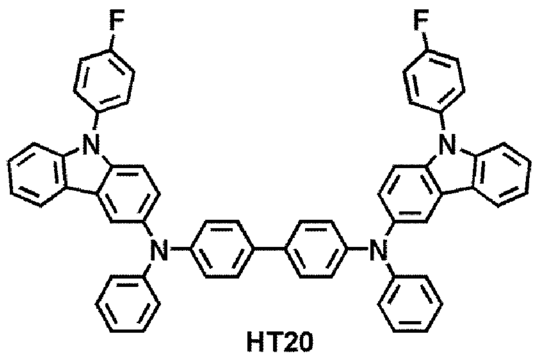

HT20

A thickness of the hole transport region may be in a range of about 100 Å to about 10,000 Å, for example, about 100 Å to about 3,000 Å. When the hole transport region includes at least one of a hole injection layer and a hole transport layer, the thickness of the hole injection layer may be in a range of about 100 Å to about 10,000 Å, for example, about 100 Å to about 2,000 Å, and the thickness of the hole transport layer may be in a range of about 50 Å to about 2,000 Å, for example, about 100 Å to about 1,500 Å. While not wishing to be bound by theory, it is understood that when the thicknesses of the hole transport region, the hole injection layer and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be one selected from a quinone derivative, a metal oxide, and a cyano group-containing compound, but embodiments of the present disclosure are not limited thereto. Non-limiting examples of the p-dopant are a quinone derivative, such as tetracyanoquinonedimethane (TCNQ) or 2,3,5,6-tetrafluoro-tetracyano-1,4-benzoquinonedimethane (F4-TCNQ); a metal oxide, such as a tungsten oxide or a molybdenium oxide; and a cyano group-containing compound, such as Compound HT-D1 or Compound HT-D2 below, but are not limited thereto.

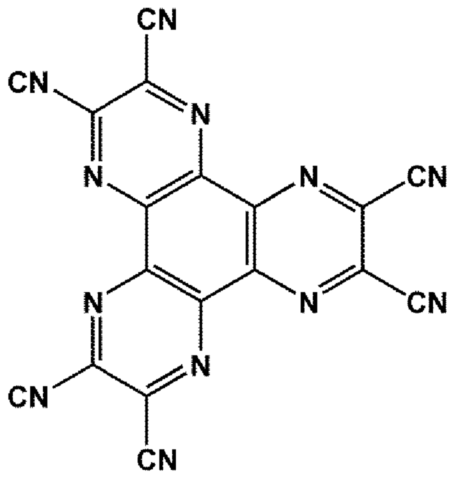

HT-D1

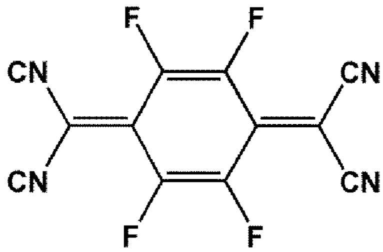

F4-TCNQ

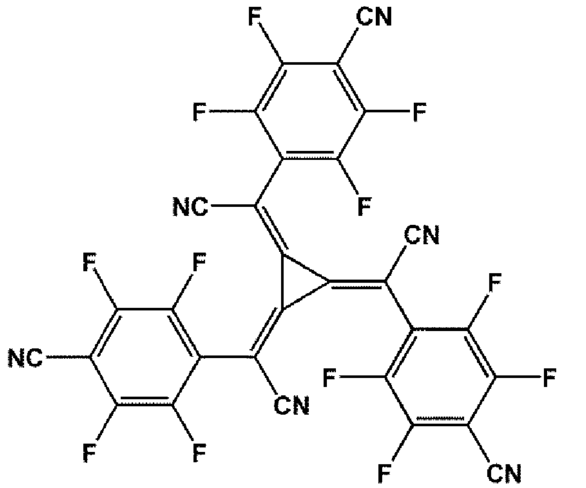

HT-D2

The hole transport region may include a buffer layer.

Also, the buffer layer may compensate for an optical resonance distance according to a wavelength of light emitted from the emission layer, and thus, efficiency of a formed organic light-emitting device may be improved.

The hole transport region may further include an electron blocking layer. The electron blocking layer may include, for example, mCP, but a material therefor is not limited thereto.

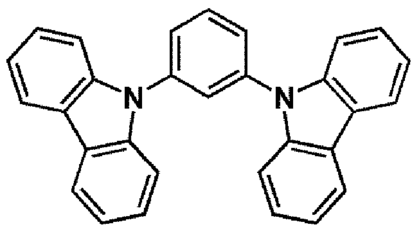

mCP

In one or more embodiments, as an electron blocking material, the host included in the emission layer may be used, but the embodiments are not limited thereto.

Then, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a compound that is used to form the emission layer.

When the organic light-emitting device is a full-color organic light-emitting device, the emission layer may be patterned into a red emission layer, a green emission layer, and a blue emission layer. In one or more embodiments, due to a stacked structure including a red emission layer, a green emission layer, and/or a blue emission layer, the emission layer may emit white light.

The emission layer may include the TADF emitter and the host described above.

In one or more embodiments, the emission layer may consist of the TADF emitter and the host described above.

A thickness of the emission layer may be in a range of about 100 Å to about 1,000 Å, for example, about 200 Å to about 600 Å. While not wishing to be bound by theory, it is understood that when the thickness of the emission layer is within this range, excellent light-emission characteristics may be obtained without a substantial increase in driving voltage.

Then, an electron transport region may be disposed on the emission layer.

The electron transport region may include at least one selected from a hole blocking layer, an electron transport layer, and an electron injection layer.

For example, the electron transport region may have a hole blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of BCP and Bphen, but may also include other materials.

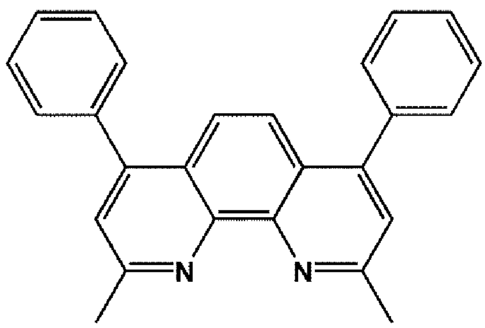

BCP

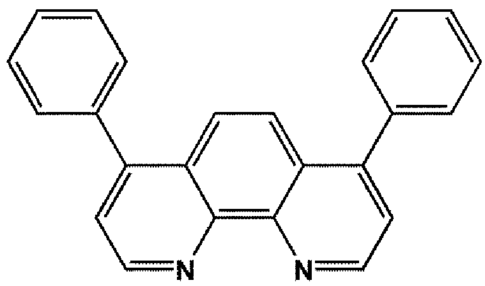

Bphen

In one or more embodiments, as the hole blocking material, a compound that is identical to the host included in the emission layer may be used, but the embodiments are not limited thereto.

A thickness of the hole blocking layer may be in a range of about 20 Å to about 1,000 Å, for example, about 30 Å to about 300 Å. While not wishing to be bound by theory, it is understood that when the thickness of the hole blocking layer is within these ranges, the hole blocking layer may have improved hole blocking ability without a substantial increase in driving voltage.

The electron transport layer may include at least one selected from BCP, Bphen, $Alq_3$, BAlq, TAZ, and NTAZ.

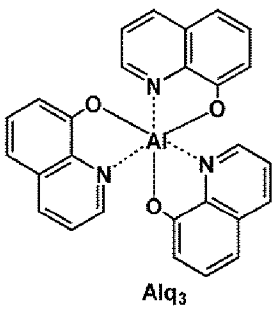

$Alq_3$

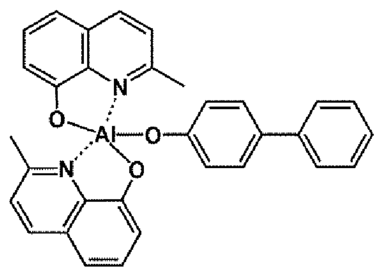

BAlq

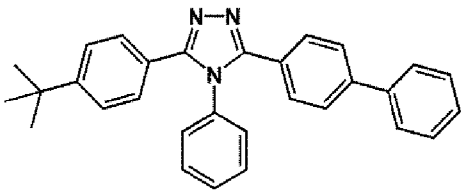

TAZ

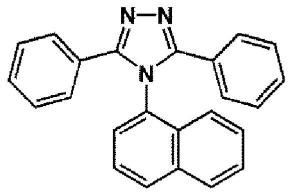

NTAZ

In one or more embodiments, the electron transport layer may include at least one of ET1 to ET25, but are not limited thereto:

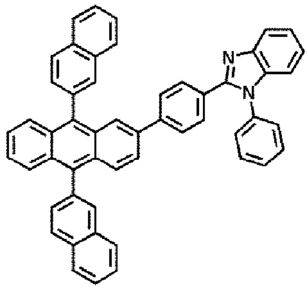

ET1

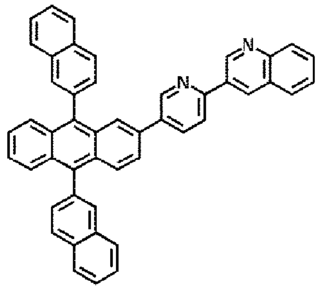

ET2

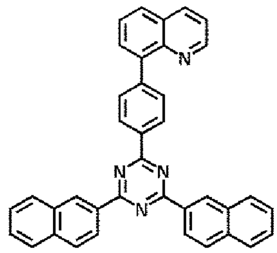

ET3

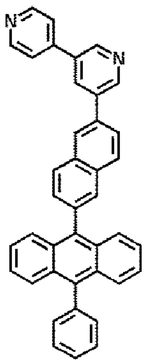

ET4

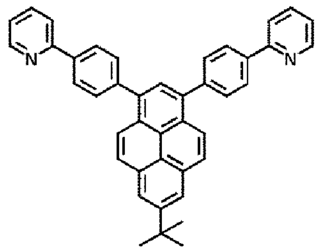

ET5

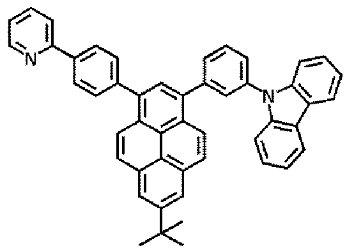

ET6

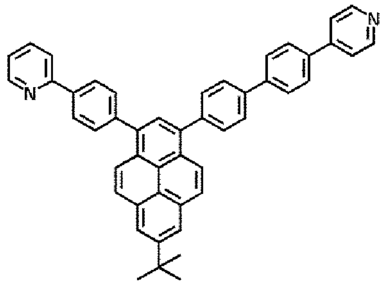

ET7

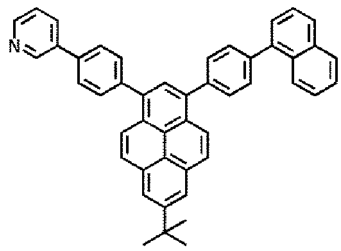

ET8

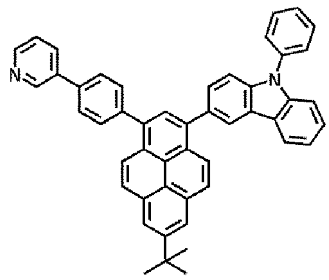

ET9

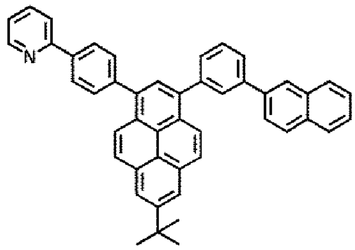

ET10

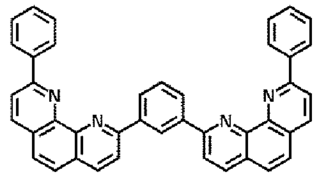

ET11

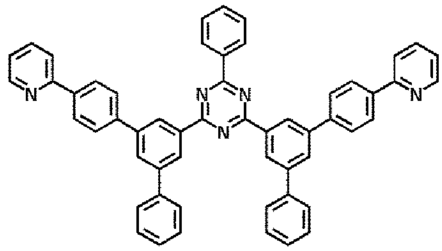

ET12

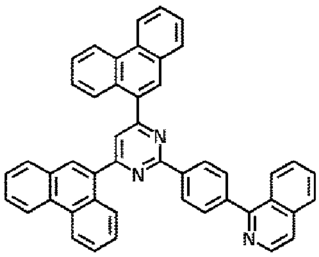

ET13

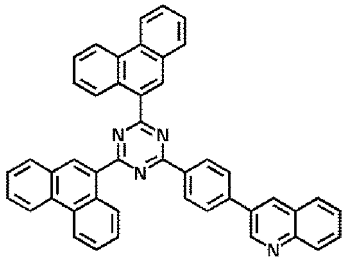

ET14

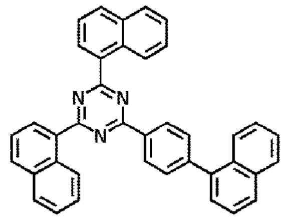

ET15

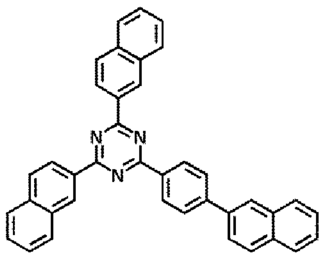

ET16

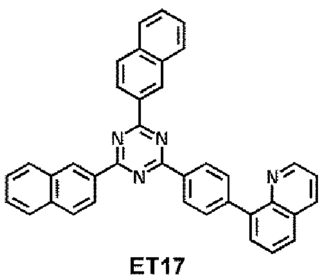

ET17

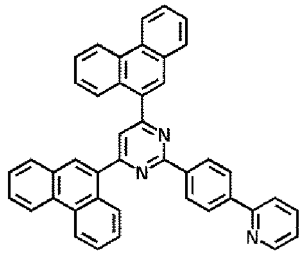

ET18

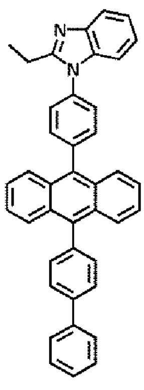

ET19

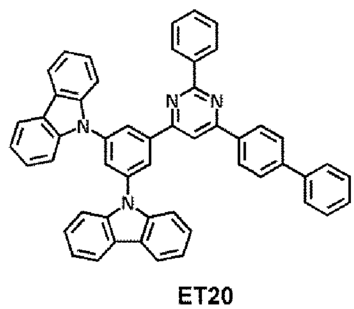

ET20

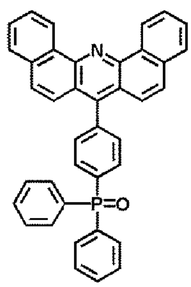

ET21

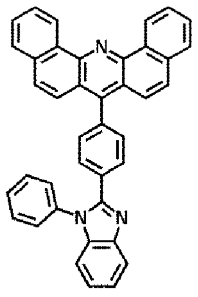
ET22

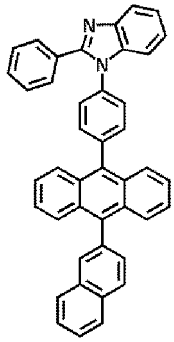
ET23

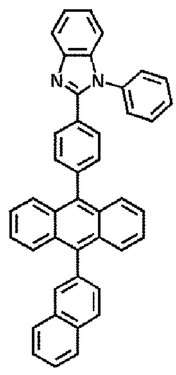
ET24

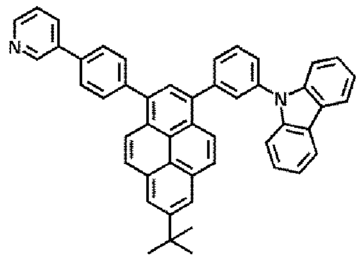
ET25

A thickness of the electron transport layer may be in a range of about 100 Å to about 1,000 Å, for example, about 150 Å to about 500 Å. While not wishing to be bound by theory, it is understood that when the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1 (lithium 8-hydroxyquinolate, LiQ) or ET-D2.

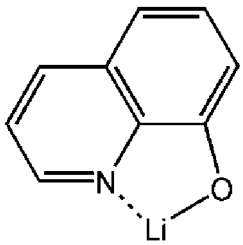
ET-D1

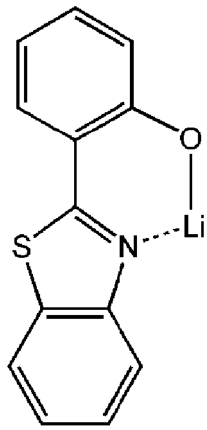
ET-D2

The electron transport region may include an electron injection layer that promotes flow of electrons from the second electrode 19 thereinto.

The electron injection layer may include at least one selected from LiF, NaCl, CsF, $Li_2O$, and BaO.

A thickness of the electron injection layer may be in a range of about 1 Å to about 100 Å, for example, about 3 Å to about 90 Å. While not wishing to be bound by theory, it is understood that when the thickness of the electron injection layer is within the range described above, the electron injection layer may have satisfactory electron injection characteristics without a substantial increase in driving voltage.

The second electrode 19 is disposed on the organic layer 15. The second electrode 19 may be a cathode. A material for forming the second electrode 19 may be selected from metal, an alloy, an electrically conductive compound, and a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be used as a material for forming the second electrode 19. In one or more embodiments, to manufacture a top-emission type light-emitting device, a transmissive electrode formed using ITO or IZO may be used as the second electrode 19.

Hereinbefore, the organic light-emitting device has been described with reference to FIG. 1, but embodiments of the present disclosure are not limited thereto.

The term "$C_1$-$C_{60}$ alkyl group" as used herein refers to a linear or branched saturated aliphatic hydrocarbon monovalent group having 1 to 60 carbon atoms, and non-limiting examples thereof include a methyl group, an ethyl group, a propyl group, an iso-butyl group, a sec-butyl group, a tert-butyl group, a pentyl group, an iso-amyl group, and a hexyl

group. The term "$C_1$-$C_{60}$ alkylene group" as used herein refers to a divalent group having the same structure as the $C_1$-$C_{60}$ alkyl group.

The term "$C_1$-$C_{60}$ alkoxy group" as used herein refers to a monovalent group represented by -$OA_{101}$ (wherein $A_{101}$ is the $C_1$-$C_{60}$ alkyl group), and non-limiting examples thereof include a methoxy group, an ethoxy group, and an isopropyloxy group.

The term "$C_2$-$C_{60}$ alkenyl group" as used herein refers to a hydrocarbon group formed by including at least one carbon-carbon double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group formed by including at least one carbon-carbon triple bond in the middle or at the terminus of the $C_2$-$C_{60}$ alkyl group, and examples thereof include an ethynyl group, and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon monocyclic group having 3 to 10 carbon atoms, and non-limiting examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having the same structure as the $C_3$-$C_{10}$ cycloalkyl group.

The term "$C_1$-$C_{10}$ heterocycloalkyl group" as used herein refers to a monovalent saturated monocyclic group having at least one heteroatom selected from N, O, P, Si and S as a ring-forming atom and 1 to 10 carbon atoms, and non-limiting examples thereof include a tetrahydrofuranyl group, and a tetrahydrothiophenyl group. The term "$C_1$-$C_{10}$ heterocycloalkylene group" as used herein refers to a divalent group having the same structure as the $C_1$-$C_{10}$ heterocycloalkyl group.

The term "$C_3$-$C_{10}$ cycloalkenyl group" as used herein refers to a monovalent monocyclic group that has 3 to 10 carbon atoms, at least one carbon-carbon double bond in the ring thereof, and no aromaticity, and non-limiting examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group that has at least one heteroatom selected from N, O, P, Si, and S as a ring-forming atom, 1 to 10 carbon atoms, and at least one carbon-carbon double bond in its ring. Examples of the $C_1$-$C_{10}$ heterocycloalkenyl group are a 2,3-dihydrofuranyl group, and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Non-limiting examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other.

The term "$C_1$-$C_{60}$ heteroaryl group" as used herein refers to a monovalent group having a heterocyclic aromatic system that has at least one heteroatom selected from N, O, P, and S as a ring-forming atom, and 1 to 60 carbon atoms. The term "$C_1$-$C_{60}$ heteroarylene group" as used herein refers to a divalent group having a heterocyclic aromatic system that has at least one heteroatom selected from N, O, P, and S as a ring-forming atom, and 1 to 60 carbon atoms. Non-limiting examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include two or more rings, the rings may be fused to each other.

The term "$C_6$-$C_{60}$ aryloxy group" as used herein indicates -$OA_{102}$ (wherein $A_{102}$ is the $C_6$-$C_{60}$ aryl group), a $C_6$-$C_{60}$ arylthio group as used herein indicates -$SA_{103}$ (wherein $A_{103}$ is the $C_6$-$C_{60}$ aryl group), and the term "$C_7$-$C_{60}$ arylalkyl group" as used herein indicates -$A_{104}A_{105}$ (wherein $A_{104}$ is the $C_6$-$C_{59}$ aryl group and $A_{105}$ is the $C_1$-$C_{53}$ alkyl group).

The term "$C_1$-$C_{60}$ heteroaryloxy group" as used herein refers to -$OA_{106}$ (wherein $A_{106}$ is the $C_2$-$C_{60}$ heteroaryl group), and the term "$C_1$-$C_{60}$ heteroarylthio group" as used herein indicates -$SA_{107}$ (wherein $A_{107}$ is the $C_2$-$C_{60}$ heteroaryl group).

The term "$C_2$-$C_{60}$ heteroarylalkyl group" as used herein refers to -$A_{108}A_{109}$ ($A_{109}$ is a $C_2$-$C_{59}$ heteroaryl group, and $A_{108}$ is a $C_1$-$C_{58}$ alkylene group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group," as used herein, refers to a divalent group having the same structure as the monovalent non-aromatic condensed polycyclic group.

The term "monovalent non-aromatic condensed heteropolycyclic group" as used herein refers to a monovalent

group (for example, having 2 to 60 carbon atoms) having two or more rings condensed to each other, a heteroatom selected from N, O, P, Si, and S, other than carbon atoms, as a ring-forming atom, and no aromaticity in its entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "$C_5$-$C_{30}$ carbocyclic group" as used herein refers to a saturated or unsaturated cyclic group having, as a ring-forming atom, 5 to 30 carbon atoms only. The $C_5$-$C_{30}$ carbocyclic group may be a monocyclic group or a polycyclic group.

The term "$C_1$-$C_{30}$ heterocyclic group" as used herein refers to a saturated or unsaturated cyclic group having, as a ring-forming atom, at least one heteroatom selected from N, O, Si, P, and S other than 1 to 30 carbon atoms. The $C_1$-$C_{30}$ heterocyclic group may be a monocyclic group or a polycyclic group.

At least one substituent of the substituted $\pi$ electron-depleted nitrogen-containing $C_2$-$C_{60}$ heterocyclic group, the substituted $C_3$-$C_{10}$ cycloalkylene group, the substituted $C_1$-$C_{10}$ heterocycloalkylene group, the substituted $C_3$-$C_{10}$ cycloalkenylene group, the substituted $C_1$-$C_{10}$ heterocycloalkenylene group, the substituted $C_6$-$C_{60}$ arylene group, the substituted $C_1$-$C_{60}$ heteroarylene group, the substituted divalent non-aromatic condensed polycyclic group, the substituted divalent non-aromatic condensed heteropolycyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_7$-$C_{60}$ arylalkyl group, the substituted $C_1$-$C_{60}$ heteroaryl group, the substituted $C_1$-$C_{60}$ heteroaryloxy group, the substituted $C_1$-$C_{60}$ heteroarylthio group, the substituted $C_2$-$C_{60}$ heteroarylalkyl group, the substituted monovalent non-aromatic condensed polycyclic group, and the substituted monovalent non-aromatic condensed heteropolycyclic group may be:

deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, or a $C_1$-$C_{60}$ alkoxy group;

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, - $N(Q_{11})(Q_{12})$, $-Si(Q_{13})(Q_{14})(Q_{15})$, and $-B(Q_{16})(Q_{17})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, or a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, or a monovalent non-aromatic condensed heteropolycyclic group, each substituted with at least one selected from deuterium, -F, -Cl, - Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, - $N(Q_{21})(Q_{22})$, $-Si(Q_{23})(Q_{24})(Q_{25})$, and $-B(Q_{26})(Q_{27})$; or

$-N(Q_{31})(Q_{32})$, $-Si(Q_{33})(Q_{34})(Q_{35})$, or $-B(Q_{36})(Q_{37})$, and

$Q_{11}$ to $Q_{17}$, $Q_{21}$ to $Q_{27}$, and $Q_{31}$ to $Q_{37}$ may each independently be hydrogen, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$

arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, or a monovalent non-aromatic condensed heteropolycyclic group.

The term "room temperature" as used herein refers to about 25°C.

Hereinafter, an organic light-emitting device according to embodiments are described in detail with reference to. However, the organic light-emitting device is not limited thereto.

Example

Evaluation Example 1

After a quartz substrate cleaned by using chloroform and pure water was prepared, materials shown in Table 1 were vacuum-deposited (co-deposited) at a vacuum degree of $10^{-7}$ torr to prepare films 1, 2, 3, 3 (DPEPO), 4, A, A (DPEPO), B, and B (DPEPO) each having a thickness of 50 nanometers (nm).

Table 1

| Film No. | Compound used to form film |
|---|---|
| Film 1 | Compound 1 and Compound H19 (volume ratio = 15:85) |
| Film 2 | Compound 2 and Compound H19 (volume ratio = 15:85) |
| Film 3 | Compound 3 and Compound H19 (volume ratio = 15:85) |
| Film 3 (DPEPO) | Compound 3 and DPEPO (volume ratio = 15:85) |
| Film 4 | Compound 4 and Compound H19 (volume ratio = 15:85) |
| Film A | Compound A and Compound H19 (volume ratio = 15:85) |
| Film A (DPEPO) | Compound A and DPEPO (volume ratio = 15:85) |
| Film B | Compound B and Compound H19 (volume ratio = 15:85) |
| Film B (DPEPO) | Compound B and DPEPO (volume ratio = 15:85) |

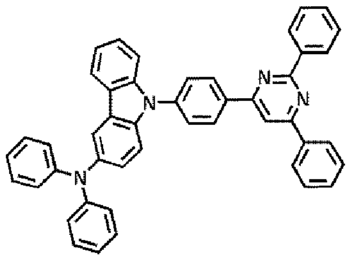

1

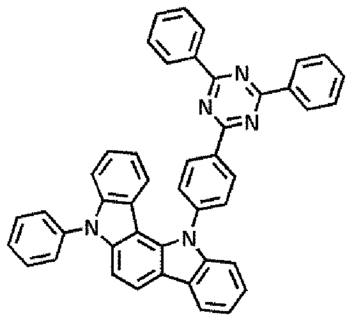

2

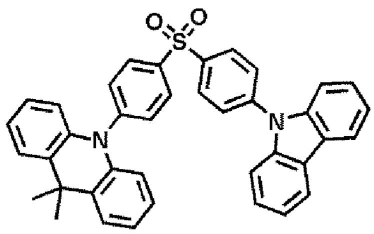

3

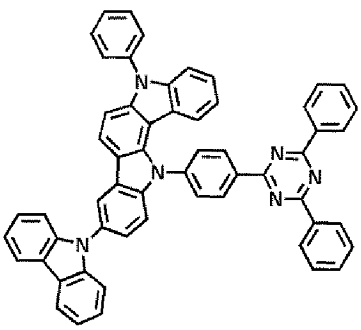

4

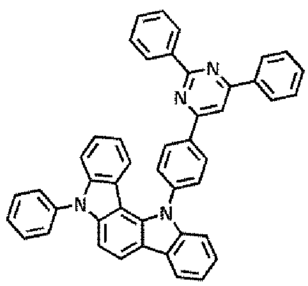

A

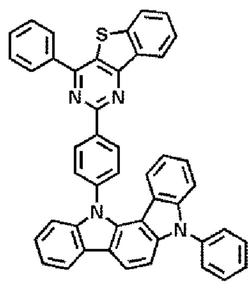

B

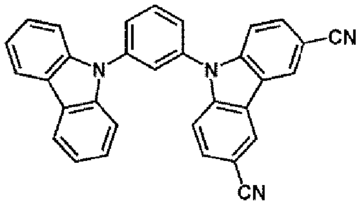

H19

DPEPO

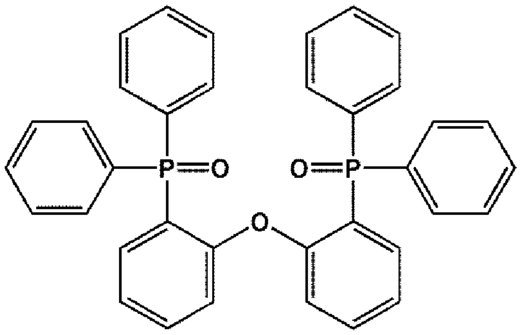

Then, photoluminescence (PL) spectra of the films 1, 2, 3, 3 (DPEPO), 4, A, A (DPEPO), B, and B (DPEPO) were evaluated by using an ISC PC1 spectrofluorometer equipped with a xenon lamp. Evaluation results are shown in FIG. 2 (PL spectrum of the film 1), FIG. 3 (PL spectrum of the film 2), FIG. 4 (PL spectra of the film 3 and the film 3 (DPEPO)), FIG. 5 (PL spectrum of the film 4), FIG. 6 (PL spectra of the film A and the film A (DPEPO)), and FIG. 7 (PL spectra of the film B and the film B (DPEPO)), and whether each film satisfies Condition 1-1 or Condition 1-2 are shown in Table 2.

Table 2

| Film No. | Whether a film satisfies Condition 1-1 | Whether a film satisfies Condition 1-2 |
|---|---|---|
| Film 1 | O | - |
| Film 2 | O | - |
| Film 3 | X | O<br>$(I_1 / I_2) \times 100 = 105\%$<br>$I_1$ = emission intensity at the shortest peak emission wavelength (440nm) in the PL spectrum of the film 3<br>$I_2$ = emission intensity at the shortest peak emission wavelength (440nm) in the PL spectrum of the film 3 (DPEPO) |
| Film 4 | O | - |
| Film A | X | X<br>$(I_1 / I_2) \times 100 = 127\%$<br>$I_1$ = emission intensity at the shortest peak emission wavelength (435nm) in the PL spectrum of the film A<br>$I_2$ = emission intensity at the shortest peak emission wavelength (435nm) in the PL spectrum of the film A (DPEPO) |
| Film B | X | X<br>$(I_1 / I_2) \times 100 = 292\%$<br>$I_1$ = emission intensity at the shortest peak emission wavelength (437nm) in the PL spectrum of the film B |

(continued)

| Film No. | Whether a film satisfies Condition 1-1 | Whether a film satisfies Condition 1-2 |
|---|---|---|
| | | $I_2$ = emission intensity at the same emission wavelength (437nm) as the shortest peak emission wavelength of the PL spectrum of the film B in the PL spectrum of B (DPEPO) |

Referring to Table 2, it is confirmed that, since the films 1 to 4 satisfies one of Condition 1-1 and Condition 1-2 but the films A and B do not satisfy both Condition 1-1 and Condition 1-2, Compounds 1 to 4 used in the films 1 to 4 are excellent TADF emitters, in which dual fluorescence is prevented, and Compounds A and B used in the films A and B have poor TADF characteristics.

Evaluation Example 2

Regarding each of Compounds 1 to 4 and Compounds A and B, with respect to rotamer (10x°) for an integer x satisfying -18 ≤ x ≤ 18,

1) attachment-detachment overlap density (see FIGS. 8 to 13)
2) rotational conformational energy (see graphs indicated by "Erc" in FIGS. 14 to 18)
3) LEosc (oscillator strength in a locally excited state of the rotamer (10x°)) (see graphs indicated by "LEosc" in FIGS. 14 to 18), and
4) CTosc (oscillator strength in a charge transfer state of the rotamer (10x°)) (see graphs indicated by "CTosc" in FIGS. 14 to 18)

were evaluated by using DFT and TD-DFT methods of a Gaussian program in which a structure was optimized at a CAM-B3LYP/6-31G(d,p) level. Evaluation results are shown in FIGS. 8 to 18. In FIGS. 14 to 18, graphs indicated by "LE" show a locally excited state energy level of the corresponding rotamer (10x°) of each Compound, and graphs indicated by "CT" show a charge transfer state energy level of the corresponding rotamer (10x°) of each compound.

First, the attachment-detachment overlap densities of the each rotamers (10x°) of Compounds 1 to 4 and Compounds A and B are shown in Table 3 with reference to FIGS. 8 to 13.

Table 3

| Compound No. | Range including 10x at which the attachment-detachment overlap density of the corresponding rotamer(10x°) is 0.65 or more | Whether Compound satisfies Condition 2-1[1] |
|---|---|---|
| 1 | -180 ~ -170<br>-130 ~ 0<br>40 ~ 180 | X |
| 2 | -130 ~ -50<br>50 ~ 130 | X |
| 3 | None | O |
| 4 | -140 ~ -40<br>40 ~ 140 | X |
| A | -130 ~ -20<br>60 ~ 160 | X |
| B | -180 ~ 180 | X |
| [1]: a condition that attachment-detachment overlap densities of all rotamer(10x°) are less than 0.65 | | |

Referring to Table 3, it is confirmed that Compound 3 satisfies Condition 2-1.

Then, whether Compounds 1, 2, 4, A, and B satisfy Condition 2-2 is shown in Table 4 with reference to FIGS. 14 to 18 showing rotational conformational energy, LEosc (oscillator strength in a locally excited state of the rotamer (10x°)), and CTosc (oscillator strength in a charge transfer state of the rotamer (10x°)) for the corresponding rotamer (10x°) of each of

Compounds 1, 2, 4, A, and B. Shaded regions in FIGS. 14 to 18 indicate a range including 10x at which the attachment-detachment overlap density of the corresponding rotamer(10x°) is 0.65 or more.

Table 4

| Compound No. | Range including 10x at which the attachment-detachment overlap density of the rotamer(10x°) is 0.65 or more | Whether Compound satisfies Condition 2-2 |
|---|---|---|
| 1 | -180 ~ -170<br>-130 ~ 0<br>40 ~ 180 | O |
| 2 | -130 ~ -50<br>50 ~ 130 | O |
| 4 | -140 ~ -40<br>40 ~ 140 | O |
| A | -130 ~ -20<br>60 ~ 160 | X (Sections $A_1$ to $A_5$ not satisfying Condition 2-2 are present) |
| B | -180 ~ 180 | X (Sections $B_1$ to $B_3$ not satisfying Condition 2-2 are present) |

Referring to Table 4, it is confirmed that Compounds 1, 2, and 4 satisfy Condition 2-2, but Compounds A and B do not satisfy Condition 2-2.

Referring to FIGS. 3 and 4, it is confirmed that Compound 3 satisfies Condition 2-1 and Compounds 1, 2, and 4 satisfy Condition 2-2, but Compounds A and B satisfy neither Condition 2-1 nor Condition 2-2.

Evaluation Example 3

PL spectra of the films 1, 2, 3, 4, A and B manufactured according to Evaluation Example 1 were evaluated at room temperature by using FluoTime 300, which is a time resolved photoluminescence (TRPL) measurement system of PicoQuant, and PLS340 (excitation wavelength = 340 nanometers, spectral width = 20 nanometers), which is a pumping source of PicoQuant, wavelengths of main peaks of the spectra were determined, and the number of photons emitted from each film at the main peak by a photon pulse (pulse width = 500 picoseconds) applied to each film by PLS340 was measured over time based on Time-Correlated Single Photon Counting (TCSPC). By repeating the above processes, a sufficiently fittable TRPL curve was obtained.

$T_{decay}$(Ex) of the films 1, 2, 3, 4, A, and B was obtained by fitting two or more exponential decay functions to a result obtained from the TRPL curve. The function used in fitting was equal to Equation 1, and the greatest value of $T_{decay}$ obtained from the exponential decay functions used in fitting was taken as $T_{decay}$(Ex). The other $T_{decay}$ values may be used to determine a lifetime of a general fluorescence decay lifetime. In this case, a baseline or background signal curve was obtained by repeating the same measurement once more in a dark state (a state in which a pumping signal incident on the film was blocked) for the same time as the measurement time for obtaining the TRPL curve, and the obtained a baseline or background signal curve was used as a baseline in fitting.

Then, a ratio of a delayed fluorescence component with respect to a total emission component was evaluated by calculating a ratio of a value obtained by integrating an exponential decay curve (= change in intensity based on time) determined by $T_{decay}$(Ex) to entire emission intensity integral value according to time. Evaluation results are shown in Table 5.

Equation 1

$$f(t) = \sum_{i=1}^{n} A_i \, exp\left(-t/T_{decay,i}\right)$$

Table 5

| Film No. | Ratio of delayed fluorescence component with respect to a total emission component (%) |
|---|---|
| Film 1 | 33.9 |
| Film 2 | 74.3 |
| Film 3 | 30.7 |
| Film 4 | 48.6 |
| Film A | 4.4 |
| Film B | 10.8 |

Referring to Table 5, it is determined that the films 1 to 4 respectively including Compounds 1 to 4 as an emitter have excellent delayed fluorescence characteristics, as compared with those of the films A and B respectively including Compounds A and B as an emitter.

Evaluation Example 4

Photoluminescent quantum yields in the films 1, 2, 4, A, and B manufactured according to Evaluation Example 1 were evaluated by using a Hamamatsu Photonics absolute PL quantum yield measurement system equipped with a xenon light source, a monochromator, a photonic multichannel analyzer, and an integrating sphere and using PLQY measurement software (Hamamatsu Photonics, Ltd., Shizuoka, Japan). Evaluation results are shown in Table 6.

Table 6

| Film No. | PLQY in film |
|---|---|
| Film 1 | 0.735 |
| Film 2 | 0.782 |
| Film 4 | 0.531 |
| Film A | 0.425 |
| Film B | 0.147 |

Referring to Table 6, it is confirmed that the films 1, 2, and 4 respectively including Compounds 1, 2, and 4 as an emitter have excellent photoluminescent quantum yields, as compared with the films A and B respectively including Compounds A and B as an emitter.

Example 1

As an anode, a glass substrate, on which an ITO electrode was formed, was cut to a size of 50 mm x 50 mm x 0.5 mm (mm = millimeter), sonicated with acetone, iso-propyl alcohol, and pure water each for 15 minutes, and then cleaned by exposure to ultraviolet (UV) rays and ozone for 30 minutes.

Then, Compound HT3 and HT-D2 (a concentration of HT-D2 was 3 percent by weight, wt%) were co-deposited on the anode to form a hole injection layer having a thickness of 100 Å, Compound HT3 was deposited on the hole injection layer to form a hole transport layer having a thickness of 1,500 Å, and mCP was deposited on the hole transport layer to form an electron blocking layer having a thickness of 100 Å, thereby forming a hole transport region having a thickness of 1,700 Å.

Compound H19 (host) and Compound 1 (dopant) were co-deposited on the hole transport region at a volume ratio of 9:1 to form an emission layer having a thickness of 400 Å.

Compound H19 was vacuum-deposited on the emission layer to form a hole blocking layer having a thickness of 100 Å, Compound ET17 and LiQ were co-deposited on the hole blocking layer at a weight ratio of 5:5 to form an electron transport layer having a thickness of 360 Å, LiQ was deposited on the electron transport layer to form an electron injection layer having a thickness of 5 Å, and Al was vacuum-deposited on the electron injection layer to form a cathode having a thickness of 120 Å, thereby completing the manufacture of an organic light-emitting device.

Examples 2 and 3 and Comparative Examples A and B

Organic light-emitting devices were manufactured in the same manner as in Example 1, except that Compounds shown in Table 7 were each used as a dopant in forming an emission layer.

Evaluation Example 5

The maximum emission wavelength and the maximum external quantum efficiency of the organic light-emitting devices manufactured according to Examples 1 to 3 and Comparative Examples A and B were measured by using a current-voltage meter (Keithley 2400) and a luminance meter (Minolta Cs-1000A). Results thereof are shown in Table 7.

Table 7

| | Host | Dopant | Maximum emission wavelength (nm) | Maximum external quantum efficiency (EQE) (%) |
|---|---|---|---|---|
| Example 1 | H19 | 1 | 500 | 16.8 |
| Example 2 | H19 | 2 | 484 | 15.6 |
| Example 3 | H19 | 4 | 472 | 14.8 |
| Comparative Example A | H19 | A | 444 | 4.2 |
| Comparative Example B | H19 | B | 444 | 2.8 |

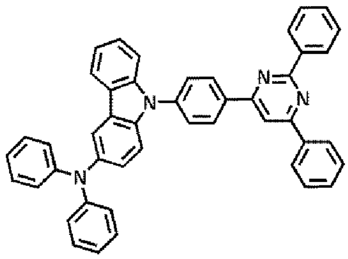

1

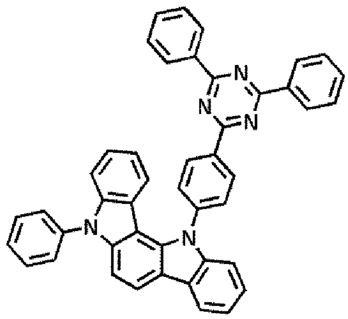

2

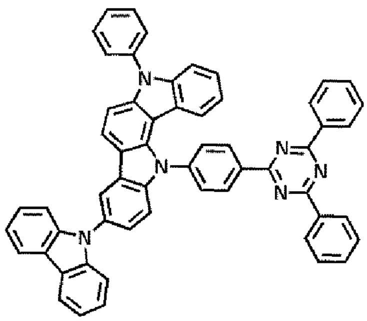

4

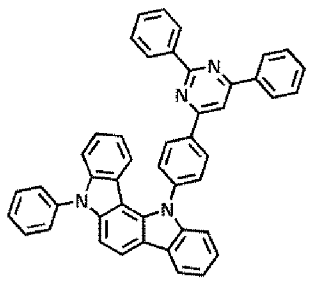

A

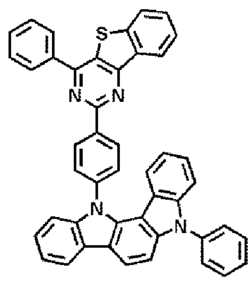

B

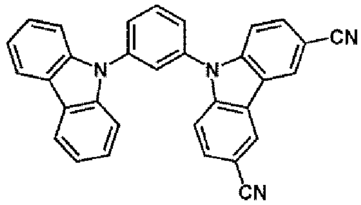

H19

Referring to Table 7, it is determined that the organic light-emitting devices of Examples 1 to 3 have improved maximum external quantum efficiency, as compared with those of the organic light-emitting devices of Comparative Examples A and B.

According to one or more embodiments, since an organic light-emitting device including a TADF emitter satisfying Condition 1-1 or Condition 1-2 may have excellent delayed fluorescence characteristics, regardless of a type of a host used together in an emission layer, the organic light-emitting device including the TADF emitter may have excellent characteristics in terms of quantum efficiency and roll-off ratio.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope of the present disclosure as defined by the following claims.

## Claims

**1.** An organic light-emitting device comprising:

a first electrode (11);
a second electrode (19) facing the first electrode; and
an organic layer (15) that is disposed between the first electrode and the second electrode, wherein the organic layer comprises an emission layer,
wherein the emission layer comprises a thermally activated delayed fluorescence (TADF) emitter and a host, the TADF emitter is different from the host, the host does not comprise DPEPO, and the TADF emitter is a compound represented by Formula 1,
the TADF emitter satisfies Condition 1-1 or Condition 1-2:

Condition 1-1
a condition that n1 is one, and
Condition 1-2
a condition that, when n1 is two or more, $(I_1 / I_2) \times 100(\%)$ is less than 110%, wherein, in Condition 1-1 and Condition 1-2,
$I_1$ (arbitrary units) is emission intensity at the shortest peak emission wavelength in a photoluminescence spectrum 1,
1) when n2 is one, $I_2$ (arbitrary units) is emission intensity at the same emission wavelength as the shortest peak emission wavelength of the photoluminescence spectrum 1 in the photoluminescence spectrum 2, and

2) when n2 is two or more, $I_2$ (arbitrary units) is emission intensity at the shortest peak emission wavelength in a photoluminescence spectrum 2,

the photoluminescence spectrum 1 is a photoluminescence spectrum of a film 1 that is doped with 15 percent by volume of the TADF emitter in a matrix with the host comprised in the emission layer and has a thickness of 50 nanometers, and

the photoluminescence spectrum 2 is a photoluminescence spectrum of a film 2 that is doped with 15 percent by volume of the TADF emitter in a matrix with DPEPO and has a thickness of 50 nanometers:

DPEPO

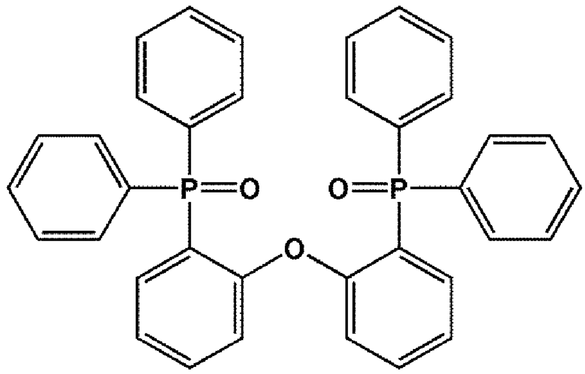

,

wherein n1 is the number of distinguishable emission peaks in the photoluminescence spectrum 1, and n2 is the number of distinguishable emission peaks in the photoluminescence spectrum 2,

Formula 1 $R_1\text{-}(D_2)_{d1}\text{-}D_1\text{-}(L_1)_{a1}\text{-}A_1$,

wherein, in Formula 1,
$L_1$ is selected from:

a single bond, a cyclopentane group, a cyclohexane group, a cycloheptane group, a cyclooctane group, a cyclopenpentene group, a cyclohexene group, a cycloheptene group, a benzene group, a naphthalene group, a fluorene group, a phenanthrene group, an anthracene group, a fluoranthene group, a triphenylene group, a pyrene group, a chrysene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyradizine group, an isoindole group, an indole group, an indazole group, a purine group, a quinoline group, an isoquinoline group, a benzoquinoline group, a quinoxaline group, a quinazoline group, a cinnoline group, a phenanthroline group, a benzimidazole group, a benzofuran group, a benzothiophene group, a benzoxazole group, an isobenzoxazole group, a triazole group, a tetrazole group, an oxadiazole group, a triazine group, a dibenzofuran group, a dibenzothiophene group, a benzocarbazole group, a dibenzocarbazole group, an imidazopyridine group, an imidazopyrimidine group, an azaindole group, an azaindene group, an azabenzofuran group, an azabenzothiophene group, an azacarbazole group, an azafluorene group, an azadibenzofuran group, and an azadibenzothiophene group; and

a cyclopentane group, a cyclohexane group, a cycloheptane group, a cyclooctane group, a cyclopenpentene group, a cyclohexene group, a cycloheptene group, a benzene group, a naphthalene group, a fluorene group, a phenanthrene group, an anthracene group, a fluoranthene group, a triphenylene group, a pyrene group, a chrysene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyradizine group, an iso-indole group, an indole group, an indazole group, a purine group, a quinoline group, an isoquinoline group, a benzoquinoline group, a quinoxaline group, a quinazoline group, a cinnoline group, a phenanthroline group, a benzimidazole group, a benzofuran group, a benzothiophene group, a benzoxazole group, an isobenzoxazole group, a triazole group, a tetrazole group, an oxadiazole group, a triazine group, a dibenzofuran group, a dibenzothiophene group, a benzocarbazole group, a dibenzocarbazole group, an imidazopyridine group, an imidazopyrimidine

group, an azaindole group, an azaindene group, an azabenzofuran group, an azabenzothiophene group, an azacarbazole group, an azafluorene group, an azadibenzofuran group, and an azadibenzothiophene group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a ($C_1$-$C_{20}$ alkyl)phenyl group, a di($C_1$-$C_{20}$ alkyl) phenyl group, a tri($C_1$-$C_{20}$ alkyl)phenyl group, a ($C_6$-$C_{20}$ aryl)phenyl group, a di($C_6$-$C_{26}$ aryl)phenyl group, a tri($C_6$-$C_{26}$ aryl)phenyl group, a ($C_3$-$C_{20}$ heteroaryl)phenyl group, a di($C_3$-$C_{20}$ heteroaryl) phenyl group, a pyridinyl group, a ($C_1$-$C_{20}$ alkyl)pyridinyl group, a di($C_1$-$C_{20}$ alkyl)pyridinyl group, a ($C_6$-$C_{20}$ aryl)pyridinyl group, a di($C_6$-$C_{26}$ aryl)pyridinyl group, a ($C_3$-$C_{20}$ heteroaryl)pyridinyl group, a di($C_3$-$C_{26}$ heteroaryl)pyridinyl group, a pyrimidinyl group, a ($C_1$-$C_{20}$ alkyl)pyrimidinyl group, a di($C_1$-$C_{20}$ alkyl)pyrimidinyl group, a ($C_6$-$C_{20}$ aryl)pyrimidinyl group, a di($C_6$-$C_{26}$ aryl)pyrimidinyl group, a ($C_3$-$C_{20}$ heteroaryl)pyrimidinyl group, a di($C_3$-$C_{26}$ heteroaryl)pyrimidinyl group, a triazinyl group, a ($C_1$-$C_{20}$ alkyl)triazinyl group, a di($C_1$-$C_{20}$ alkyl)triazinyl group, a ($C_6$-$C_{20}$ aryl)triazinyl group, a di($C_6$-$C_{26}$ aryl)triazinyl group, a ($C_3$-$C_{20}$ heteroaryl)triazinyl group, and a di($C_3$-$C_{20}$ heteroaryl)triazinyl group,

a1 is an integer from 1 to 5,

$D_1$ and $D_2$ are each an electron donor group,

d1 is an integer from 0 to 5,

$A_1$ is selected from a substituted or unsubstituted π electron-depleted nitrogen-containing $C_2$-$C_{60}$ heterocyclic group and a sulphonyl-containing group, and

$R_1$ is selected from:

hydrogen, deuterium, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_5$-$C_{60}$ carbocyclic group, and a π electron-depleted nitrogen-free $C_2$-$C_{60}$ heterocyclic group; and

a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_5$-$C_{60}$ carbocyclic group, and a π electron-depleted nitrogen-free $C_2$-$C_{60}$ heterocyclic group, each substituted with at least one selected from deuterium, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_5$-$C_{60}$ carbocyclic group, a ($C_1$-$C_{10}$ alkyl)$C_5$-$C_{60}$ carbocyclic group, a di($C_1$-$C_{10}$ alkyl)$C_5$-$C_{60}$ carbocyclic group, a (phenyl) $C_5$-$C_{60}$ carbocyclic group, a di(phenyl)$C_5$-$C_{60}$ carbocyclic group, a (biphenyl)$C_5$-$C_{60}$ carbocyclic group, a di(biphenyl)$C_5$-$C_{60}$ carbocyclic group, a π electron-depleted nitrogen-free $C_2$-$C_{60}$ heterocyclic group, a ($C_1$-$C_{10}$ alkyl) π electron-depleted nitrogen-free $C_2$-$C_{60}$ heterocyclic group, a di($C_1$-$C_{10}$ alkyl) π electron-depleted nitrogen-free $C_2$-$C_{60}$ heterocyclic group, a (phenyl) π electron-depleted nitrogen-free $C_2$-$C_{60}$ heterocyclic group, a di(phenyl) π electron-depleted nitrogen-free $C_2$-$C_{60}$ heterocyclic group, a (biphenyl) π electron-depleted nitrogen-free $C_2$-$C_{60}$ heterocyclic group, and a di(biphenyl) π electron-depleted nitrogen-free $C_2$-$C_{60}$ heterocyclic group,

provided that,

i) d1 is an integer from 1 to 5; or

ii) when d1 is zero, $A_1$ is selected from groups represented by Formulae 3-6(1), 3-10(8), and 3-12(24):

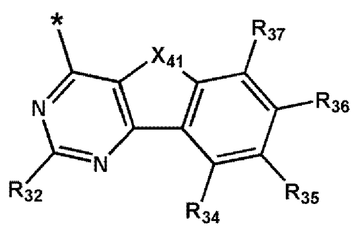

Formula 3-6(1)

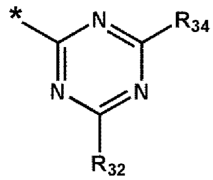

Formula 3-10(8)

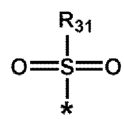

Formula 3-12(24)

wherein, in Formulae 3-6(1), 3-10(8), and 3-12(24),

$X_{41}$ is $N(R_{41})$, $C(R_{42})(R_{43})$, O, or S,

$R_{31}$, $R_{32}$, $R_{34}$ to $R_{37}$ and $R_{41}$ to $R_{43}$ are each independently selected from hydrogen, deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a ($C_1$-$C_{20}$ alkyl)phenyl group, a di($C_1$-$C_{20}$ alkyl)phenyl group, a tri($C_1$-$C_{20}$ alkyl)phenyl group, a ($C_6$-$C_{20}$ aryl)phenyl group, a di($C_6$-$C_{26}$ aryl) phenyl group, a tri($C_6$-$C_{26}$ aryl)phenyl group, a ($C_3$-$C_{20}$ heteroaryl)phenyl group, a di($C_3$-$C_{20}$ heteroaryl)phenyl group, a pyridinyl group, a ($C_1$-$C_{20}$ alkyl)pyridinyl group, a di($C_1$-$C_{20}$ alkyl)pyridinyl group, a ($C_6$-$C_{20}$ aryl)pyridinyl group, a di($C_6$-$C_{26}$ aryl)pyridinyl group, a ($C_3$-$C_{20}$ heteroaryl)pyridinyl group, a di($C_3$-$C_{20}$ heteroaryl)pyridinyl group, a pyrimidinyl group, a ($C_1$-$C_{20}$ alkyl)pyrimidinyl group, a di($C_1$-$C_{20}$ alkyl)pyrimidinyl group, a ($C_6$-$C_{20}$ aryl)pyrimidinyl group, a di($C_6$-$C_{20}$ aryl)pyrimidinyl group, a ($C_3$-$C_{20}$ heteroaryl)pyrimidinyl group, a di($C_3$-$C_{20}$ heteroaryl)pyrimidinyl group, a triazinyl group, a ($C_1$-$C_{20}$ alkyl)triazinyl group, a di($C_1$-$C_{20}$ alkyl)triazinyl group, a ($C_6$-$C_{20}$ aryl)triazinyl group, a di($C_6$-$C_{26}$ aryl)triazinyl group, a ($C_3$-$C_{20}$ heteroaryl) triazinyl group, and a di($C_3$-$C_{20}$ heteroaryl)triazinyl group, and
* indicates a binding site to a neighboring atom.

**2.** The organic light-emitting device of claim 1, wherein
the TADF emitter satisfies Condition 2-1, when assuming that rotamer (0°) is a molecular structure that the TADF emitter has in a gas-phase isolated molecular state, a constant $\alpha$ is an angle between a first plane including $D_1$ and a second plane including $A_1$ in the rotamer (0°), rotamer (10x°) is a molecular structure that the TADF emitter has in a state in which the angle between the first plane and the second plane is changed to $\alpha$ + 10x°, and x is an integer satisfying $-18 \leq x \leq 18$:

Condition 2-1
a condition that attachment-detachment overlap densities of the rotamer (10x°) are all less than 0.65, and attachment-detachment overlap density is evaluated by using DFT and TD-DFT methods in which molecular structure of the TADF emitter is optimized at a CAM-B3LYP/6-31 G(d,p) level.

**3.** The organic light-emitting device of claim 1, wherein
the TADF emitter satisfies Condition 2-2, when assuming that rotamer (0°) is a molecular structure that the TADF emitter has in a gas-phase isolated molecular state, a constant $\alpha$ is an angle between a first plane including $D_1$ and a second plane including $A_1$ in the rotamer (0°), rotamer (10x°) is a molecular structure that the TADF emitter has in a state in which the angle between the first plane and the second plane is changed to $\alpha$ + 10x°, and x is an integer satisfying $-18 \leq x \leq 18$:

Condition 2-2
a condition that at least one 10x, of which an attachment-detachment overlap density of the rotamer (10x°) is 0.65 or more, is present, and rotamer (10x°) for all values 10x, of which an attachment-detachment overlap density of rotamer (10x°) is 0.65 or more, have i) rotational conformational energy of 0.15 electron volts or more, ii) CTosc greater than LEosc, or iii) rotational conformational energy of 0.15 electron volts or more and CTosc greater than LEosc, and attachment-detachment overlap density, rotational conformational energy, CTosc and LEosc are evaluated by using DFT and TD-DFT methods in which molecular structure of the TADF emitter is optimized at a CAM-B3LYP/6-31 G(d,p) level,
wherein, in Condition 2-2, LEosc is oscillator strength in a locally excited state of the corresponding rotamer (10x°), and CTosc is oscillator strength in a charge transfer state of the corresponding rotamer (10x°).

**4.** The organic light-emitting device of any of claims 1-3, wherein
$L_1$ is selected from:

a single bond, a benzene group, a naphthalene group, a fluorene group, a pyridine group, a pyrazine group, a pyrimidine group, a pyradizine group, a quinoline group, an isoquinoline group, a benzoquinoline group, a quinoxaline group, a quinazoline group, and a triazine group; and
a benzene group, a naphthalene group, a fluorene group, a pyridine group, a pyrazine group, a pyrimidine group, a pyradizine group, a quinoline group, an isoquinoline group, a benzoquinoline group, a quinoxaline group, a quinazoline group, and a triazine group, each substituted with at least one selected from deuterium, -F, -Cl, -Br, -I,

$-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a ($C_1$-$C_{20}$ alkyl)phenyl group, a di($C_1$-$C_{20}$ alkyl)phenyl group, a ($C_6$-$C_{20}$ aryl)phenyl group, a di($C_6$-$C_{26}$ aryl)phenyl group, a ($C_3$-$C_{20}$ heteroaryl)phenyl group, a di($C_3$-$C_{20}$ heteroaryl)phenyl group, a pyridinyl group, a ($C_1$-$C_{20}$ alkyl)pyridinyl group, a di($C_1$-$C_{20}$ alkyl)pyridinyl group, a ($C_6$-$C_{20}$ aryl)pyridinyl group, a di($C_6$-$C_{26}$ aryl)pyridinyl group, a ($C_3$-$C_{20}$ heteroaryl)pyridinyl group, a di($C_3$-$C_{20}$ heteroaryl)pyridinyl group, a pyrimidinyl group, a ($C_1$-$C_{20}$ alkyl)pyrimidinyl group, a di($C_1$-$C_{20}$ alkyl)pyrimidinyl group, a ($C_6$-$C_{20}$ aryl)pyrimidinyl group, a di($C_6$-$C_{26}$ aryl)pyrimidinyl group, a ($C_3$-$C_{20}$ heteroaryl)pyrimidinyl group, a di($C_3$-$C_{20}$ heteroaryl) pyrimidinyl group, a triazinyl group, a ($C_1$-$C_{20}$ alkyl)triazinyl group, a di($C_1$-$C_{20}$ alkyl)triazinyl group, a ($C_6$-$C_{20}$ aryl)triazinyl group, a di($C_6$-$C_{20}$ aryl)triazinyl group, a ($C_3$-$C_{20}$ heteroaryl)triazinyl group, and a di($C_3$-$C_{20}$ heteroaryl)triazinyl group, and
a1 is 1 or 2.

**5.** The organic light-emitting device of any of claims 1-4, wherein

$D_1$ and $D_2$ are each independently selected from groups represented by Formulae 11-1 to 11-4:

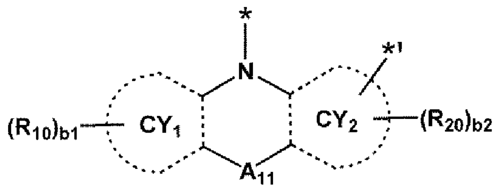
Formula 11-1

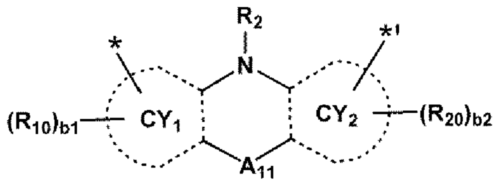
Formula 11-2

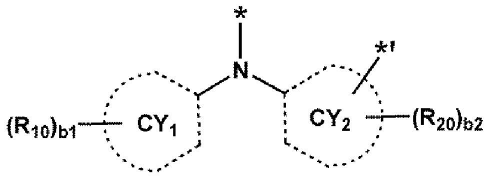
Formula 11-3

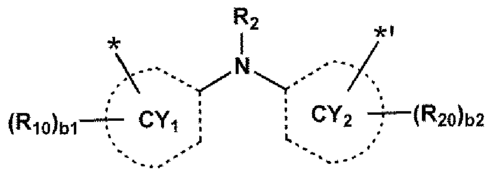
Formula 11-4

,

wherein, in Formulae 11-1 to 11-4,
$CY_1$ and $CY_2$ are each independently a $C_5$-$C_{60}$ carbocyclic group or a $C_2$-$C_{60}$ heterocyclic group,
$A_{11}$ is selected from:
a single bond, a $C_1$-$C_4$ alkylene group, and a $C_2$-$C_4$ alkenylene group; and
a $C_1$-$C_4$ alkylene group and a $C_2$-$C_4$ alkenylene group, each substituted with at least one selected from deuterium, a cyano group, a $C_1$-$C_{60}$ alkyl group, a $C_1$-$C_{60}$ alkoxy group, a phenyl group, a fluorenyl group, a carbazolyl group, a dibenzofuranyl group, and a dibenzothiophenyl group,
$R_2$, $R_{10}$, and $R_{20}$ are each independently selected from:

hydrogen, deuterium, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a furanyl group, a thiophenyl group, an indolyl group, a benzofuranyl group, a benzothiophenyl group, a carbazolyl group, a dibenzofuranyl group, a dibenzothiophenyl group, a benzocarbazolyl group, a naphthobenzofuranyl group, a naphthobenzothiophenyl group, a dibenzocarbazolyl group, a dinaphthofuranyl group, a dinaphthothiophenyl group, an indolocarbazolyl group, an indolodibenzofuranyl group, and an indolodibenzothiophenyl group; and
a $C_1$-$C_{20}$ alkyl group, a $C_1$-$C_{20}$ alkoxy group, a cyclopentyl group, a cyclohexyl group, a cycloheptyl group, a

cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a furanyl group, a thiophenyl group, an indolyl group, a benzofuranyl group, a benzothiophenyl group, a carbazolyl group, a dibenzofuranyl group, a dibenzothiophenyl group, a benzocarbazolyl group, a naphthobenzofuranyl group, a naphthobenzothiophenyl group, a dibenzocarbazolyl group, a dinaphthofuranyl group, a dinaphthothiophenyl group, an indolocarbazolyl group, an indolodibenzofuranyl group, and an indolodibenzothiophenyl group, each substituted with at least one selected from deuterium, a $C_1$-$C_{20}$ alkyl group, a $C_1$-$C_{20}$ alkoxy group, a phenyl group, a biphenyl group, a terphenyl group, a naphthyl group, a fluorenyl group, a dimethylfluorenyl group, a diphenylfluorenyl group, a carbazolyl group, a phenylcarbazolyl group, a biphenylcarbazolyl group, a dibenzofuranyl group, and a dibenzothiophenyl group,

b1 and b2 are each independently an integer from 0 to 3, and

* and *' each indicate a binding site to a neighboring atom;

preferably wherein

$D_1$ and $D_2$ are each independently selected from groups represented by Formulae 11(1) to 11(19):

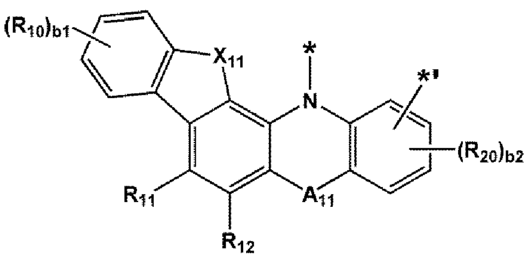

Formula 11(1)

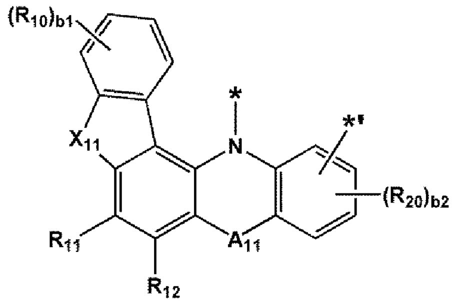

Formula 11(2)

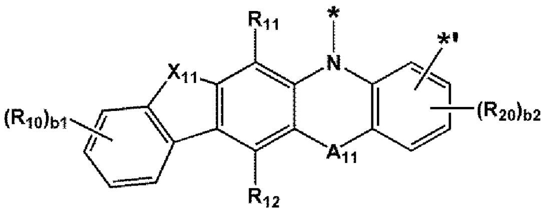

Formula 11(3)

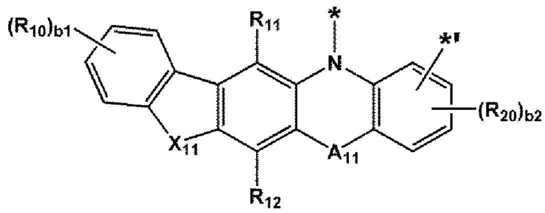

Formula 11(4)

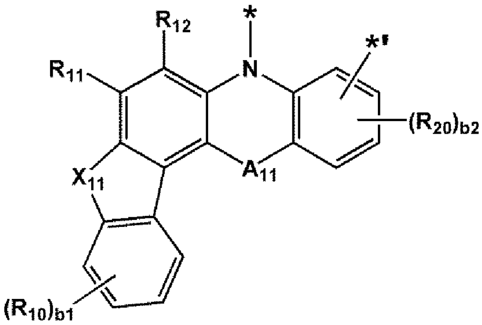

Formula 11(5)

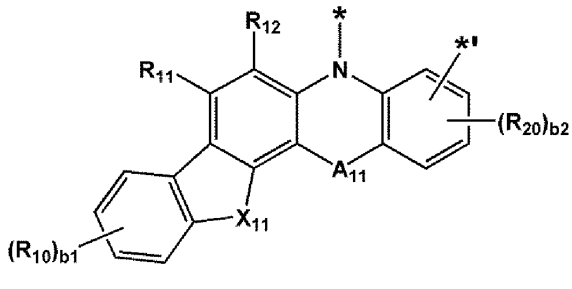

Formula 11(6)

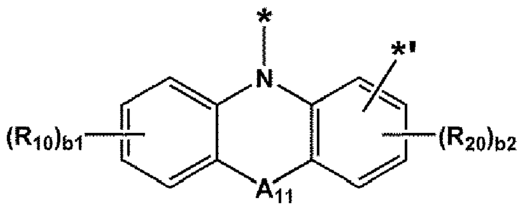

Formula 11(7)

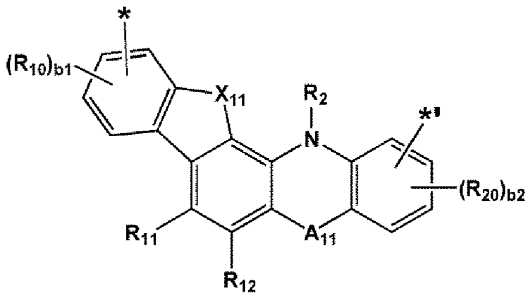

Formula 11(8)

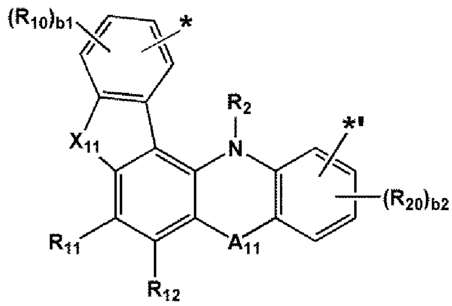

Formula 11(9)

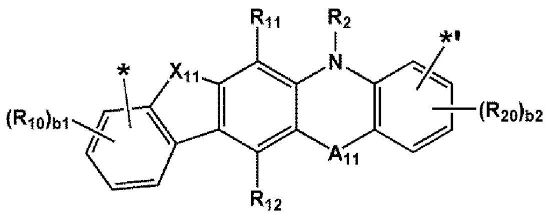

Formula 11(10)

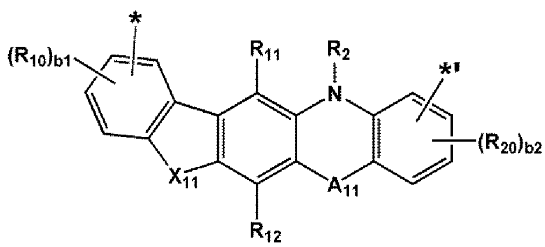

Formula 11(11)

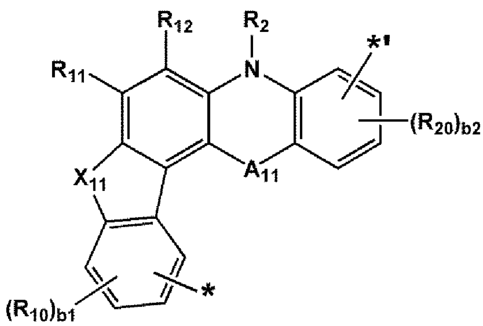

Formula 11(12)

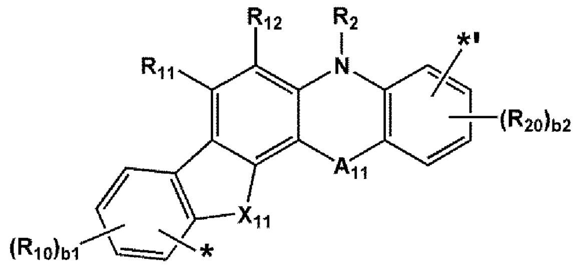

Formula 11(13)

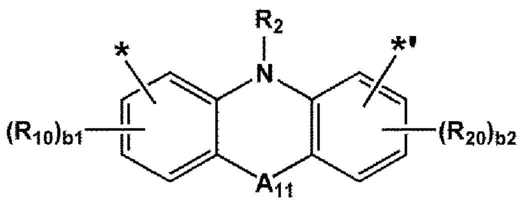

Formula 11(14)

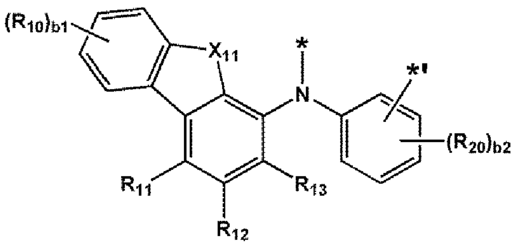
Formula 11(15)

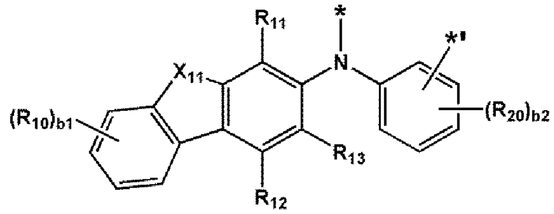
Formula 11(16)

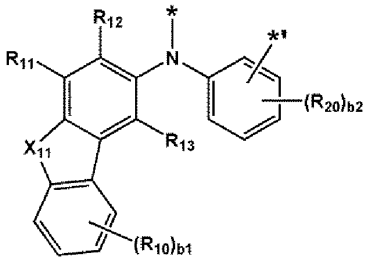
Formula 11(17)

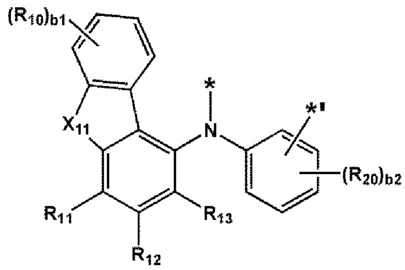
Formula 11(18)

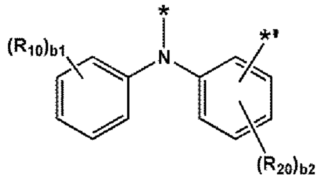
Formula 11(19)

,

wherein, in Formulae 11(1) to 11(19),
$X_{11}$ is O, S, $C(R_{14})$, or $N(R_{15})(R_{16})$,
$A_{11}$, $R_2$, $R_{10}$, $R_{20}$, b1, and b2 are each independently the same as described above,
$R_{11}$ to $R_{16}$ are each independently the same as described in connection with $R_{10}$, and
* and *' each indicate a binding site to a neighboring atom.

**6.** The organic light-emitting device of claim 5, wherein
$R_{10}$ to $R_{16}$ and $R_{26}$ are each independently selected from hydrogen, deuterium, a cyano group, a $C_1$-$C_{20}$ alkyl group, a $C_1$-$C_{20}$ alkoxy group, a phenyl group, a biphenyl group, a terphenyl group, a naphthyl group, a fluorenyl group, a dimethylfluorenyl group, a diphenylfluorenyl group, a carbazolyl group, a phenylcarbazolyl group, a biphenylcarbazolyl group, a dibenzofuranyl group, and a dibenzothiophenyl group.

**7.** The organic light-emitting device of any of claims 1-6, wherein
d1 is 1.

**8.** The organic light-emitting device of any of claims 1-7, wherein

$A_1$ is selected from groups represented by Formulae 3-1 to 3-14 and a sulphonyl-containing group:

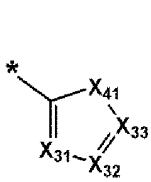
Formula 3-1

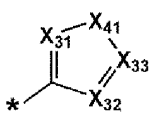
Formula 3-2

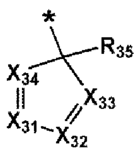
Formula 3-3

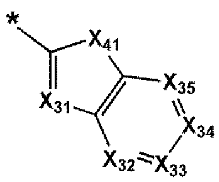
Formula 3-4

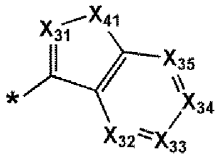
Formula 3-5

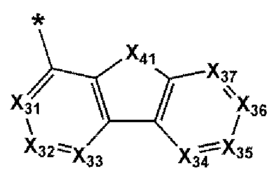
Formula 3-6

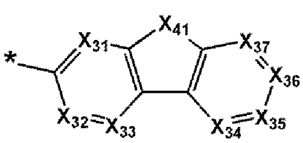
Formula 3-7

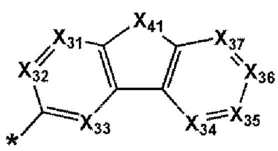
Formula 3-8

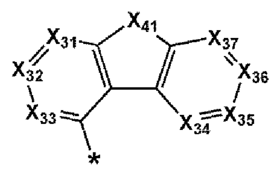
Formula 3-9

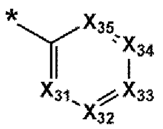
Formula 3-10

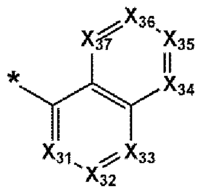
Formula 3-11

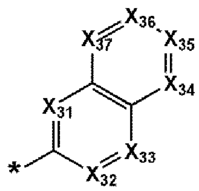
Formula 3-12

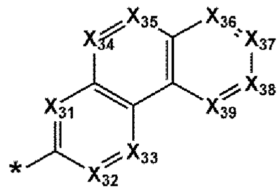
Formula 3-13

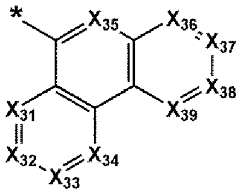
Formula 3-14

,

wherein, in Formula 3-1 to 3-14, $X_{31}$ is N or C($R_{31}$), $X_{32}$ is N or C($R_{32}$), $X_{33}$ is N or C($R_{33}$), $X_{34}$ is N or C($R_{34}$), $X_{35}$ is N or C($R_{35}$), $X_{36}$ is N or C($R_{36}$), $X_{37}$ is N or C($R_{37}$), $X_{38}$ is N or C($R_{38}$), and $X_{39}$ is N or C($R_{39}$),

$X_{41}$ in Formulae 3-1, 3-2, and 3-4 to 3-9 is N($R_{41}$), C($R_{42}$)($R_{43}$), O, or S,

at least one of $X_{31}$ to $X_{33}$ in Formulae 3-1 and 3-2 is N, at least one of $X_{31}$ to $X_{34}$ in Formula 3-3 is N, at least one of $X_{31}$ to $X_{35}$ in Formulae 3-4, 3-5, and 3-10 is N, at least one of $X_{31}$ to $X_{37}$ in Formulae 3-6 to 3-9, 3-11, and 3-12 is N, and at least one of $X_{31}$ to $X_{39}$ in Formulae 3-13 and 3-14 is N,

$R_{31}$ to $R_{39}$ and $R_{41}$ to $R_{43}$ are each independently selected from hydrogen, deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a ($C_1$-$C_{20}$ alkyl)phenyl group, a di($C_1$-$C_{20}$ alkyl)phenyl group, a tri($C_1$-$C_{20}$ alkyl)phenyl group, a ($C_6$-$C_{20}$ aryl)phenyl group, a di($C_6$-$C_{26}$ aryl)phenyl group, a tri($C_6$-$C_{26}$ aryl)phenyl group, a ($C_3$-$C_{20}$ heteroaryl)phenyl group, a di($C_3$-$C_{20}$ heteroaryl)phenyl group, a pyridinyl group, a ($C_1$-$C_{20}$ alkyl)pyridinyl group, a di($C_1$-$C_{20}$ alkyl)pyridinyl group, a ($C_6$-$C_{20}$ aryl)pyridinyl group, a di($C_6$-$C_{26}$ aryl)pyridinyl group, a ($C_3$-$C_{20}$ heteroaryl)pyridinyl group, a di($C_3$-$C_{20}$ heteroaryl)pyridinyl group, a pyrimidinyl group, a ($C_1$-$C_{20}$ alkyl)pyrimidinyl group, a di($C_1$-$C_{20}$ alkyl) pyrimidinyl group, a ($C_6$-$C_{20}$ aryl)pyrimidinyl group, a di($C_6$-$C_{20}$ aryl)pyrimidinyl group, a ($C_3$-$C_{20}$ heteroaryl) pyrimidinyl group, a di($C_3$-$C_{20}$ heteroaryl)pyrimidinyl group, a triazinyl group, a ($C_1$-$C_{20}$ alkyl)triazinyl group, a di($C_1$-$C_{20}$ alkyl)triazinyl group, a ($C_6$-$C_{20}$ aryl)triazinyl group, a di($C_6$-$C_{26}$ aryl)triazinyl group, a ($C_3$-$C_{20}$ heteroaryl)triazinyl group, and a di($C_3$-$C_{20}$ heteroaryl)triazinyl group, and

* indicates a binding site to a neighboring atom.

**9.** The organic light-emitting device of any of claims 1-7, wherein

$A_1$ is selected from groups represented by Formulae 3-4(1) to 3-4(4), 3-5(1) to 3-5(4), 3-6(1), 3-7(1), 3-8(1), 3-9(1), 3-10(1) to 3-10(8), 3-11(1) to 3-11(23), and 3-12(1) to 3-12(24):

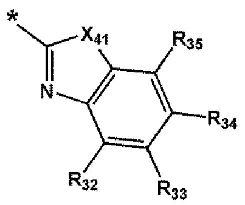
Formula 3-4(1)

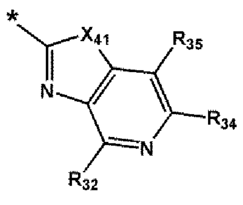
Formula 3-4(2)

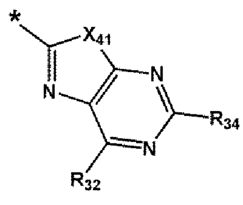
Formula 3-4(3)

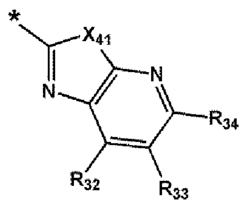
Formula 3-4(4)

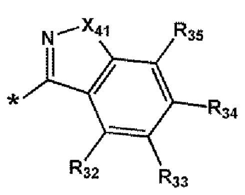
Formula 3-5(1)

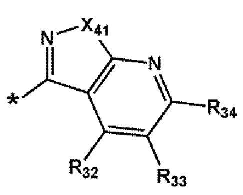
Formula 3-5(2)

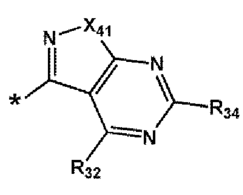
Formula 3-5(3)

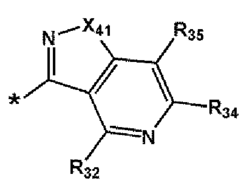
Formula 3-5(4)

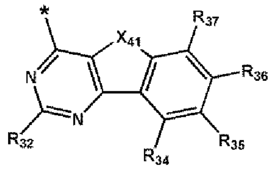
Formula 3-6(1)

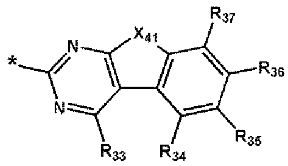
Formula 3-7(1)

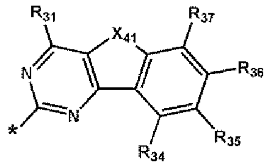
Formula 3-8(1)

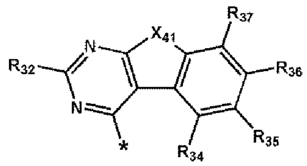
Formula 3-9(1)

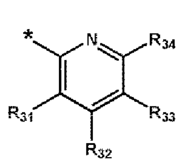
Formula 3-10(1)

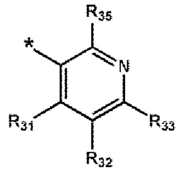
Formula 3-10(2)

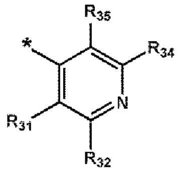
Formula 3-10(3)

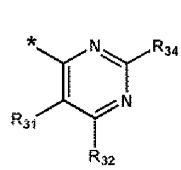
Formula 3-10(4)

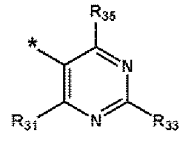
Formula 3-10(5)

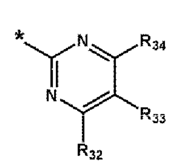
Formula 3-10(6)

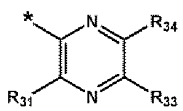
Formula 3-10(7)

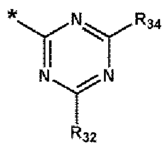
Formula 3-10(8)

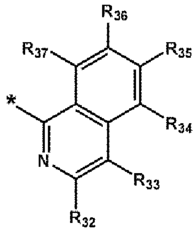
Formula 3-11(1)

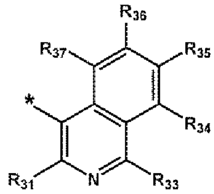
Formula 3-11(2)

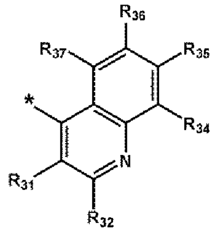
Formula 3-11(3)

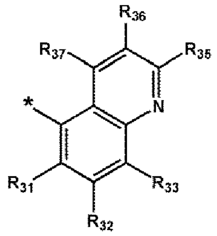
Formula 3-11(4)

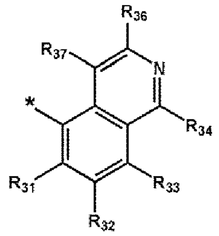
Formula 3-11(5)

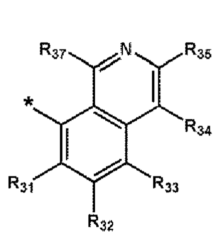
Formula 3-11(6)

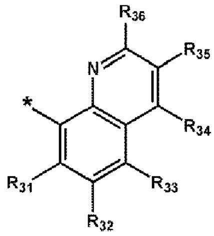
Formula 3-11(7)

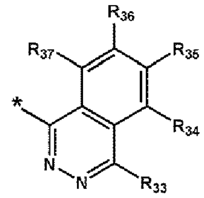
Formula 3-11(8)

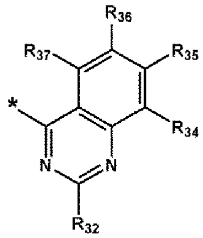
Formula 3-11(9)

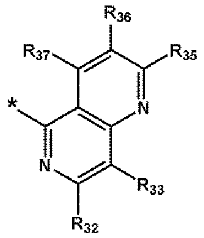
Formula 3-11(10)

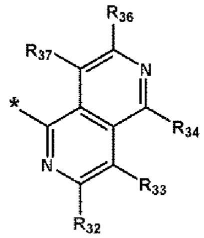
Formula 3-11(11)

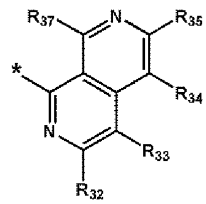
Formula 3-11(12)

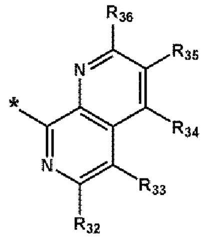
Formula 3-11(13)

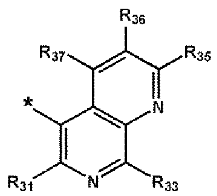
Formula 3-11(14)

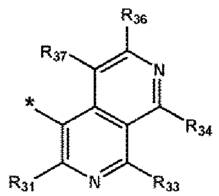
Formula 3-11(15)

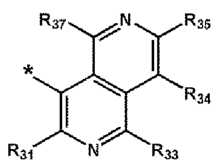
Formula 3-11(16)

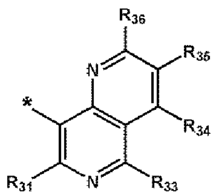
Formula 3-11(17)

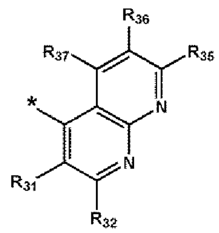
Formula 3-11(18)

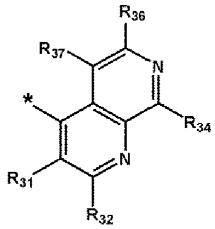
Formula 3-11(19)

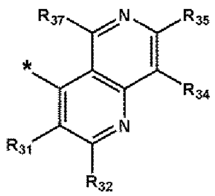
Formula 3-11(20)

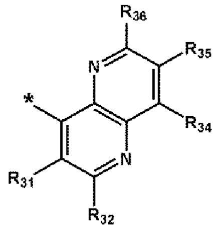
Formula 3-11(21)

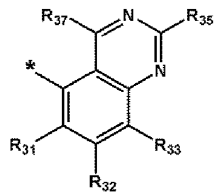
Formula 3-11(22)

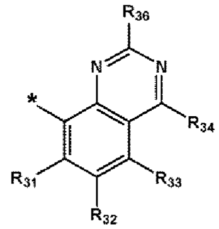
Formula 3-11(23)

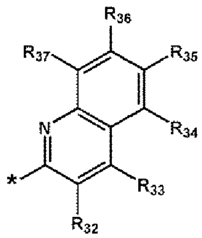
Formula 3-12(1)

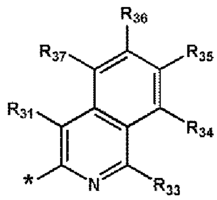
Formula 3-12(2)

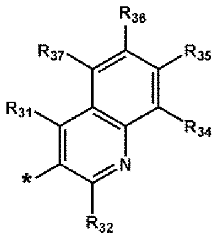
Formula 3-12(3)

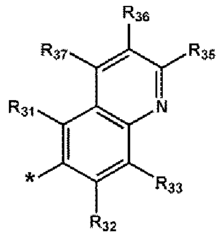
Formula 3-12(4)

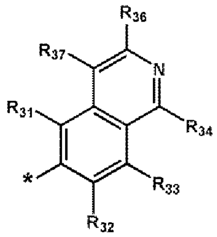
Formula 3-12(5)

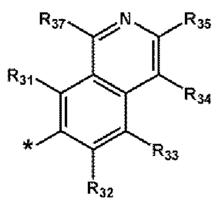
Formula 3-12(6)

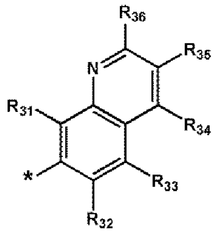
Formula 3-12(7)

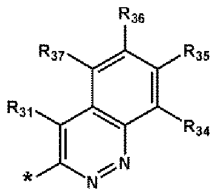
Formula 3-12(8)

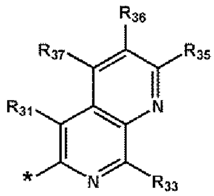
Formula 3-12(9)

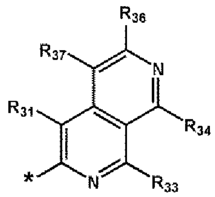
Formula 3-12(10)

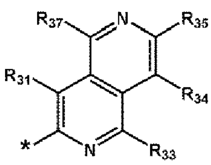
Formula 3-12(11)

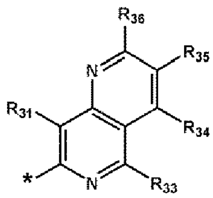
Formula 3-12(12)

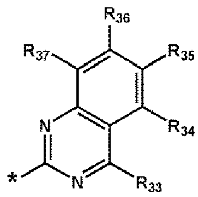
Formula 3-12(13)

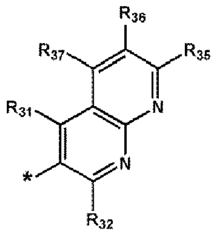
Formula 3-12(14)

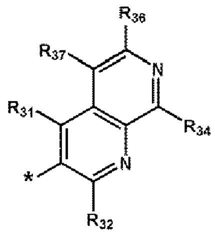
Formula 3-12(15)

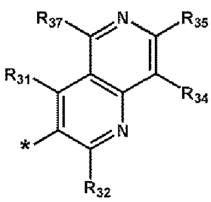
Formula 3-12(16)

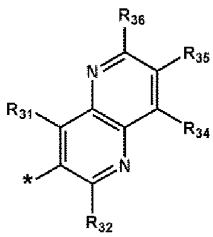
Formula 3-12(17)

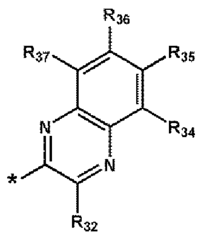
Formula 3-12(18)

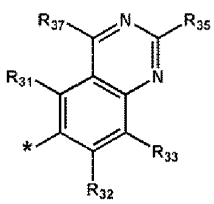
Formula 3-12(19)

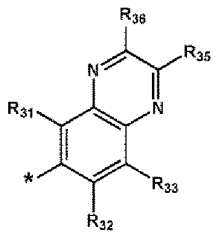
Formula 3-12(20)

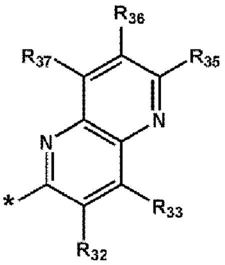

Formula 3-12(21)

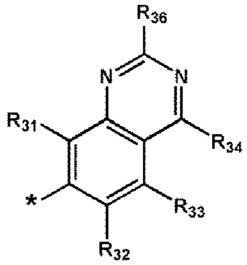

Formula 3-12(22)

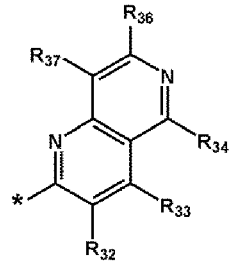

Formula 3-12(23)

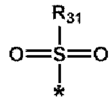

Formula 3-12(24) ,

wherein, in Formulae 3-4(1) to 3-4(4), 3-5(1) to 3-5(4), 3-6(1), 3-7(1), 3-8(1), 3-9(1), 3-10(1) to 3-10(8), 3-11(1) to 3-11(23), and 3-12(1) to 3-12(24),

$X_{41}$ is $N(R_{41})$, $C(R_{42})(R_{43})$, O, or S,

$R_{31}$ to $R_{37}$ and $R_{41}$ to $R_{43}$ are each independently selected from hydrogen, deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, a phenyl group, a ($C_1$-$C_{10}$ alkyl)phenyl group, a di($C_1$-$C_{10}$ alkyl)phenyl group, a tri($C_1$-$C_{10}$ alkyl)phenyl group, a biphenyl group, a di(phenyl)phenyl group, a tri(phenyl)phenyl group, a (pyridinyl)phenyl group, a di(pyridinyl)phenyl group, (pyrimidinyl)phenyl group, a di(pyrimidinyl)phenyl group, a (triazinyl)phenyl group, a di(triazinyl)phenyl group, a (carbazolyl)phenyl group, a pyridinyl group, a ($C_1$-$C_{10}$ alkyl)pyridinyl group, a di($C_1$-$C_{10}$ alkyl)pyridinyl group, a (phenyl)pyridinyl group, a di(phenyl)pyridinyl group, a (pyridinyl)pyridinyl group, a di(pyridinyl)pyridinyl group, a (pyrimidinyl)pyridinyl group, a di(pyrimidinyl)pyridinyl group, a (triazinyl)pyridinyl group, a di(triazinyl)pyridinyl group, a triazinyl group, a ($C_1$-$C_{10}$ alkyl)triazinyl group, a di($C_1$-$C_{10}$ alkyl)triazinyl group, a (phenyl)triazinyl group, a di(phenyl)triazinyl group, (pyridinyl)triazinyl group, a di(pyridinyl)triazinyl group, a (pyrimidinyl)triazinyl group, a di(pyrimidinyl)triazinyl group, a (triazinyl)triazinyl group, and a di(triazinyl)triazinyl group, and

* indicates a binding site to a neighboring atom;

preferably wherein

$A_1$ is selected from Formulae 3-6(1), 3-10(4), 3-10(8), and 3-12(24).

**10.** The organic light-emitting device of any of claims 1-7, wherein

$A_1$ is a triazine-containing group or a sulphonyl-containing group; and/or

wherein

$R_1$ is selected from hydrogen, deuterium, a cyano group, a $C_1$-$C_{20}$ alkyl group, a $C_1$-$C_{20}$ alkoxy group, a phenyl group, a biphenyl group, a terphenyl group, a naphthyl group, a fluorenyl group, a dimethylfluorenyl group, a diphenylfluorenyl group, a carbazolyl group, a phenylcarbazolyl group, a biphenylcarbazolyl group, a dibenzofuranyl group, and a dibenzothiophenyl group.

**11.** The organic light-emitting device of any of claims 1-10, wherein

the TADF emitter is selected from Compounds 1 to 11:

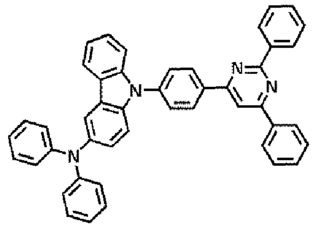

1

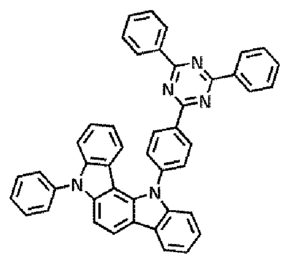

2

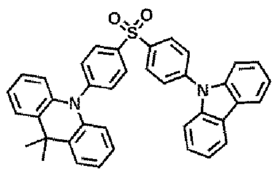

3

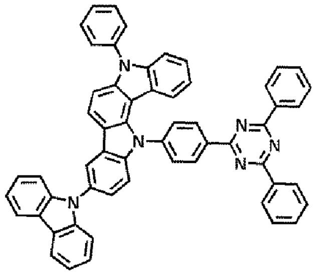

4

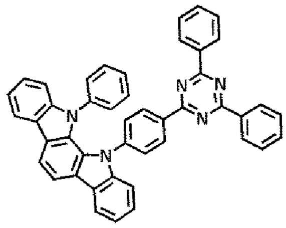

5

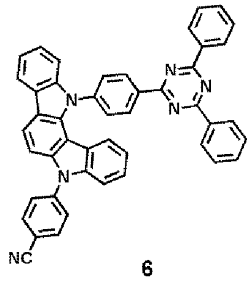

6

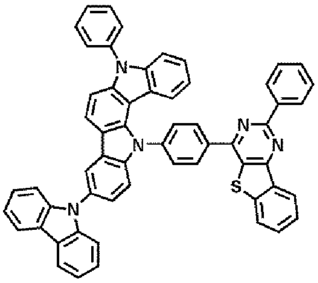

7

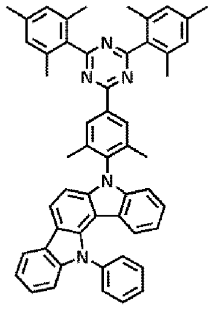

8

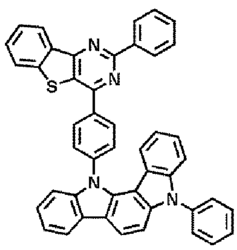

9

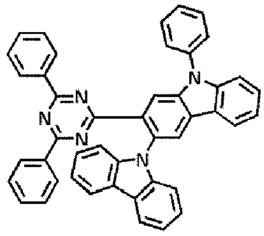

10

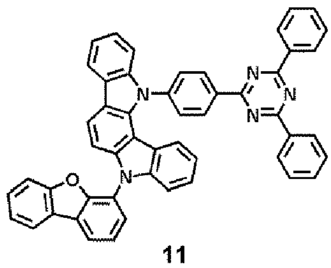

11

; and/or
wherein
the host comprises at least one compound selected from a fluorene-containing compound, a carbazole-containing compound, a dibenzofuran-containing compound, a dibenzothiophene-containing compound, an indenocarbazole-containing compound, an indolocarbazole-containing compound, a benzofurocarbazole-containing compound, a benzothienocarbazole-containing compound, an acridine-containing compound, a dihydroacridine-containing compound, a triindolobenzene-containing compound, a pyridine-containing compound, a pyrimidine-containing compound, a triazine-containing compound, a silicon-containing compound, a cyano group-containing compound, a phosphine oxide-containing compound, a sulfoxide-containing compound, and a sulphonyl-containing compound.

**12.** The organic light-emitting device of any of claims 1-11, wherein

the host is a compound comprising at least one carbazole ring and at least one cyano group or a phosphine oxide-containing compound; or
wherein
the host comprises at least one compound selected from Compounds H1 to H22 and Compound H24:

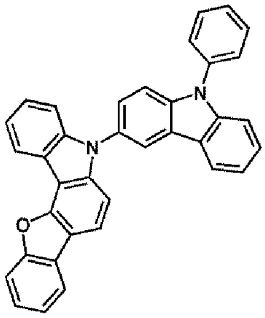

H1

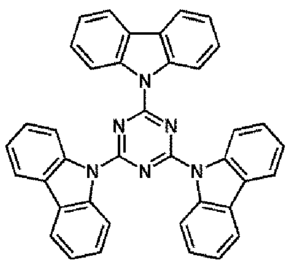

H2

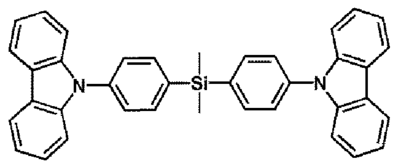

H3

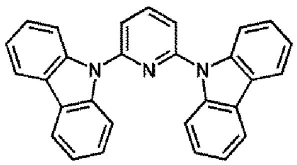

H4

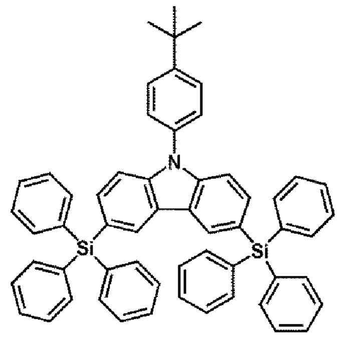

H5

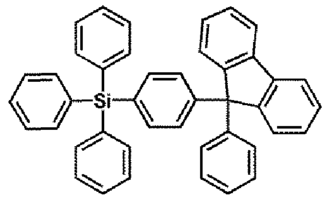

H6

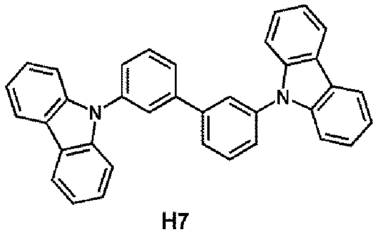

H7

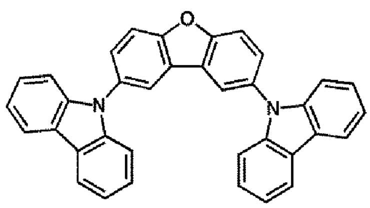

H8

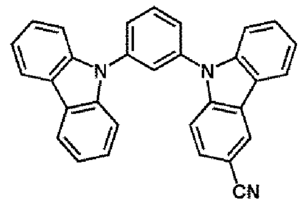

H9

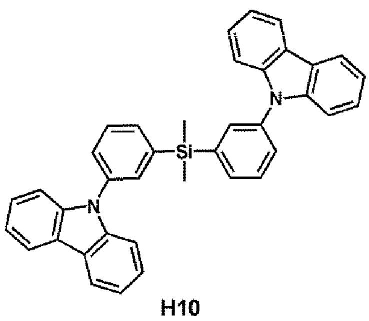

H10

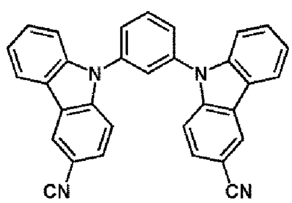

H11

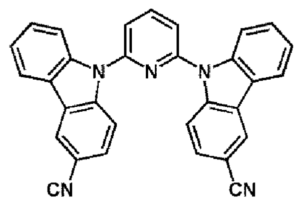

H12

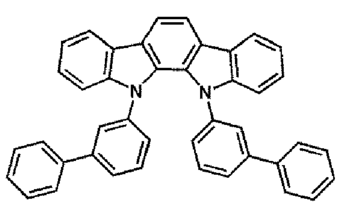

H13

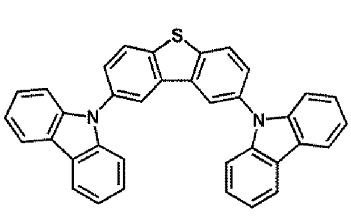

H14

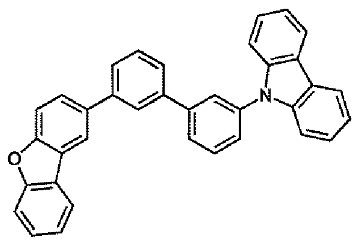

H15

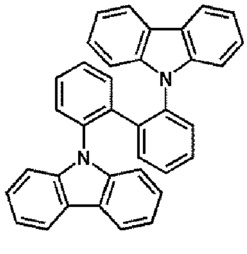
H16

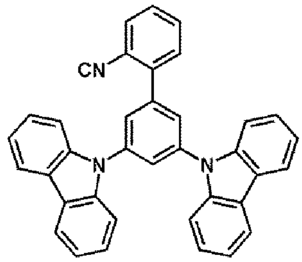
H17

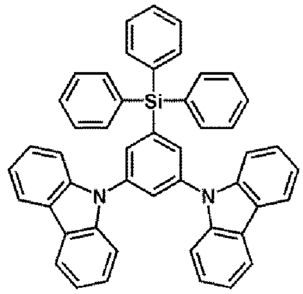
H18

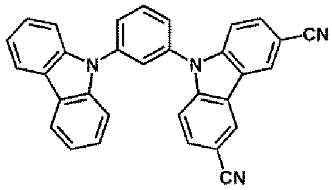
H19

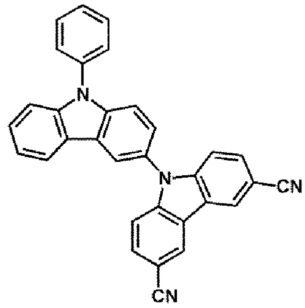
H20

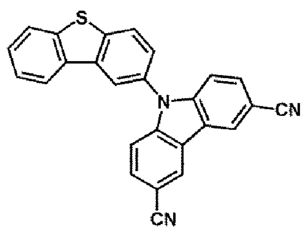
H21

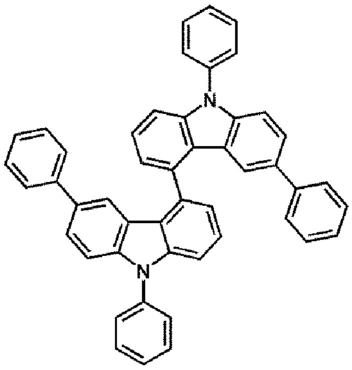
H22

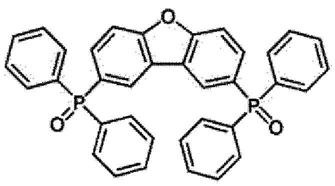
H24

**13.** The organic light-emitting device of any of claims 1-12, wherein a ratio of a delayed fluorescence component emitted from the TADF emitter with respect to a total emission component of the emission layer is 30% or more.

**14.** The organic light-emitting device of any of claims 1-13, wherein

an amount of the TADF emitter is smaller than an amount of the host; and/or
wherein
an amount of the TADF emitter in the emission layer is selected within a range of 0.01 parts by weight to 20 parts by weight based on 100 parts by weight of the emission layer.

**Patentansprüche**

**1.** Organische lichtemittierende Vorrichtung, umfassend:

eine erste Elektrode (11);
eine zweite Elektrode (19), die der ersten Elektrode zugewandt ist; und
eine organische Schicht (15), die zwischen der ersten Elektrode und der zweiten Elektrode angeordnet ist, wobei die organische Schicht eine Emissionsschicht umfasst,

wobei die Emissionsschicht einen thermisch aktivierten Emitter mit verzögerter Fluoreszenz (TADF) und einen Wirt umfasst, sich der TADF-Emitter von dem Wirt unterscheidet, der Wirt kein DPEPO umfasst und der TADF-Emitter eine Verbindung dargestellt durch Formel 1 ist,
der TADF-Emitter Bedingung 1-1 oder Bedingung 1-2 erfüllt:

Bedingung 1-1
eine Bedingung, dass n1 eins ist, und
Bedingung 1-2
eine Bedingung, dass, wenn n1 zwei oder mehr ist, $(I_1 / I_2) \times 100(\%)$ weniger als 110 % ist, wobei in Bedingung 1-1 und Bedingung 1-2
$I_1$ (willkürliche Einheiten) Emissionsintensität bei der kürzesten Peak-Emissionswellenlänge in einem Photolumineszenzspektrum 1 ist,
1) wenn n2 eins ist, $I_2$ (willkürliche Einheiten) Emissionsintensität bei derselben Emissionswellenlänge wie die kürzeste Peak-Emissionswellenlänge des Photolumineszenzspektrums 1 in dem Photolumineszenzspektrum 2 ist, und 2) wenn n2 zwei oder mehr ist, $I_2$ (willkürliche Einheiten) Emissionsintensität bei der kürzesten Peak-Emissionswellenlänge in einem Photolumineszenzspektrum 2 ist,
das Photolumineszenzspektrum 1 ein Photolumineszenzspektrum eines Films 1 ist, der mit 15 Volumenprozent des TADF-Emitters in einer Matrix mit dem Wirt dotiert ist, der in der Emissionsschicht umfasst ist und eine Dicke von 50 Nanometern aufweist, und
das Photolumineszenzspektrum 2 ein Photolumineszenzspektrum eines Films 2 ist, der mit 15 Volumenprozent des TADF-Emitters in einer Matrix mit DPEPO dotiert ist und eine Dicke von 50 Nanometern aufweist:

DPEPO

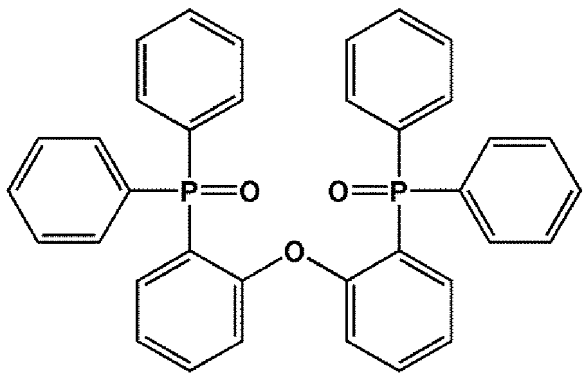

,

wobei n1 die Anzahl an unterscheidbaren Emissionspeaks in dem Photolumineszenzspektrum 1 ist und n2 die Anzahl an unterscheidbaren Emissionspeaks in dem Photolumineszenzspektrum 2 ist,

Formel 1 $R_1$-$(D_2)_{d1}$-$D_1$-$(L_1)_{a1}$-$A_1$,

wobei in Formel 1
$L_1$ ausgewählt ist aus:

einer Einfachbindung, einer Cyclopentangruppe, einer Cyclohexangruppe, einer Cycloheptangruppe, einer Cyclooctangruppe, einer Cyclopenpentengruppe, einer Cyclohexengruppe, einer Cycloheptengruppe, einer Benzolgruppe, einer Naphthalengruppe, einer Fluorengruppe, einer Phenanthrengruppe, einer Anthracengruppe, einer Fluoranthengruppe, einer Triphenylengruppe, einer Pyrengruppe, einer Chrysengruppe, einer Pyrrolgruppe, einer Thiophengruppe, einer Furangruppe, einer Imidazolgruppe, einer Pyrazolgruppe, einer Thiazolgruppe, einer Isothiazolgruppe, einer Oxazolgruppe, einer Isoxazolgruppe, einer Pyridingruppe, einer Pyrazingruppe, einer Pyrimidingruppe, einer Pyradizingruppe, einer Isoindolgruppe, einer Indolgruppe, einer Indazolgruppe, einer Puringruppe, einer Chinolingruppe, einer Isochinolingruppe, einer Benzochinolingruppe, einer Chinoxalingruppe, einer Chinazolingruppe, einer Cinnolingruppe, einer Phenanthrolingruppe, einer Benzimidazolgruppe, einer Benzofurangruppe, einer Benzothiophengruppe, einer Benzoxazolgruppe, einer Isobenzoxazolgruppe, einer Triazolgruppe, einer Tetrazolgruppe, einer Oxadiazolgruppe, einer Triazingruppe, einer Dibenzofurangruppe, einer Dibenzothiophengruppe, einer

Benzocarbazolgruppe, einer Dibenzocarbazolgruppe, einer Imidazopyridingruppe, einer Imidazopyrimidingruppe, einer Azaindolgruppe, einer Azaindengruppe, einer Azabenzofurangruppe, einer Azabenzothiophengruppe, einer Azacarbazolgruppe, einer Azafluorengruppe, einer Azadibenzofurangruppe und einer Azadibenzothiophengruppe, und

einer Cyclopentangruppe, einer Cyclohexangruppe, einer Cycloheptangruppe, einer Cyclooctangruppe, einer Cyclopenpentengruppe, einer Cyclohexengruppe, einer Cycloheptengruppe, einer Benzolgruppe, einer Naphthalengruppe, einer Fluorengruppe, einer Phenanthrengruppe, einer Anthracengruppe, einer Fluoranthengruppe, einer Triphenylengruppe, einer Pyrengruppe, einer Chrysengruppe, einer Pyrrolgruppe, einer Thiophengruppe, einer Furangruppe, einer Imidazolgruppe, einer Pyrazolgruppe, einer Thiazolgruppe, einer Isothiazolgruppe, einer Oxazolgruppe, einer Isoxazolgruppe, einer Pyridingruppe, einer Pyrazingruppe, einer Pyrimidingruppe, einer Pyradizingruppe, einer Isoindolgruppe, einer Indolgruppe, einer Indazolgruppe, einer Puringruppe, einer Chinolingruppe, einer Isochinolingruppe, einer Benzochinolingruppe, einer Chinoxalingruppe, einer Chinazolingruppe, einer Cinnolingruppe, einer Phenanthrolingruppe, einer Benzimidazolgruppe, einer Benzofurangruppe, einer Benzothiophengruppe, einer Benzoxazolgruppe, einer Isobenzoxazolgruppe, einer Triazolgruppe, einer Tetrazolgruppe, einer Oxadiazolgruppe, einer Triazingruppe, einer Dibenzofurangruppe, einer Dibenzothiophengruppe, einer Benzocarbazolgruppe, einer Dibenzocarbazolgruppe, einer Imidazopyridingruppe, einer Imidazopyrimidingruppe, einer Azaindolgruppe, einer Azaindengruppe, einer Azabenzofurangruppe, einer Azabenzothiophengruppe, einer Azacarbazolgruppe, einer Azafluorengruppe, einer Azadibenzofurangruppe und einer Azadibenzothiophengruppe, jeweils substituiert mit zumindest einem ausgewählt aus Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe, einer Phenylgruppe, einer ($C_1$-$C_{20}$-Alkyl)phenylgruppe, einer di($C_1$-$C_{20}$-Alkyl)phenylgruppe, einer tri($C_1$-$C_{20}$-Alkyl)phenylgruppe, einer ($C_6$-$C_{20}$-Aryl)phenylgruppe, einer di($C_6$-$C_{20}$-Aryl)phenylgruppe, einer tri($C_6$-$C_{20}$-Aryl)phenylgruppe, einer ($C_3$-$C_{20}$-Heteroaryl)phenylgruppe, einer di($C_3$-$C_{20}$-Heteroaryl)phenylgruppe, einer Pyridinylgruppe, einer ($C_1$-$C_{20}$-Alkyl)pyridinylgruppe, einer di($C_1$-$C_{20}$-Alkyl)pyridinylgruppe, einer ($C_6$-$C_{20}$-Aryl) pyridinylgruppe, einer di($C_6$-$C_{20}$-Aryl)pyridinylgruppe, einer ($C_3$-$C_{20}$-Heteroaryl)pyridinylgruppe, einer di($C_3$-$C_{20}$-Heteroaryl)pyridinylgruppe, einer Pyrimidinylgruppe, einer ($C_1$-$C_{20}$-Alkyl)pyrimidinylgruppe, einer di($C_1$-$C_{20}$-Alkyl)pyrimidinylgruppe, einer ($C_6$-$C_{20}$-Aryl)pyrimidinylgruppe, einer di($C_6$-$C_{20}$-Aryl)pyrimidinylgruppe, einer ($C_3$-$C_{20}$-Heteroaryl)pyrimidinylgruppe, einer di($C_3$-$C_{20}$-Heteroaryl)pyrimidinylgruppe, einer Triazinylgruppe, einer ($C_1$-$C_{20}$-Alkyl)triazinylgruppe, einer di($C_1$-$C_{20}$-Alkyl)triazinylgruppe, einer ($C_6$-$C_{20}$-Aryl)triazinylgruppe, einer di($C_6$-$C_{20}$-Aryl) triazinylgruppe, einer ($C_3$-$C_{20}$-Heteroaryl)triazinylgruppe und einer di($C_3$-$C_{20}$-Heteroaryl)triazinylgruppe,

a1 eine ganze Zahl von 1 bis 5 ist,

$D_1$ und $D_2$ jeweils eine Elektronendonorgruppe sind,

d1 eine ganze Zahl von 0 bis 5 ist,

$A_1$ ausgewählt ist aus einer substituierten oder unsubstituierten $\pi$-Elektronen-abgereicherten stickstoffhaltigen heterocyclischen $C_2$-$C_{60}$-Gruppe und einer sulfonylhaltigen Gruppe, und

$R_1$ ausgewählt ist aus:

Wasserstoff, Deuterium, einer $C_1$-$C_{60}$-Alkylgruppe, einer $C_2$-$C_{60}$-Alkenylgruppe, einer $C_2$-$C_{60}$-Alkinylgruppe, einer $C_1$-$C_{60}$-Alkoxygruppe, einer carbocyclischen $C_5$-$C_{60}$-Gruppe und einer $\pi$-Elektronen-abgereicherten stickstofffreien heterocyclischen $C_2$-$C_{60}$-Gruppe; und einer $C_1$-$C_{60}$-Alkylgruppe, einer $C_2$-$C_{60}$-Alkenylgruppe, einer $C_2$-$C_{60}$-Alkinylgruppe, einer $C_1$-$C_{60}$-Alkoxygruppe, einer carbocyclischen $C_5$-$C_{60}$-Gruppe und einer $\pi$-Elektronen-abgereicherten stickstofffreien heterocyclischen $C_2$-$C_{60}$-Gruppe, jeweils substituiert mit zumindest einem ausgewählt aus Deuterium, einer $C_1$-$C_{60}$-Alkylgruppe, einer $C_2$-$C_{60}$-Alkenylgruppe, einer $C_2$-$C_{60}$-Alkinylgruppe, einer $C_1$-$C_{60}$-Alkoxygruppe, einer carbocyclischen $C_5$-$C_{60}$-Gruppe, einer carbocyclischen ($C_1$-$C_{10}$-Alkyl)$C_5$-$C_{60}$-Gruppe, einer carbocyclischen di($C_1$-$C_{10}$-Alkyl)$C_5$-$C_{60}$-Gruppe, einer carbocyclischen (Phenyl)$C_5$-$C_{60}$-Gruppe, einer carbocyclischen di(Phenyl)$C_5$-$C_{60}$-Gruppe, einer carbocyclischen (Biphenyl)$C_5$-$C_{60}$-Gruppe, einer carbocyclischen di(Biphenyl)$C_5$-$C_{60}$-Gruppe, einer $\pi$-Elektronen-abgereicherten stickstofffreien heterocyclischen $C_2$-$C_{60}$-Gruppe, einer ($C_1$-$C_{10}$-Alkyl)-$\pi$-Elektronen-abgereicherten stickstofffreien

heterocyclischen $C_2$-$C_{60}$-Gruppe, einer di($C_1$-$C_{10}$-Alkyl)-π-Elektronen-abgereicherten stickstofffreien heterocyclischen $C_2$-$C_{60}$-Gruppe, einer (Phenyl)-π-Elektronen-abgereicherten stickstofffreien heterocyclischen $C_2$-$C_{60}$-Gruppe, einer di(Phenyl)-π-Elektronen-abgereicherten stickstofffreien heterocyclischen $C_2$-$C_{60}$-Gruppe, einer (Biphenyl)-π-Elektronen-abgereicherten stickstofffreien heterocyclischen $C_2$-$C_{60}$-Gruppe und einer di(Biphenyl)-π-Elektronen-abgereicherten stickstofffreien heterocyclischen $C_2$-$C_{60}$-Gruppe,
vorausgesetzt, dass

i) d1 eine ganze Zahl von 1 bis 5 ist, oder
ii) wenn d1 null ist, $A_1$ ausgewählt ist aus Gruppen dargestellt durch Formel 3-6(1), 3-10(8) und 3-12(24):

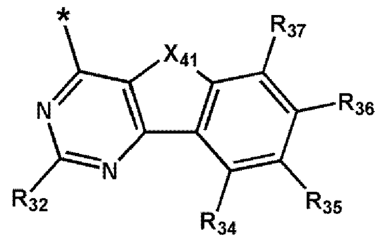

**Formel 3-6(1)**

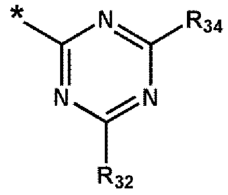

**Formel 3-10(8)**

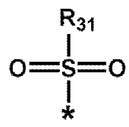

**Formel 3-12(24)**,

wobei in Formel 3-6(1), 3-10(8) und 3-12(24)
$X_{41}$ $N(R_{41})$, $C(R_{42})(R_{43})$, O oder S ist,
$R_{31}$, $R_{32}$, $R_{34}$ bis $R_{37}$ und $R_{41}$ bis $R_{43}$ jeweils unabhängig ausgewählt sind aus Wasserstoff, Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe, einer Phenylgruppe, einer ($C_1$-$C_{20}$-Alkyl)phenylgruppe, einer di($C_1$-$C_{20}$-Alkyl)phenylgruppe, einer tri($C_1$-$C_{20}$-Alkyl)phenylgruppe, einer ($C_6$-$C_{20}$-Aryl)phenylgruppe, einer di($C_6$-$C_{20}$-Aryl)phenylgruppe, einer tri($C_6$-$C_{20}$-Aryl) phenylgruppe, einer ($C_3$-$C_{20}$-Heteroaryl)phenylgruppe, einer di($C_3$-$C_{20}$-Heteroaryl) phenylgruppe, einer Pyridinylgruppe, einer ($C_1$-$C_{20}$-Alkyl)pyridinylgruppe, einer di($C_1$-$C_{20}$-Alkyl)pyridinylgruppe, einer ($C_6$-$C_{20}$-Aryl)pyridinylgruppe, einer di($C_6$-$C_{20}$-Aryl)pyridinylgruppe, einer ($C_3$-$C_{20}$-Heteroaryl)pyridinylgruppe, einer di($C_3$-$C_{20}$-Heteroaryl)pyridinylgruppe, einer Pyrimidinylgruppe, einer ($C_1$-$C_{20}$-Alkyl) pyrimidinylgruppe, einer di($C_1$-$C_{20}$-Alkyl)pyrimidinylgruppe, einer ($C_6$-$C_{20}$-Aryl)pyrimidinylgruppe, einer di($C_6$-$C_{20}$-Aryl)pyrimidinylgruppe, einer ($C_3$-$C_{20}$-Heteroaryl)pyrimidinylgruppe einer di($C_3$-$C_{20}$-Heteroaryl)pyrimidinylgruppe, einer Triazinylgruppe, einer ($C_1$-$C_{20}$-Alkyl)triazinylgruppe, einer di($C_1$-$C_{20}$-Alkyl)triazinylgruppe, einer ($C_6$-$C_{20}$-Aryl)triazinylgruppe, einer di($C_6$-$C_{20}$-Aryl)triazinylgruppe, einer ($C_3$-$C_{20}$-Heteroaryl)triazinylgruppe und einer di($C_3$-$C_{20}$-Heteroaryl)triazinylgruppe, und
* eine Bindungsstelle zu einem benachbarten Atom angibt.

**2.** Organische lichtemittierende Vorrichtung nach Anspruch 1, wobei der TADF-Emitter Bedingung 2-1 erfüllt, wenn angenommen wird, dass Rotamer (0°) eine molekulare Struktur ist, die der TADF-Emitter in einem gasphasenisolierten molekularen Zustand aufweist, eine Konstante α ein Winkel zwischen einer ersten Ebene beinhaltend $D_1$ und einer zweiten Ebene beinhaltend $A_1$ in dem Rotamer (0°) ist, Rotamer (10x°) eine molekulare Struktur ist, die der TADF-Emitter in einem Zustand aufweist, in dem der Winkel zwischen der ersten Ebene und der zweiten Ebene zu $\alpha + 10x°$ geändert wird, und x eine ganze Zahl ist, die $-18 \leq x \leq 18$ erfüllt:

Bedingung 2-1
eine Bedingung, dass Bindungsablösungsüberlappungsdichten des Rotamers (10x°) alle kleiner als 0,65 sind

und Bindungsablösungsüberlappungsdichte durch Verwenden von DFT- und TD-DFT-Verfahren bewertet wird, bei denen molekulare Struktur des TADF-Emitters auf einem CAM-B3LYP/6-31G(d,p)-Niveau optimiert wird.

**3.** Organische lichtemittierende Vorrichtung nach Anspruch 1, wobei der TADF-Emitter Bedingung 2-2 erfüllt, wenn angenommen wird, dass Rotamer (0°) eine molekulare Struktur ist, die der TADF-Emitter in einem gasphasenisolierten molekularen Zustand aufweist, eine Konstante $\alpha$ ein Winkel zwischen einer ersten Ebene beinhaltend $D_1$ und einer zweiten Ebene beinhaltend $A_1$ in dem Rotamer (0°) ist, Rotamer (10x°) eine molekulare Struktur ist, die der TADF-Emitter in einem Zustand aufweist, in dem der Winkel zwischen der ersten Ebene und der zweiten Ebene zu $\alpha$ + 10x° geändert wird, und x eine ganze Zahl ist, die $-18 \leq x \leq 18$ erfüllt:

Bedingung 2-2
eine Bedingung, dass zumindest ein 10x, von dem eine Bindungsablösungsüberlappungsdichte des Rotamers (10x°) 0,65 oder mehr ist, vorhanden ist, und Rotamer (10x°) für alle Werte 10x, von denen eine Bindungsablösungsüberlappungsdichte von Rotamer (10x°) 0,65 oder mehr ist, i) Rotationskonformationsenergie von 0,15 Elektronenvolt oder mehr, ii) CTosc größer als LEosc oder iii) Rotationskonformationsenergie von 0,15 Elektronenvolt oder mehr und CTosc größer als LEosc aufweisen, und Bindungsablösungsüberlappungsdichte, Rotationskonformationsenergie, CTosc und LEosc durch Verwenden von DFT- und TD-DFT-Verfahren bewertet werden, bei denen molekulare Struktur des TADF-Emitters auf einem CAM-B3LYP6-31G(d,p)-Niveau optimiert wird,
wobei in Bedingung 2-2 LEosc Oszillatorstärke in einem lokal angeregten Zustand des entsprechenden Rotamers (10x°) ist und CTosc Oszillatorstärke in einem Ladungsübertragungszustand des entsprechenden Rotamers (10x°) ist.

**4.** Organische lichtemittierende Vorrichtung nach einem der Ansprüche 1-3, wobei $L_1$ ausgewählt ist aus:

einer Einfachbindung, einer Benzolgruppe, einer Naphthalengruppe, einer Fluorengruppe, einer Pyridingruppe, einer Pyrazingruppe, einer Pyrimidingruppe, einer Pyradizingruppe, einer Chinolingruppe, einer Isochinolingruppe, einer Benzochinolingruppe, einer Chinoxalingruppe, einer Chinazolingruppe und einer Triazingruppe; und
einer Benzolgruppe, einer Naphthalengruppe, einer Fluorengruppe, einer Pyridingruppe, einer Pyrazingruppe, einer Pyrimidingruppe, einer Pyradizingruppe, einer Chinolingruppe, einer Isochinolingruppe, einer Benzochinolingruppe, einer Chinoxalingruppe, einer Chinazolingruppe und einer Triazingruppe, jeweils substituiert mit zumindest einem ausgewählt aus Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe, einer Phenylgruppe, einer ($C_1$-$C_{20}$-Alkyl)phenylgruppe, einer di($C_1$-$C_{20}$-Alkyl)phenylgruppe, einer ($C_6$-$C_{20}$-Aryl)phenylgruppe, einer di($C_6$-$C_{20}$-Aryl)phenylgruppe, einer ($C_3$-$C_{20}$-Heteroaryl)phenylgruppe, einer di($C_3$-$C_{20}$-Heteroaryl)phenylgruppe, einer Pyridinylgruppe, einer ($C_1$-$C_{20}$-Alkyl)pyridinylgruppe, einer di($C_1$-$C_{20}$-Alkyl)pyridinylgruppe, einer ($C_6$-$C_{20}$-Aryl)pyridinylgruppe, einer di($C_6$-$C_{20}$-Aryl)pyridinylgruppe, einer ($C_3$-$C_{20}$-Heteroaryl)pyridinylgruppe, einer di($C_3$-$C_{20}$-Heteroaryl)pyridinylgruppe, einer Pyrimidinylgruppe, einer ($C_1$-$C_{20}$-Alkyl)pyrimidinylgruppe, einer di($C_1$-$C_{20}$-Alkyl)pyrimidinylgruppe, einer ($C_6$-$C_{20}$-Aryl) pyrimidinylgruppe, einer di($C_6$-$C_{20}$-Aryl)pyrimidinylgruppe, einer ($C_3$-$C_{20}$-Heteroaryl)pyrimidinylgruppe, einer di($C_3$-$C_{20}$-Heteroaryl)pyrimidinylgruppe, einer Triazinylgruppe, einer ($C_1$-$C_{20}$-Alkyl)triazinylgruppe, einer di($C_1$-$C_{20}$-Alkyl)triazinylgruppe, einer ($C_6$-$C_{20}$-Aryl)triazinylgruppe, einer di($C_6$-$C_{20}$-Aryl)triazinylgruppe, einer ($C_3$-$C_{20}$-Heteroaryl)triazinylgruppe und einer di($C_3$-$C_{20}$-Heteroaryl)triazinylgruppe, und
a1 1 oder 2 ist.

**5.** Organische lichtemittierende Vorrichtung nach einem der Ansprüche 1-4, wobei

$D_1$ und $D_2$ jeweils unabhängig ausgewählt sind aus Gruppen dargestellt durch Formel 11-1 bis 11-4:

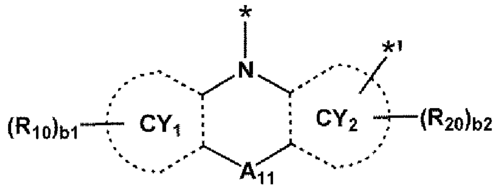

Formel 11-1

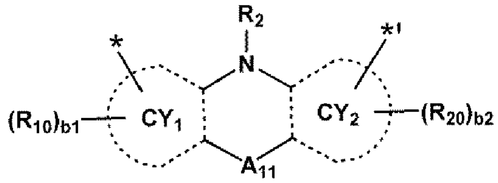

Formel 11-2

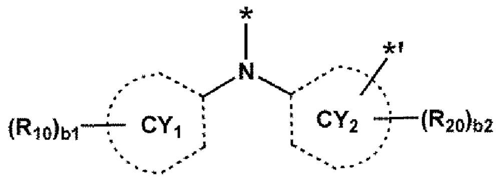

Formel 11-3

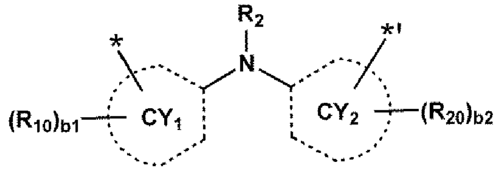

Formel 11-4,

wobei in Formel 11-1 bis 11-4
$CY_1$ und $CY_2$ jeweils unabhängig eine carbocyclische $C_5$-$C_{60}$-Gruppe oder eine heterocyclische $C_2$-$C_{60}$-Gruppe sind,
$A_{11}$ ausgewählt ist aus:

einer Einfachbindung, einer $C_1$-$C_4$-Alkylengruppe und einer $C_2$-$C_4$-Alkenylengruppe; und
einer $C_1$-$C_4$-Alkylengruppe und einer $C_2$-$C_4$-Alkenylengruppe, jeweils substituiert mit zumindest einem ausgewählt aus Deuterium, einer Cyanogruppe, einer $C_1$-$C_{60}$-Alkylgruppe, einer $C_1$-$C_{60}$-Alkoxygruppe, einer Phenylgruppe, einer Fluorenylgruppe, einer Carbazolylgruppe, einer Dibenzofuranylgruppe und einer Dibenzothiophenylgruppe,
$R_2$, $R_{10}$ und $R_{20}$ jeweils unabhängig ausgewählt sind aus:

Wasserstoff, Deuterium, einer $C_1$-$C_{20}$-Alkylgruppe, einer $C_1$-$C_{20}$-Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spiro-Bifluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Furanylgruppe, einer Thiophenylgruppe, einer Indolylgruppe, einer Benzofuranylgruppe, einer Benzothiophenylgruppe, einer Carbazolylgruppe, einer Dibenzofuranylgruppe, einer Dibenzothiophenylgruppe, einer Benzocarbazolylgruppe, einer Naphthobenzofuranylgruppe, einer Naphthobenzothiophenylgruppe, einer Dibenzocarbazolylgruppe, einer Dinaphthofuranylgruppe, einer Dinaphthothiophenylgruppe, einer Indolocarbazolylgruppe, einer Indolodibenzofuranylgruppe und einer Indolodibenzothiophenylgruppe, und
einer $C_1$-$C_{20}$-Alkylgruppe, einer $C_1$-$C_{20}$-Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spiro-Bifluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Furanylgruppe, einer Thiophenylgruppe, einer Indolylgruppe, einer Benzofuranylgruppe, einer Benzothiophenylgruppe, einer Carbazolylgruppe, einer Dibenzofuranylgruppe, einer Dibenzothiophenylgruppe, einer Benzocarbazolylgruppe, einer

Naphthobenzofuranylgruppe, einer Naphthobenzothiophenylgruppe, einer Dibenzocarbazolylgruppe, einer Dinaphthofuranylgruppe, einer Dinaphthothiophenylgruppe, einer Indolocarbazolylgruppe, einer Indolodibenzofuranylgruppe und einer Indolodibenzothiophenylgruppe, jeweils substituiert mit zumindest einem ausgewählt aus Deuterium, einer $C_1$-$C_{20}$-Alkylgruppe, einer $C_1$-$C_{20}$-Alkoxygruppe, einer Phenylgruppe, einer Biphenylgruppe, einer Terphenylgruppe, einer Naphthylgruppe, einer Fluorenylgruppe, einer Dimethylfluorenylgruppe, einer Diphenylfluorenylgruppe, einer Carbazolylgruppe, einer Phenylcarbazolylgruppe, einer Biphenylcarbazolylgruppe, einer Dibenzofuranylgruppe und einer Dibenzothiophenylgruppe,
b1 und b2 jeweils unabhängig eine ganze Zahl von 0 bis 3 sind, und
* und *' jeweils eine Bindungsstelle zu einem benachbarten Atom angeben;
wobei bevorzugt
$D_1$ und $D_2$ jeweils unabhängig ausgewählt sind aus Gruppen dargestellt durch Formel 11(1) bis 11(19):

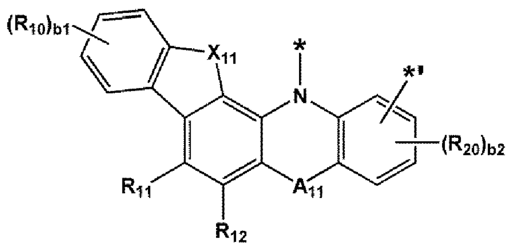

**Formel 11(1)**

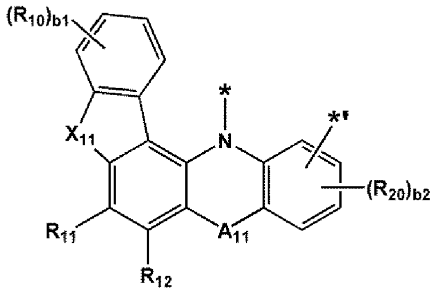

**Formel 11(2)**

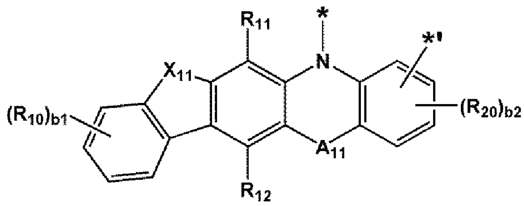

**Formel 11(3)**

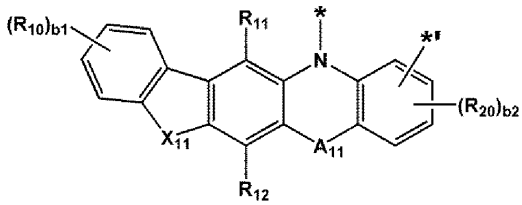

**Formel 11(4)**

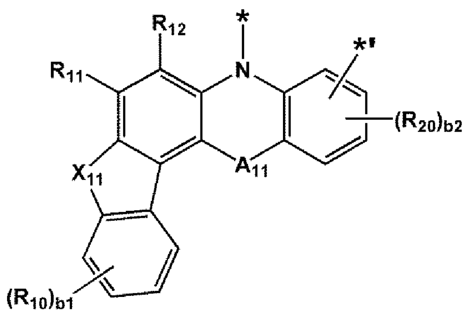

**Formel 11(5)**

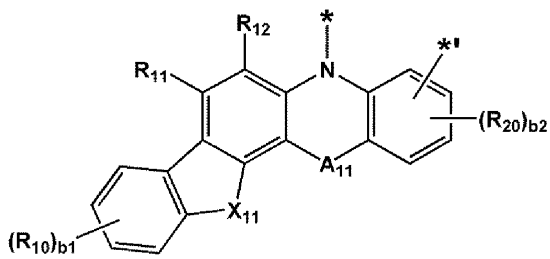

**Formel 11(6)**

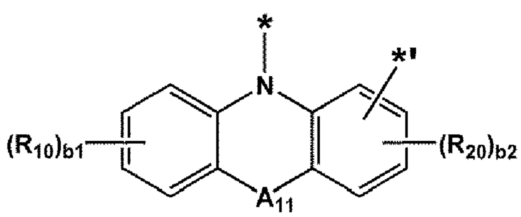

**Formel 11(7)**

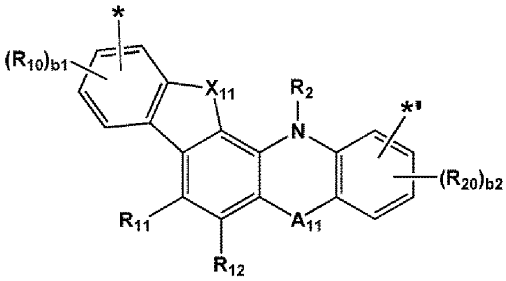

Formel 11(8)

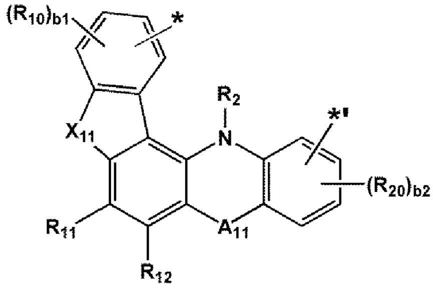

Formel 11(9)

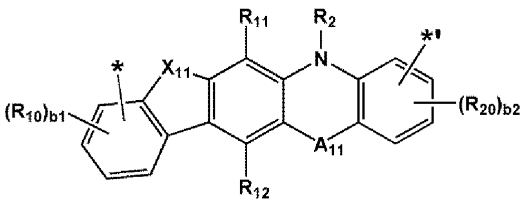

Formel 11(10)

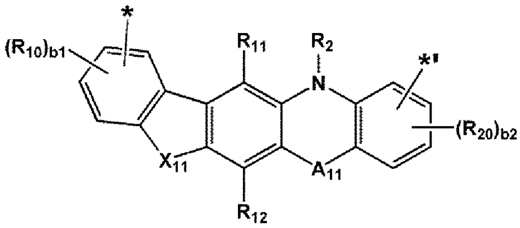

Formel 11(11)

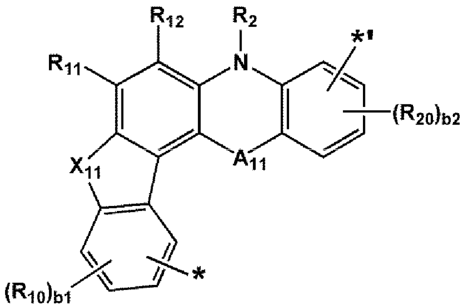

Formel 11(12)

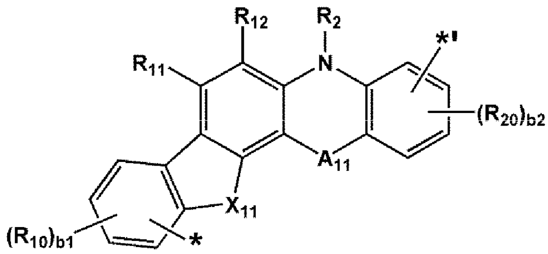

Formel 11(13)

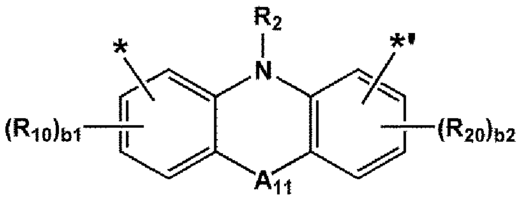

Formel 11(14)

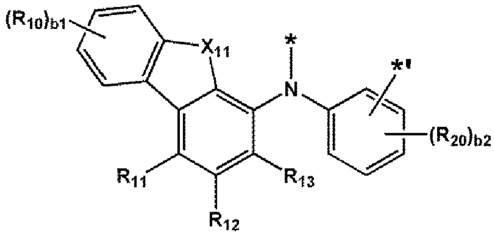

Formel 11(15)

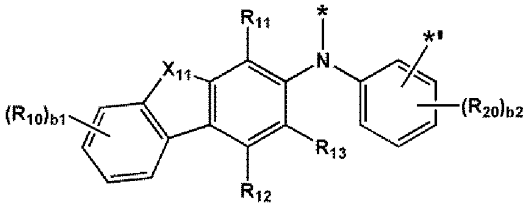

Formel 11(16)

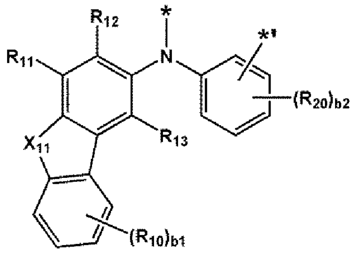

**Formel 11(17)**

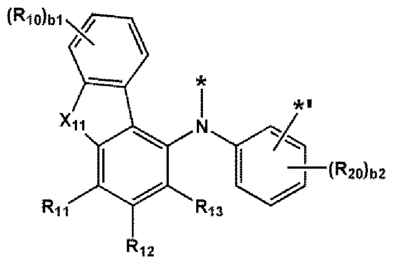

**Formel 11(18)**

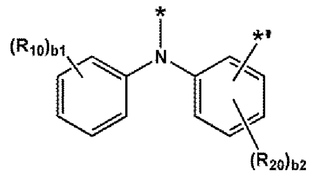

**Formel 11(19)**

wobei in Formel 11 (1) bis 11 (19)
$X_{11}$ O, S, $C(R_{14})$ oder $N(R_{15})(R_{16})$ ist,
$A_{11}$, $R_2$, $R_{10}$, $R_{20}$, b1 und b2 jeweils unabhängig das gleiche wie oben beschrieben sind,
$R_{11}$ bis $R_{16}$ jeweils unabhängig das gleiche wie in Verbindung mit $R_{10}$ beschrieben sind, und
* und *' jeweils eine Bindungsstelle zu einem benachbarten Atom angeben.

**6.** Organische lichtemittierende Vorrichtung nach Anspruch 5, wobei $R_{10}$ bis $R_{16}$ und $R_{20}$ jeweils unabhängig ausgewählt sind aus Wasserstoff, Deuterium, einer Cyanogruppe, einer $C_1$-$C_{20}$-Alkylgruppe, einer $C_1$-$C_{20}$-Alkoxygruppe, einer Phenylgruppe, einer Biphenylgruppe, einer Terphenylgruppe, einer Naphthylgruppe, einer Fluorenylgruppe, einer Dimethylfluorenylgruppe, einer Diphenylfluorenylgruppe, einer Carbazolylgruppe, einer Phenylcarbazolylgruppe, einer Biphenylcarbazolylgruppe, einer Dibenzofuranylgruppe und einer Dibenzothiophenylgruppe.

**7.** Organische lichtemittierende Vorrichtung nach einem der Ansprüche 1-6, wobei d1 1 ist.

**8.** Organische lichtemittierende Vorrichtung nach einem der Ansprüche 1-7, wobei

$A_1$ ausgewählt ist aus Gruppen dargestellt durch Formel 3-1 bis 3-14 und einer sulfonylhaltigen Gruppe:

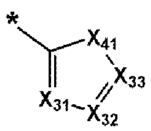

**Formel 3-1**

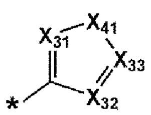

**Formel 3-2**

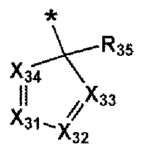

**Formel 3-3**

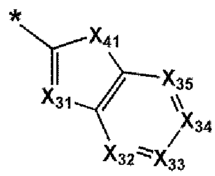

**Formel 3-4**

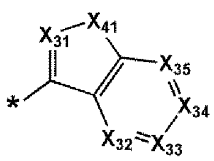

**Formel 3-5**

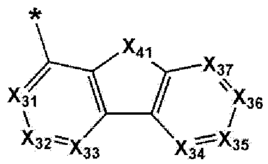

**Formel 3-6**

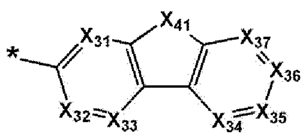

**Formel 3-7**

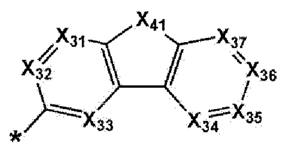

**Formel 3-8**

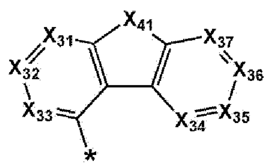

**Formel 3-9**

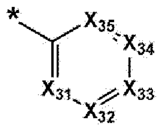

**Formel 3-10**

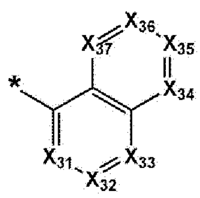

**Formel 3-11**

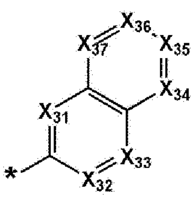

**Formel 3-12**

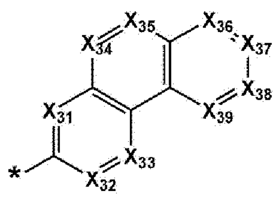

**Formel 3-13**

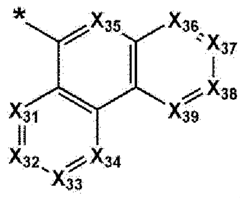

**Formel 3-14**

,

wobei in Formel 3-1 bis 3-14 $X_{31}$ N oder $C(R_{31})$ ist, $X_{32}$ N oder $C(R_{32})$ ist, $X_{33}$ N oder $C(R_{33})$ ist, $X_{34}$ N oder $C(R_{34})$ ist, $X_{35}$ N oder $C(R_{35})$ ist, $X_{36}$ N oder $C(R_{36})$ ist, $X_{37}$ N oder $C(R_{37})$ ist, $X_{38}$ N oder $C(R_{38})$ ist und $X_{39}$ N oder $C(R_{39})$ ist,

$X_{41}$ in Formel 3-1, 3-2 und 3-4 bis 3-9 $N(R_{41})$, $C(R_{42})(R_{43})$, O oder S ist,
zumindest eines von $X_{31}$ bis $X_{33}$ in Formel 3-1 und 3-2 N ist, zumindest eines von $X_{31}$ bis $X_{34}$ in Formel 3-3 N ist,
zumindest eines von $X_{31}$ bis $X_{35}$ in Formel 3-4, 3-5 und 3-10 N ist,
zumindest eines von $X_{31}$ bis $X_{37}$ in Formel 3-6 bis 3-9, 3-11 und 3-12 N ist und zumindest eines von $X_{31}$ bis $X_{39}$ in Formel 3-13 und 3-14 N ist,
$R_{31}$ bis $R_{39}$ und $R_{41}$ bis $R_{43}$ jeweils unabhängig ausgewählt sind aus Wasserstoff, Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe, einer Phenylgruppe, einer ($C_1$-$C_{20}$-Alkyl)phenylgruppe, einer di($C_1$-$C_{20}$-Alkyl)phenylgruppe, einer tri($C_1$-$C_{20}$-Alkyl)phenylgruppe, einer ($C_6$-$C_{20}$-Aryl) phenylgruppe, einer di($C_6$-$C_{20}$-Aryl)phenylgruppe, einer tri($C_6$-$C_{20}$-Aryl)phenylgruppe, einer ($C_3$-$C_{20}$-Heteroaryl)phenylgruppe, einer di($C_3$-$C_{20}$-Heteroaryl)phenylgruppe, einer Pyridinylgruppe, einer ($C_1$-$C_{20}$-Alkyl)pyridinylgruppe, einer di($C_1$-$C_{20}$-Alkyl)pyridinylgruppe, einer ($C_6$-$C_{20}$-Aryl)pyridinylgruppe, einer di($C_6$-$C_{20}$-Aryl)pyridinylgruppe, einer ($C_3$-$C_{20}$-Heteroaryl)pyridinylgruppe, einer di($C_3$-$C_{20}$-Heteroaryl)pyridinylgruppe, einer Pyrimidinylgruppe, einer ($C_1$-$C_{20}$-Alkyl)pyrimidinylgruppe, einer di($C_1$-$C_{20}$-Alkyl)pyrimidinylgruppe einer ($C_6$-$C_{20}$-Aryl)pyrimidinylgruppe, einer di($C_6$-$C_{20}$-Aryl)pyrimidinylgruppe, einer ($C_3$-$C_{20}$-Heteroaryl)pyrimidinylgruppe, einer di($C_3$-$C_{20}$-Heteroaryl)pyrimidinylgruppe, einer Triazinylgruppe, einer ($C_1$-$C_{20}$-Alkyl)triazinylgruppe, einer di($C_1$-$C_{20}$-Alkyl)triazinylgruppe, einer ($C_6$-$C_{20}$-Aryl)triazinylgruppe, einer di($C_6$-$C_{20}$-Aryl)triazinylgruppe, einer ($C_3$-$C_{20}$-Heteroaryl)triazinylgruppe und einer di($C_3$-$C_{20}$-Heteroaryl)triazinylgruppe, und
* eine Bindungsstelle zu einem benachbarten Atom angibt.

**9.** Organische lichtemittierende Vorrichtung nach einem der Ansprüche 1-7, wobei

$A_1$ ausgewählt ist aus Gruppen dargestellt durch Formel 3-4(1) bis 3-4(4), 3-5(1) bis 3-5(4), 3-6(1), 3-7(1), 3-8(1), 3-9(1), 3-10(1) bis 3-10(8), 3-11 (1) bis 3-11 (23) und 3-12(1) bis 3-12(24):

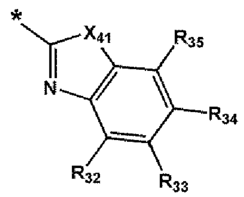
Formel 3-4(1)

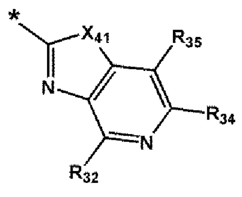
Formel 3-4(2)

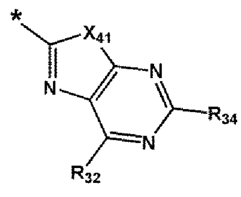
Formel 3-4(3)

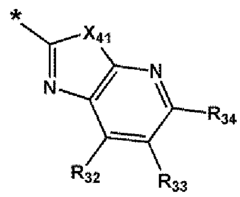
Formel 3-4(4)

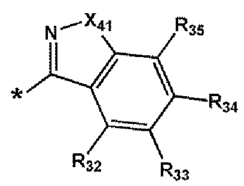
Formel 3-5(1)

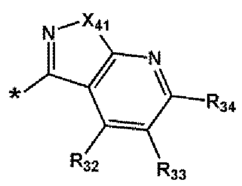
Formel 3-5(2)

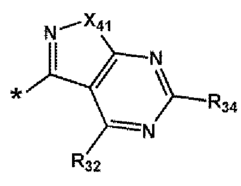
Formel 3-5(3)

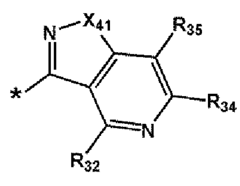
Formel 3-5(4)

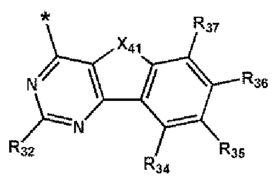
Formel 3-6(1)

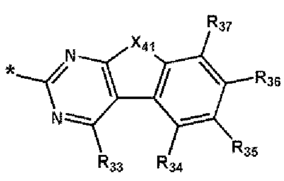
Formel 3-7(1)

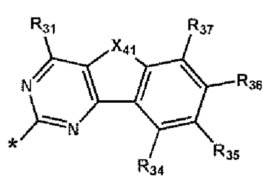
Formel 3-8(1)

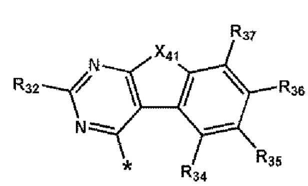
Formel 3-9(1)

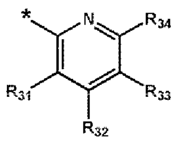
Formel 3-10(1)

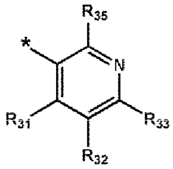
Formel 3-10(2)

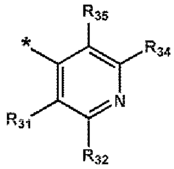
Formel 3-10(3)

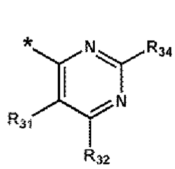
Formel 3-10(4)

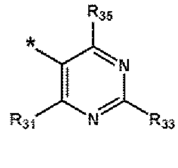
Formel 3-10(5)

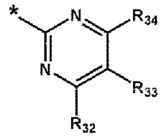
Formel 3-10(6)

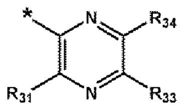
Formel 3-10(7)

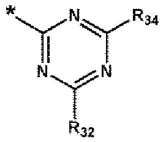
Formel 3-10(8)

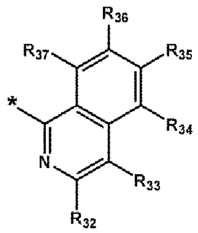
Formel 3-11(1)

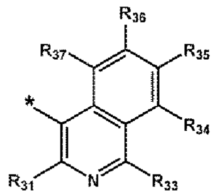
Formel 3-11(2)

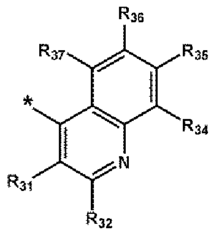
Formel 3-11(3)

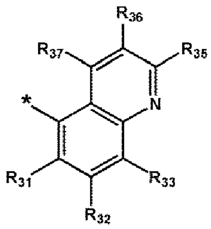
Formel 3-11(4)

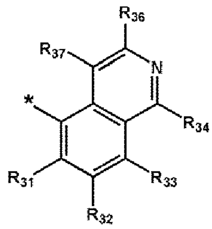
Formel 3-11(5)

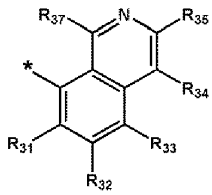
Formel 3-11(6)

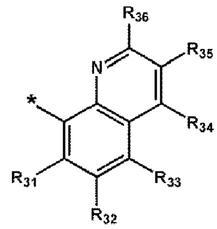
Formel 3-11(7)

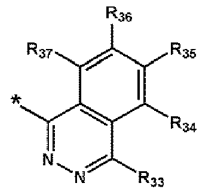
Formel 3-11(8)

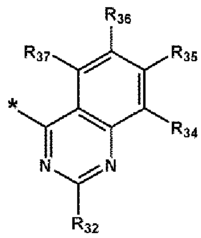
Formel 3-11(9)

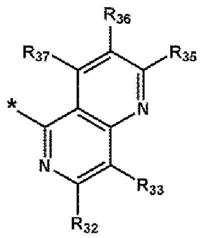
Formel 3-11(10)

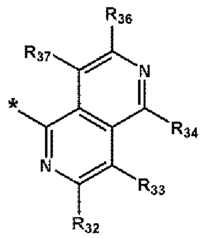
Formel 3-11(11)

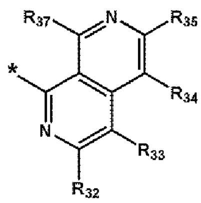
Formel 3-11(12)

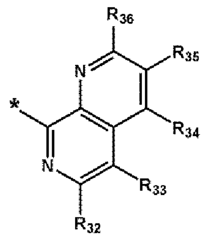
Formel 3-11(13)

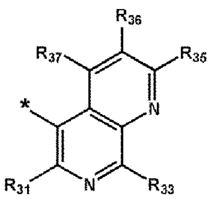
Formel 3-11(14)

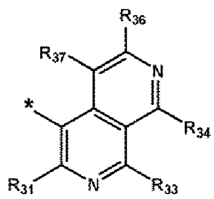
Formel 3-11(15)

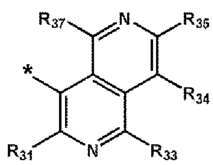
Formel 3-11(16)

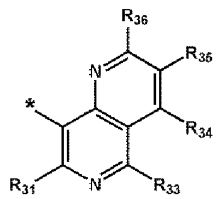
Formel 3-11(17)

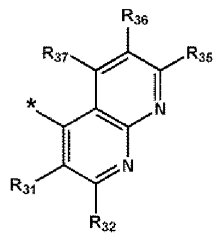
Formel 3-11(18)

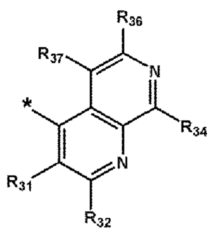
Formel 3-11(19)

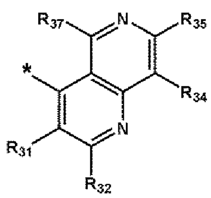
Formel 3-11(20)

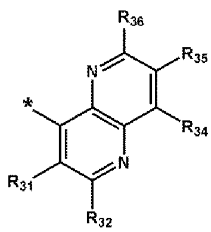
Formel 3-11(21)

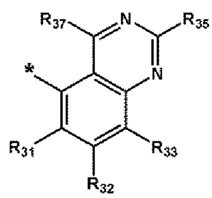
Formel 3-11(22)

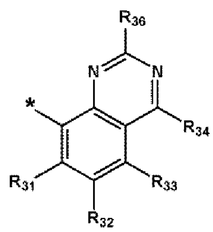
Formel 3-11(23)

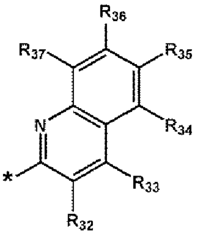
Formel 3-12(1)

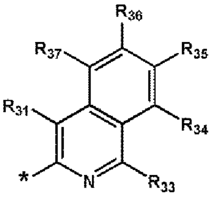
Formel 3-12(2)

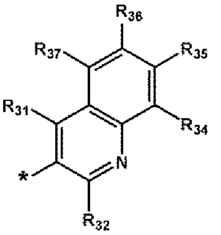
Formel 3-12(3)

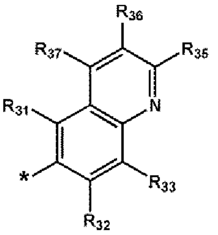
Formel 3-12(4)

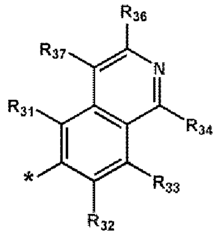
Formel 3-12(5)

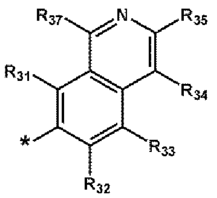
Formel 3-12(6)

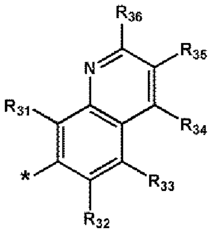
Formel 3-12(7)

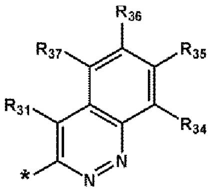
Formel 3-12(8)

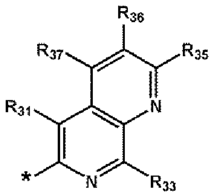
Formel 3-12(9)

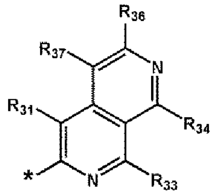
Formel 3-12(10)

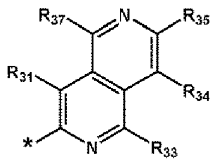
Formel 3-12(11)

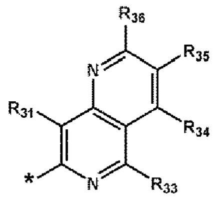
Formel 3-12(12)

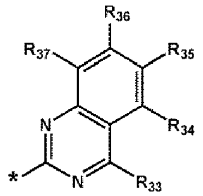
Formel 3-12(13)

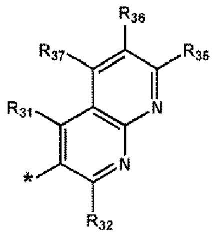
Formel 3-12(14)

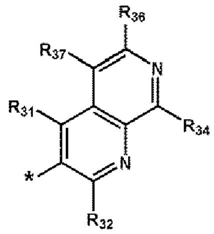
Formel 3-12(15)

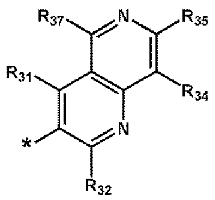
Formel 3-12(16)

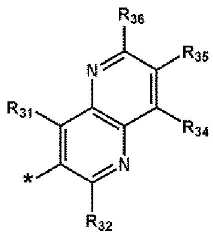
Formel 3-12(17)

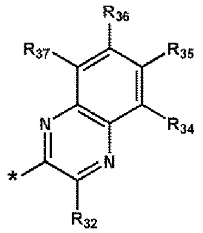
Formel 3-12(18)

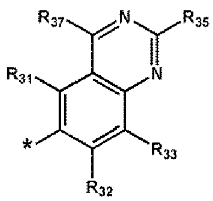
Formel 3-12(19)

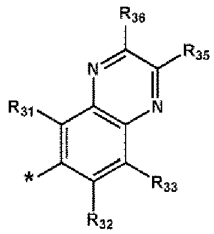
Formel 3-12(20)

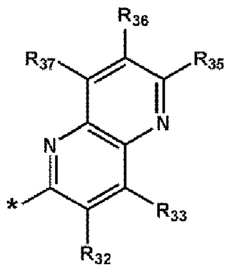
Formel 3-12(21)

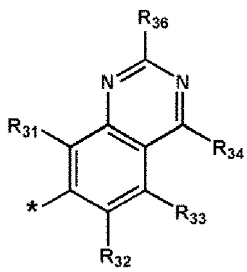
Formel 3-12(22)

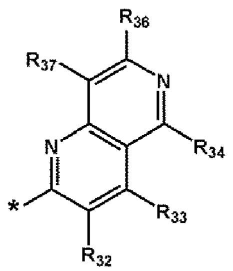
Formel 3-12(23)

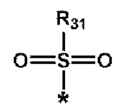
Formel 3-12(24),

wobei in Formel 3-4(1) bis 3-4(4), 3-5(1) bis 3-5(4), 3-6(1), 3-7(1), 3-8(1), 3-9(1), 3-10(1) bis 3-10(8), 3-11 (1) bis 3-11 (23) und 3-12(1) bis 3-12(24),

$X_{41}$ $N(R_{41})$, $C(R_{42})(R_{43})$ O oder S ist,

$R_{31}$ bis $R_{37}$ und $R_{41}$ bis $R_{43}$ jeweils unabhängig ausgewählt sind aus Wasserstoff, Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe

oder einem Salz davon, einer Sulfonsäuregruppe oder einem Salz davon, einer Phosphorsäuregruppe oder einem Salz davon, einer $C_1$-$C_{10}$-Alkylgruppe, einer $C_1$-$C_{10}$-Alkoxygruppe, einer Phenylgruppe, einer ($C_1$-$C_{10}$-Alkyl)phenylgruppe, einer di($C_1$-$C_{10}$-Alkyl)phenylgruppe, einer tri($C_1$-$C_{10}$-Alkyl)phenylgruppe, einer Biphenylgruppe, einer di(Phenyl)phenylgruppe, einer tri(Phenyl)phenylgruppe, einer (Pyridinyl)phenylgruppe, einer di(Pyridinyl)phenylgruppe, (Pyrimidinyl)phenylgruppe, einer di(Pyrimidinyl)phenylgruppe, einer (Triazinyl)phenylgruppe, einer di(Triazinyl)phenylgruppe, einer (Carbazolyl)phenylgruppe, einer Pyridinylgruppe, einer ($C_1$-$C_{10}$-Alkyl)pyridinylgruppe, einer di($C_1$-$C_{10}$-Alkyl)pyridinylgruppe, einer (Phenyl)pyridinylgruppe, einer di(Phenyl)pyridinylgruppe, einer (Pyridinyl)pyridinylgruppe, einer di(Pyridinyl)pyridinylgruppe, einer (Pyrimidinyl)pyridinylgruppe, einer di(Pyrimidinyl)pyridinylgruppe, einer (Triazinyl)pyridinylgruppe, einer di(Triazinyl)pyridinylgruppe, einer Triazinylgruppe, einer ($C_1$-$C_{10}$-Alkyl)triazinylgruppe, einer di($C_1$-$C_{10}$-Alkyl)triazinylgruppe, einer (Phenyl)triazinylgruppe, einer di(Phenyl)triazinylgruppe, (Pyridinyl)triazinylgruppe, einer di(Pyridinyl)triazinylgruppe, einer (Pyrimidinyl)triazinylgruppe, einer di(Pyrimidinyl)triazinylgruppe, einer (Triazinyl)triazinylgruppe und einer di(Triazinyl)triazinylgruppe, und
* eine Bindungsstelle zu einem benachbarten Atom angibt;
wobei bevorzugt
$A_1$ ausgewählt ist aus Formel 3-6(1), 3-10(4), 3-10(8) und 3-12(24).

**10.** Organische lichtemittierende Vorrichtung nach einem der Ansprüche 1-7, wobei

$A_1$ eine triazinhaltige Gruppe oder eine sulfonylhaltige Gruppe ist; und/oder wobei
$R_1$ ausgewählt ist aus Wasserstoff, Deuterium, einer Cyanogruppe, einer $C_1$-$C_{20}$-Alkylgruppe, einer $C_1$-$C_{20}$-Alkoxygruppe, einer Phenylgruppe, einer Biphenylgruppe, einer Terphenylgruppe, einer Naphthylgruppe, einer Fluorenylgruppe, einer Dimethylfluorenylgruppe, einer Diphenylfluorenylgruppe, einer Carbazolylgruppe, einer Phenylcarbazolylgruppe, einer Biphenylcarbazolylgruppe, einer Dibenzofuranylgruppe und einer Dibenzothiophenylgruppe.

**11.** Organische lichtemittierende Vorrichtung nach einem der Ansprüche 1-10, wobei

der TADF-Emitter ausgewählt ist aus Verbindung 1 bis 11:

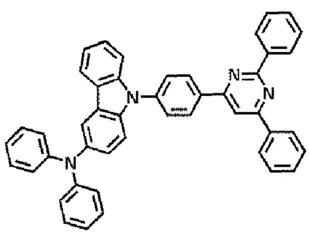
1

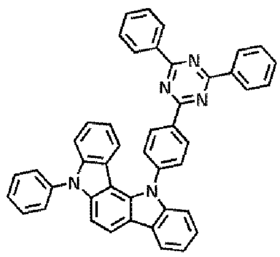
2

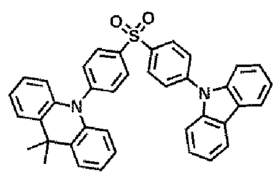
3

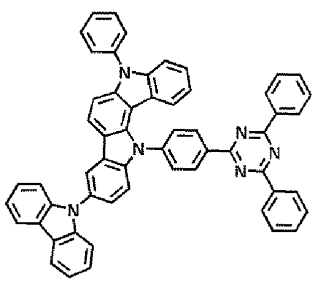
4

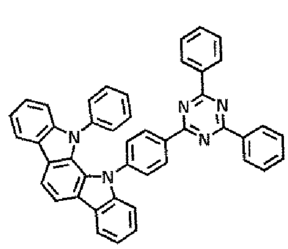
5

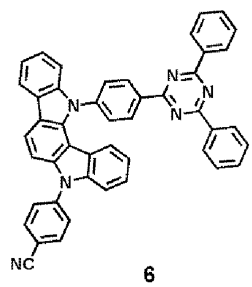
6

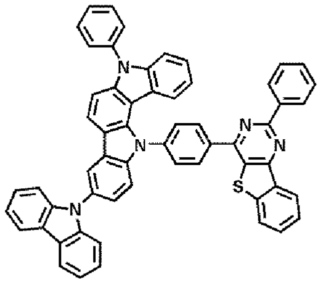

7

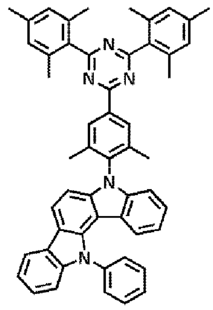

8

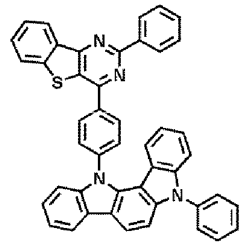

9

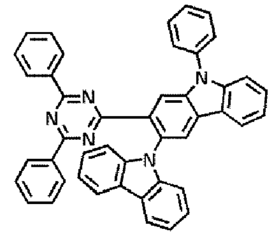

10

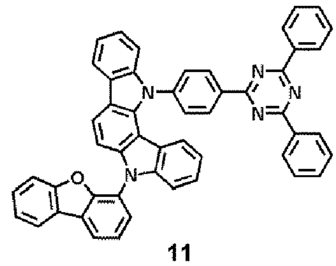

11

; und/oder

wobei

der Wirt zumindest eine Verbindung ausgewählt aus einer fluorenhaltigen Verbindung, einer carbazolhaltigen Verbindung, einer dibenzofuranhaltigen Verbindung, einer dibenzothiophenhaltigen Verbindung, einer indenocarbazolhaltigen Verbindung, einer indolocarbazolhaltigen Verbindung, einer benzofurocarbazolhaltigen Verbindung, einer benzothienocarbazolhaltigen Verbindung, einer acridinhaltigen Verbindung, einer dihydroacridinhaltigen Verbindung, einer triindolobenzolhaltigen Verbindung, einer pyridinhaltigen Verbindung, einer pyrimidinhaltigen Verbindung, einer triazinhaltigen Verbindung, einer siliziumhaltigen Verbindung, einer cyanogruppenhaltigen Verbindung, einer phosphinoxidhaltigen Verbindung, einer sulfoxidhaltigen Verbindung und einer sulphonylhaltigen Verbindung umfasst.

**12.** Organische lichtemittierende Vorrichtung nach einem der Ansprüche 1-11, wobei

der Wirt eine Verbindung, die zumindest einen Carbazolring und zumindest eine Cyanogruppe umfasst, oder eine phosphinoxidhaltige Verbindung ist; oder

wobei

der Wirt zumindest eine Verbindung ausgewählt aus Verbindung H1 bis H22 und Verbindung H24 umfasst:

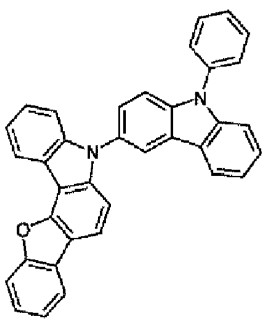

H1

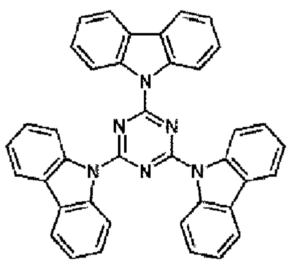

H2

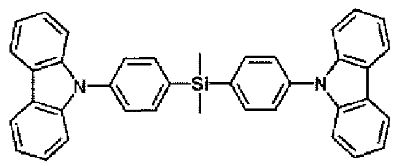

H3

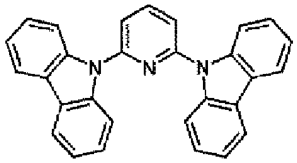
H4

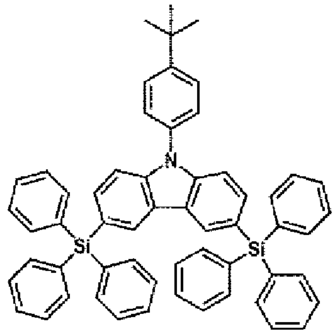
H5

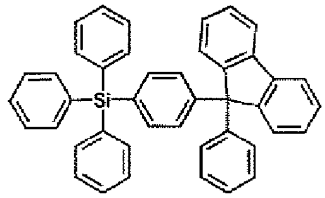
H6

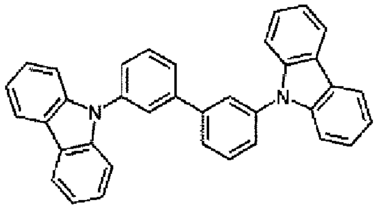
H7

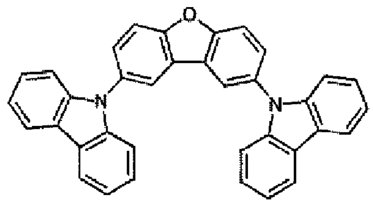
H8

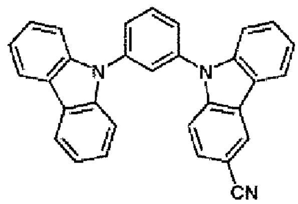
H9

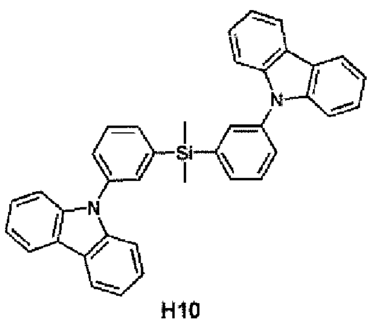
H10

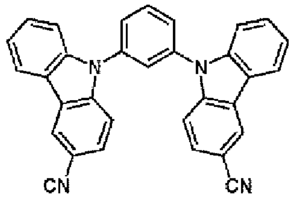
H11

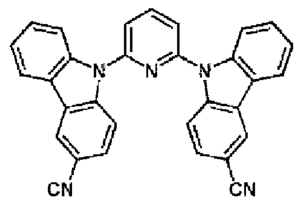
H12

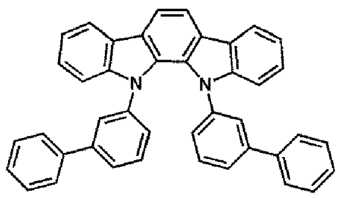
H13

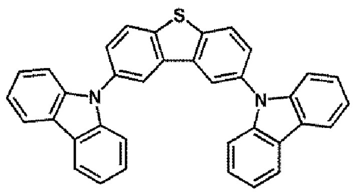
H14

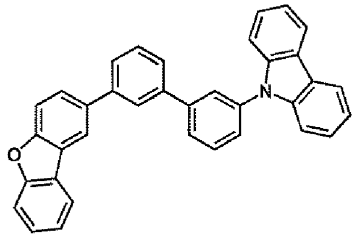
H15

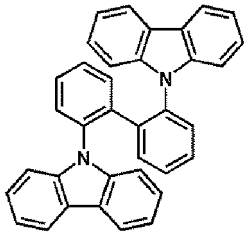
H16

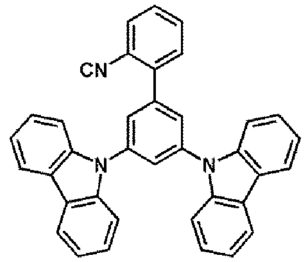
H17

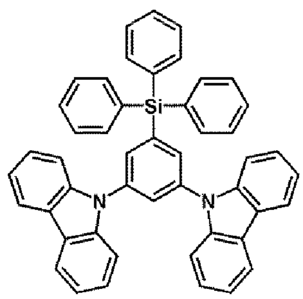
H18

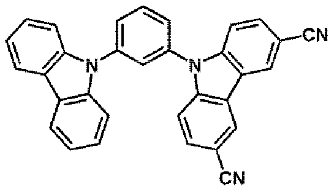

H19

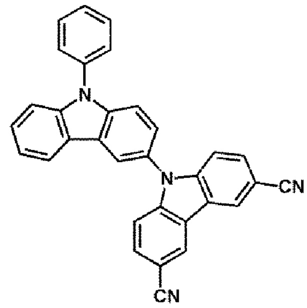

H20

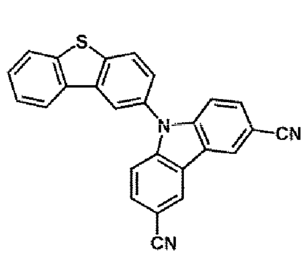

H21

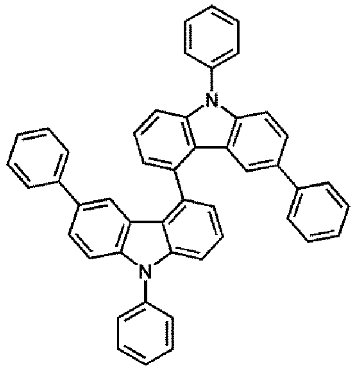

H22

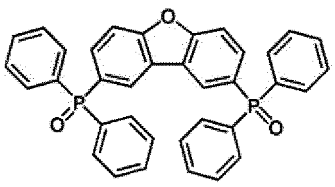

H24

**13.** Organische lichtemittierende Vorrichtung nach einem der Ansprüche 1-12, wobei ein Verhältnis einer verzögerten Fluoreszenzkomponente, die von dem TADF-Emitter emittiert wird, in Bezug auf eine Gesamtemissionskomponente der Emissionsschicht 30 % oder mehr ist.

**14.** Organische lichtemittierende Vorrichtung nach einem der Ansprüche 1-13, wobei

eine Menge des TADF-Emitters kleiner als eine Menge des Wirts ist; und/oder wobei
eine Menge des TADF-Emitters in der Emissionsschicht innerhalb eines Bereichs von 0,01 Gewichtsteilen bis 20 Gewichtsteilen basierend auf 100 Gewichtsteilen der Emissionsschicht ausgewählt ist.

## Revendications

**1.** Dispositif électroluminescent organique, comprenant :

une première électrode (11) ;
une seconde électrode (19) faisant face à la première électrode ; et
une couche organique (15) qui est disposée entre la première électrode et la seconde électrode, la couche organique comprenant une couche d'émission,
ladite couche d'émission comprenant un émetteur à fluorescence retardée activée thermiquement (TADF) et un hôte, l'émetteur TADF étant différent de l'hôte, l'hôte ne comprenant pas de DPEPO, et l'émetteur TADF étant un composé représenté par la formule 1,
l'émetteur TADF satisfaisant à la condition 1-1 ou à la condition 1-2 :

Condition 1-1
une condition selon laquelle n1 est égal à un, et
Condition 1-2
une condition selon laquelle, lorsque n1 est égal à deux ou plus, $(I_1 / I_2) \times 100(\%)$ est inférieur à 110 %, dans la condition 1-1 et la condition 1-2,
$I_1$ (unités arbitraires) étant l'intensité d'émission à la longueur d'onde d'émission maximale la plus courte dans un spectre de photoluminescence 1,

1) lorsque n2 est égal à un, $I_2$ (unités arbitraires) étant l'intensité d'émission à la même longueur d'onde d'émission que la longueur d'onde d'émission maximale la plus courte du spectre de photoluminescence 1 dans le spectre de photoluminescence 2, et 2) lorsque n2 est égal à deux ou plus, $I_2$ (unités arbitraires) étant l'intensité d'émission à la longueur d'onde d'émission maximale la plus courte dans un spectre de photoluminescence 2,

le spectre de photoluminescence 1 étant un spectre de photoluminescence d'un film 1 qui est dopé à 15 pour cent en volume de l'émetteur TADF dans une matrice avec l'hôte compris dans la couche d'émission et qui comporte une épaisseur de 50 nanomètres, et

le spectre de photoluminescence 2 étant un spectre de photoluminescence d'un film 2 qui est dopé à 15 pour cent en volume de l'émetteur TADF dans une matrice avec du DPEPO et qui comporte une épaisseur de 50 nanomètres :

DPEPO

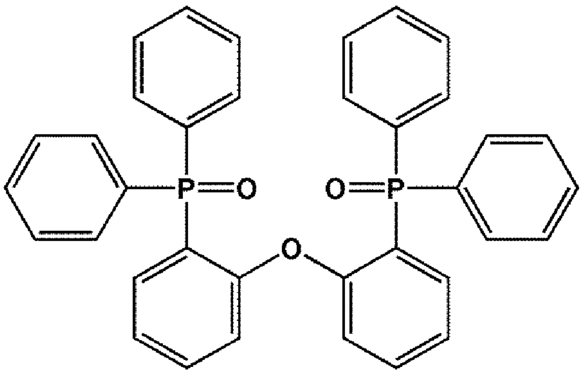

,

où n1 est le nombre de pics d'émission distinguables dans le spectre de photoluminescence 1, et n2 est le nombre de pics d'émission distinguables dans le spectre de photoluminescence 2,

Formule 1 $R_1$-$(D_2)_{d1}$-$D_1$-$(L_1)_{a1}$-$A_1$,

dans la Formule 1,

$L_1$ étant choisi parmi :

une liaison simple, un groupe cyclopentane, un groupe cyclohexane, un groupe cycloheptane, un groupe cyclo-octane, un groupe cyclopenpentène, un groupe cyclohexène, un groupe cycloheptène, un groupe benzène, un groupe naphtalène, un groupe fluorène, un groupe phénanthrène, un groupe anthracène, un groupe fluoranthène, un groupe triphénylène, un groupe pyrène, un groupe chrysène, un groupe pyrrole, un groupe thiophène, un groupe furane, un groupe imidazole, un groupe pyrazole, un groupe thiazole, un groupe isothiazole, un groupe oxazole, un groupe isoxazole, un groupe pyridine, un groupe pyrazine, un groupe pyrimidine, un groupe pyradizine, un groupe iso-indole, un groupe indole, un groupe indazole, un groupe purine, un groupe quinoléine, un groupe isoquinoléine, un groupe benzoquinoléine, un groupe quinoxaline, un groupe quinazoline, un groupe cinnoléine, un groupe phénanthroline, un groupe benzimidazole, un groupe benzofurane, un groupe benzothiophène, un groupe benzoxazole, un groupe isobenzoxazole, un groupe triazole, un groupe tétrazole, un groupe oxadiazole, un groupe triazine, un groupe dibenzofurane, un groupe dibenzothiophène, un groupe benzocarbazole, un groupe dibenzocarbazole, un groupe imidazopyridine, un groupe imidazopyrimidine, un groupe aza-indole, un groupe aza-indène, un groupe azabenzofurane, un groupe azabenzothiophène, un groupe azacarbazole, un groupe azafluorène, un groupe azadibenzofurane et un groupe azadibenzothiophène ; et

un groupe cyclopentane, un groupe cyclohexane, un groupe cycloheptane, un groupe cyclo-octane, un groupe cyclopenpentène, un groupe cyclohexène, un groupe cycloheptène, un groupe benzène, un groupe naphtalène, un groupe fluorène, un groupe phénanthrène, un groupe anthracène, un groupe fluoranthène, un groupe triphénylène, un groupe pyrène, un groupe chrysène, un groupe pyrrole, un groupe thiophène, un groupe furane, un groupe imidazole, un groupe pyrazole, un groupe thiazole, un groupe isothiazole, un groupe oxazole, un groupe isoxazole, un groupe pyridine, un groupe pyrazine, un

groupe pyrimidine, un groupe pyradizine, un groupe iso-indole, un groupe indole, un groupe indazole, un groupe purine, un groupe quinoléine, un groupe isoquinoléine, un groupe benzoquinoléine, un groupe quinoxaline, un groupe quinazoline, un groupe cinnoline, un groupe phénanthroline, un groupe benzimidazole, un groupe benzofurane, un groupe benzothiophène, un groupe benzoxazole, un groupe isobenzoxazole, un groupe triazole, un groupe tétrazole, un groupe oxadiazole, un groupe triazine, un groupe dibenzofurane, un groupe dibenzothiophène, un groupe benzocarbazole, un groupe dibenzocarbazole, un groupe imidazopyridine, un groupe imidazopyrimidine, un groupe aza-indole, un groupe aza-indène, un groupe azabenzofurane, un groupe azabenzothiophène, un groupe azacarbazole, un groupe azafluorène, un groupe azadibenzofurane et un groupe azadibenzothiophène, chacun substitué par au moins un élément choisi parmi le deutérium, -F, - Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{20}$, un groupe alcoxy en $C_1$-$C_{20}$, un groupe phényle, un groupe (alkyle en $C_1$-$C_{20}$)phényle, un groupe di(alkyle en $C_1$-$C_{20}$)phényle, un groupe tri(alkyle en $C_1$-$C_{20}$)phényle, un groupe (aryle en $C_6$-$C_{20}$)phényle, un groupe di(aryle en $C_6$-$C_{20}$)phényle, un groupe tri(aryle en $C_6$-$C_{20}$)phényle, un groupe (hétéroaryle en $C_3$-$C_{20}$)phényle, un groupe di(hétéroaryle en $C_3$-$C_{20}$)phényle, un groupe pyridinyle, un groupe (alkyle en $C_1$-$C_{20}$)pyridinyle, un groupe di(alkyle en $C_1$-$C_{20}$)pyridinyle, un groupe (aryle en $C_6$-$C_{20}$)pyridinyle, un groupe di(aryle en $C_6$-$C_{20}$)pyridinyle, un groupe (hétéroaryle en $C_3$-$C_{20}$) pyridinyle, un groupe di(hétéroaryle en $C_3$-$C_{20}$)pyridinyle, un groupe pyrimidinyle, un groupe (alkyle en $C_1$-$C_{20}$)pyrimidinyle, un groupe di(alkyle en $C_1$-$C_{20}$)pyrimidinyle, un groupe (aryle en $C_6$-$C_{20}$)pyrimidinyle, un groupe di(aryle $C_6$-$C_{20}$)pyrimidinyle, un groupe (hétéroaryle en $C_3$-$C_{20}$)pyrimidinyle, un groupe di(hétéroaryle en $C_3$-$C_{20}$)pyrimidinyle, un groupe triazinyle, un groupe (alkyle en $C_1$-$C_{20}$) triazinyle, un groupe di(alkyle en $C_1$-$C_{20}$)triazinyle, un groupe (aryle en $C_6$-$C_{20}$)triazinyle, un groupe di(aryle en $C_6$-$C_{20}$)triazinyle, un groupe (hétéroaryle en $C_3$-$C_{20}$)triazinyle et un groupe di(hétéroaryle en $C_3$-$C_{20}$)triazinyle,

a1 étant un nombre entier de 1 à 5,

$D_1$ et $D_2$ étant chacun un groupe donneur d'électrons,

d1 étant un nombre entier de 0 à 5,

$A_1$ étant choisi parmi un groupe hétérocyclique en $C_2$-$C_{60}$ contenant de l'azote appauvri en électrons $\pi$ substitué ou non substitué et un groupe contenant un sulfonyle, et

$R_1$ étant choisi parmi :

l'hydrogène, le deutérium, un groupe alkyle en $C_1$-$C_{60}$, un groupe alcényle en $C_2$-$C_{60}$, un groupe alcynyle en $C_2$-$C_{60}$, un groupe alcoxy en $C_1$-$C_{60}$, un groupe carbocyclique en $C_5$-$C_{60}$ et un groupe hétérocyclique en $C_2$-$C_{60}$ dépourvu d'azote et appauvri en électrons $\pi$ ; et

un groupe alkyle en $C_1$-$C_{60}$, un groupe alcényle en $C_2$-$C_{60}$, un groupe alcynyle en $C_2$-$C_{60}$, un groupe alcoxy en $C_1$-$C_{60}$, un groupe carbocyclique en $C_5$-$C_{60}$ et un groupe hétérocyclique en $C_2$-$C_{60}$ dépourvu d'azote et appauvri en électrons $\pi$, chacun substitué par au moins un élément choisi parmi le deutérium, un groupe alkyle en $C_1$-$C_{60}$, un groupe alcényle en $C_2$-$C_{60}$, un groupe alcynyle en $C_2$-$C_{60}$, un groupe alcoxy en $C_1$-$C_{60}$, un groupe carbocyclique en $C_5$-$C_{60}$, un groupe carbocyclique (alkyle en $C_1$-$C_{10}$) en $C_5$-$C_{60}$, un groupe carbocyclique di(alkyle en $C_1$-$C_{10}$) en $C_5$-$C_{60}$, un groupe carbocyclique (phényl)$C_5$-$C_{60}$, un groupe carbocyclique di(phényl) en $C_5$-$C_{60}$, un groupe carbocyclique (biphényl) en $C_5$-$C_{60}$, un groupe carbocyclique di(biphényl)$C_5$-$C_{60}$, un groupe hétérocyclique en $C_2$-$C_{60}$ dépourvu d'azote et appauvri en électrons $\pi$, un groupe hétérocyclique en $C_2$-$C_{60}$ dépourvu d'azote et appauvri en électrons $\pi$ (alkyle en $C_1$-$C_{10}$), un groupe hétérocyclique en $C_2$-$C_{60}$ dépourvu d'azote et appauvri en électrons $\pi$ di(alkyle en $C_1$-$C_{10}$), un groupe hétérocyclique en $C_2$-$C_{60}$ dépourvu d'azote et appauvri en électrons $\pi$ (phényle), un groupe hétérocyclique en $C_2$-$C_{60}$ dépourvu d'azote et appauvri en électrons $\pi$ di(phényle), un groupe hétérocyclique en $C_2$-$C_{60}$ dépourvu d'azote et appauvri en électrons $\pi$ (biphényle) et un groupe hétérocyclique en $C_2$-$C_{60}$ dépourvu d'azote et appauvri en électrons $\pi$ di(biphényle),

à condition que,

i) d1 soit un nombre entier allant de 1 à 5 ;

ii) lorsque d1 est nul, $A_1$ soit choisi parmi les groupes représentés par les formules 3-6(1), 3-10(8) et 3-12(24) :

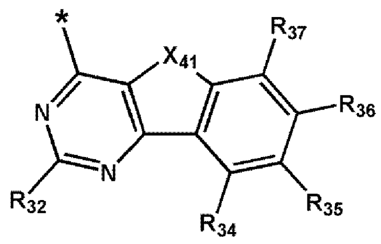

Formule 3-6(1)

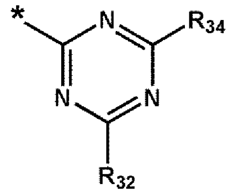

Formule 3-10(8)

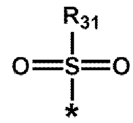

Formule 3-12(24)

dans les formules 3-6(1), 3-10(8) et 3-12(24),
$X_{41}$ étant $N(R_{41})$, $C(R_{42})(R_{43})$, O ou S,
$R_{31}$, $R_{32}$, $R_{34}$ to $R_{37}$ et $R_{41}$ à $R_{43}$ étant chacun indépendamment choisis parmi l'hydrogène, le deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{20}$, un groupe alcoxy en $C_1$-$C_{20}$, un groupe phényle, un groupe (alkyle en $C_1$-$C_{20}$)phényle, un groupe di(alkyle en $C_1$-$C_{20}$)phényle, un groupe tri(alkyle en $C_1$-$C_{20}$)phényle, un groupe (aryle en $C_6$-$C_{20}$)phényle, un groupe di(aryle en $C_6$-$C_{20}$)phényle, un groupe tri(aryle en $C_6$-$C_{20}$)phényle, un groupe (hétéroaryle en $C_3$-$C_{20}$) phényle, un groupe di(hétéroaryle en $C_3$-$C_{20}$)phényle, un groupe pyridinyle, un groupe (alkyle en $C_1$-$C_{20}$)pyridinyle, un groupe di(alkyle en $C_1$-$C_{20}$)pyridinyle, un groupe (aryle en $C_6$-$C_{20}$)pyridinyle, un groupe di(aryle en $C_6$-$C_{20}$)pyridinyle, un groupe (hétéroaryle en $C_3$-$C_{20}$)pyridinyle, un groupe di(hétéroaryle en $C_3$-$C_{20}$)pyridinyle, un groupe pyrimidinyle, un groupe (alkyle en $C_1$-$C_{20}$)pyrimidinyle, un groupe di(alkyle en $C_1$-$C_{20}$)pyrimidinyle, un groupe (aryle en $C_6$-$C_{20}$)pyrimidinyle, un groupe di(aryle en $C_6$-$C_{20}$)pyrimidinyle, un groupe (hétéroaryle en $C_3$-$C_{20}$)pyrimidinyle, un groupe di(hétéroaryle en $C_3$-$C_{20}$)pyrimidinyle, un groupe triazinyle, un groupe (alkyle en $C_1$-$C_{20}$)triazinyle, un groupe di(alkyle en $C_1$-$C_{20}$)triazinyle, un groupe (aryle en $C_6$-$C_{20}$)triazinyle, un groupe di(aryle en $C_6$-$C_{20}$) triazinyle, un groupe (hétéroaryle en $C_3$-$C_{20}$)triazinyle et un groupe di(hétéroaryle en $C_3$-$C_{20}$)triazinyle, et
* indiquant un site de liaison à un atome voisin.

**2.** Dispositif électroluminescent organique selon la revendication 1,
ledit émetteur TADF satisfaisant à la condition 2-1, en supposant que le rotamère (0°) soit une structure moléculaire que l'émetteur TADF comporte dans un état moléculaire isolé en phase gazeuse, une constante $\alpha$ étant un angle entre un premier plan comprenant $D_1$ et un second plan comprenant $A_1$ dans le rotamère (0°), le rotamère (10x°) étant une structure moléculaire que l'émetteur TADF comporte dans un état dans lequel l'angle entre le premier plan et le second plan est changé en $\alpha$ + 10x°, et x étant un entier satisfaisant à $-18 \leq x \leq 18$ :

Condition 2-1
une condition selon laquelle les densités de chevauchement d'attachement-détachement du rotamère (10x°) sont toutes inférieures à 0,65, et la densité de chevauchement d'attachement-détachement est évaluée en utilisant les méthodes DFT et TD-DFT dans lesquelles la structure moléculaire de l'émetteur TADF est optimisée à un niveau CAM-B3LYP/6-31G(d,p).

**3.** Dispositif électroluminescent organique selon la revendication 1,
ledit émetteur TADF satisfaisant à la condition 2-2, en supposant que le rotamère (0°) soit une structure moléculaire que l'émetteur TADF comporte dans un état moléculaire isolé en phase gazeuse, une constante $\alpha$ étant un angle entre un premier plan comprenant $D_1$ et un second plan comprenant $A_1$ dans le rotamère (0°), le rotamère (10x°) étant une structure moléculaire que l'émetteur TADF comporte dans un état dans lequel l'angle entre le premier plan et le second plan est changé en $\alpha$ + 10x°, et x étant un entier satisfaisant à $-18 \leq x \leq 18$ :

Condition 2-2
une condition selon laquelle au moins un 10x, dont la densité de chevauchement d'attachement-détachement du rotamère (10x°) est de 0,65 ou plus, est présent, et un rotamère (10x°) pour toutes les valeurs 10x, dont la densité

de chevauchement d'attachement-détachement du rotamère (10x°) est de 0,65 ou plus, comporte i) une énergie conformationnelle rotationnelle de 0,15 électronvolt ou plus, ii) un CTosc supérieur à un LEosc ou iii) une énergie conformationnelle rotationnelle de 0,15 électronvolt ou plus et un CTosc supérieur à un LEosc, et la densité de chevauchement d'attachement-détachement, l'énergie conformationnelle rotationnelle, le CTosc et le LEosc sont évalués en utilisant des méthodes DFT et TD-DFT dans lesquelles la structure moléculaire de l'émetteur TADF est optimisée à un niveau CAM-B3LYP/6-31G(d,p),
dans la condition 2-2, LEosc étant une intensité d'oscillateur dans un état localement excité du rotamère (10x°) correspondant, et CTosc étant une intensité d'oscillateur dans un état de transfert de charge du rotamère (10x°) correspondant.

**4.** Dispositif électroluminescent organique selon l'une quelconque des revendications 1 à 3,
$L_1$ étant choisi parmi :

une liaison simple, un groupe benzène, un groupe naphtalène, un groupe fluorène, un groupe pyridine, un groupe pyrazine, un groupe pyrimidine, un groupe pyradizine, un groupe quinoléine, un groupe isoquinoléine, un groupe benzoquinoléine, un groupe quinoxaline, un groupe quinazoline et un groupe triazine ; et
un groupe benzène, un groupe naphtalène, un groupe fluorène, un groupe pyridine, un groupe pyrazine, un groupe pyrimidine, un groupe pyradizine, un groupe quinoléine, un groupe isoquinoléine, un groupe benzoquinoléine, un groupe quinoxaline, un groupe quinazoline et un groupe triazine, chacun substitués par au moins un élément choisi parmi le deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{20}$, un groupe alcoxy en $C_1$-$C_{20}$, un groupe phényle, un groupe (alkyle en $C_1$-$C_{20}$)phényle, un groupe di(alkyle en $C_1$-$C_{20}$)phényle, un groupe (aryle en $C_6$-$C_{20}$)phényle, un groupe di(aryle en $C_6$-$C_{20}$)phényle, un groupe (hétéroaryle en $C_3$-$C_{20}$)phényle, un groupe di(hétéroaryle en $C_3$-$C_{20}$)phényle, un groupe pyridinyle, un groupe (alkyle en $C_1$-$C_{20}$)pyridinyle, un groupe di(alkyle en $C_1$-$C_{20}$)pyridinyle, un groupe (aryle en $C_6$-$C_{20}$)pyridinyle, un groupe di(aryle en $C_6$-$C_{20}$)pyridinyle, un groupe (hétéroaryle en $C_3$-$C_{20}$)pyridinyle, un groupe di(hétéroaryle en $C_3$-$C_{20}$)pyridinyle, un groupe pyrimidinyle, un groupe (alkyle en $C_1$-$C_{20}$)pyrimidinyle, un groupe di(alkyle en $C_1$-$C_{20}$)pyrimidinyle, un groupe (aryle en $C_6$-$C_{20}$)pyrimidinyle, un groupe di(aryle en $C_6$-$C_{20}$)pyrimidinyle, un groupe (hétéroaryle en $C_3$-$C_{20}$)pyrimidinyle, un groupe di(hétéroaryle en $C_3$-$C_{20}$)pyrimidinyle, un groupe triazinyle, un groupe (alkyle en $C_1$-$C_{20}$)triazinyle, un groupe di(alkyle en $C_1$-$C_{20}$)triazinyle, un groupe (aryle en $C_6$-$C_{20}$)triazinyle, un groupe di(aryle en $C_6$-$C_{20}$) triazinyle, un groupe (hétéroaryle en $C_3$-$C_{20}$)triazinyle et un groupe di(hétéroaryle en $C_3$-$C_{20}$)triazinyle, et
a1 valant 1 ou 2.

**5.** Dispositif électroluminescent organique selon l'une quelconque des revendications 1 à 4, $D_1$ et $D_2$ étant chacun indépendamment choisis parmi les groupes représentés par les formules 11-1 à 11-4 :

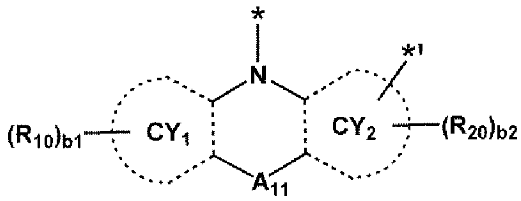

**Formule 11-1**

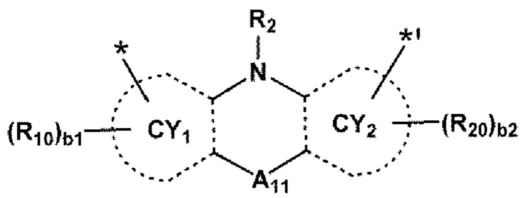

**Formule 11-2**

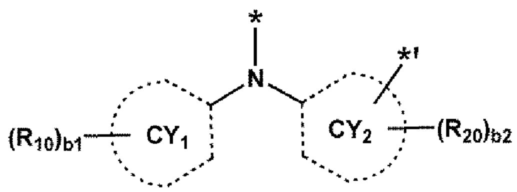

**Formule 11-3**

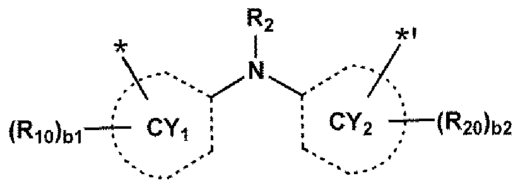

**Formule 11-4**

dans les formules 11-1 à 11-4,

$CY_1$ et $CY_2$ étant chacun indépendamment un groupe carbocyclique en $C_5$-$C_{60}$ ou un groupe hétérocyclique en $C_2$-$C_{60}$,
$A_{11}$ étant choisi parmi :

une liaison simple, un groupe alkylène en $C_1$-$C_4$ et un groupe alcénylène en $C_2$-$C_4$ ; et
un groupe alkylène en $C_1$-$C_4$ et un groupe alcénylène en $C_2$-$C_4$, chacun substitués par au moins un élément choisi parmi le deutérium, un groupe cyano, un groupe alkyle en $C_1$-$C_{60}$, un groupe alcoxy en $C_1$-$C_{60}$, un groupe phényle, un groupe fluorényle, un groupe carbazolyle, un groupe dibenzofuranyle et un groupe dibenzothiophényle,
$R_2$, $R_{10}$ et $R_{20}$ étant chacun indépendamment choisis parmi :

l'hydrogène, le deutérium, un groupe alkyle en $C_1$-$C_{20}$, un groupe alcoxy en $C_1$-$C_{20}$, un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe heptalényle, un groupe indacényle, un groupe acénaphtyle, un groupe fluorényle, un groupe spiro-bifluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphthacényle, un groupe picényle, un pérylényle groupe, un groupe pentaphényle, un groupe hexacényle, un groupe pentacényle, un groupe rubicényle, un groupe coronényle, un groupe ovalenyle, un groupe pyrrolyle, un groupe furanyle, un groupe thiophényle, un groupe indolyle, un groupe benzofuranyle, un groupe benzothiophényle, un groupe carbazolyle, un groupe dibenzofuranyle, un groupe dibenzothiophényle, un groupe benzocarbazolyle, un groupe naphtobenzofuranyle, un groupe naphtobenzothiophényle, un groupe dibenzocarbazolyle, un groupe dinaphtofuranyle, un groupe dinaphtothiophényle, un groupe indolocarbazolyle, un groupe indolodibenzofuranyle et un groupe indolodibenzothiophényle ; et
un groupe alkyle en $C_1$-$C_{20}$, un groupe alcoxy en $C_1$-$C_{20}$, un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe heptalényle, un groupe indacényle, un groupe acénaphtyle, un groupe fluorényle, un groupe spiro-bifluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphthacényle, un groupe picényle, un groupe pérylényle, un pentaphényle groupe, un groupe hexacényle, un groupe pentacényle, un groupe rubicényle, un groupe coronényle, un groupe ovalenyle, un groupe pyrrolyle, un groupe furanyle, un groupe thiophényle, un groupe indolyle, un groupe benzofuranyle, un groupe benzothiophényle, un groupe carbazolyle, un groupe dibenzofuranyle, un groupe dibenzothiophényle, un groupe benzocarbazolyle, un groupe naphtobenzofuranyle, un groupe naphtobenzothiophényle, un groupe dibenzocarbazolyle, un groupe dinaphtofuranyle, un groupe dinaphtothiophényle, un groupe indolocarbazolyle, un groupe indolodibenzofuranyle et un groupe indolodibenzothiophényle, chacun substitué par au moins un élément choisi parmi le deutérium, un groupe alkyle en $C_1$-$C_{20}$, un groupe alcoxy en $C_1$-$C_{20}$, un groupe phényle, un groupe biphényle, un groupe terphényle, un groupe naphtyle, un groupe fluorényle, un groupe diméthylfluorényle, un groupe diphénylfluorényle, un groupe carbazolyle, un groupe phénylcarbazolyle, un groupe biphénylcarbazolyle, un groupe dibenzofuranyle et un groupe dibenzothiophényle,
b1 et b2 étant chacun indépendamment un nombre entier de 0 à 3, et
* et *' indiquant chacun un site de liaison à un atome voisin ;
de préférence
$D_1$ et $D_2$ étant chacun indépendamment choisis parmi les groupes représentés par les formules 11(1) à 11(19) :

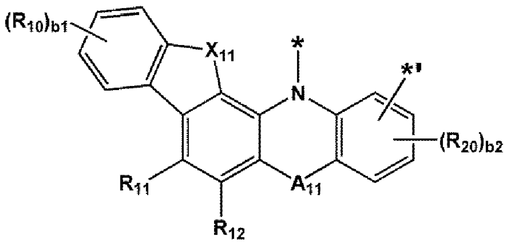

Formule 11(1)

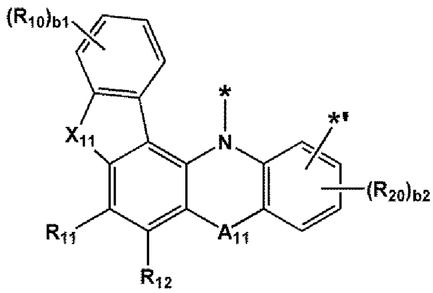

Formule 11(2)

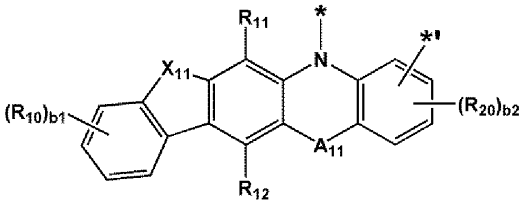

Formule 11(3)

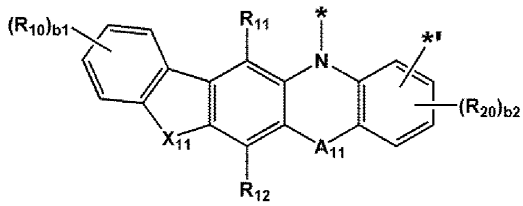

Formule 11(4)

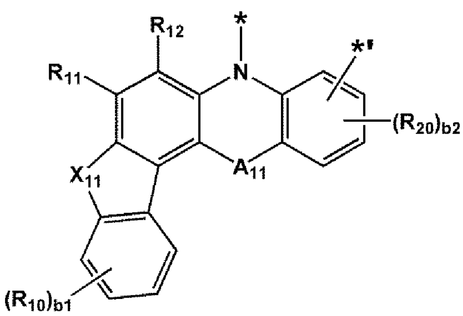

Formule 11(5)

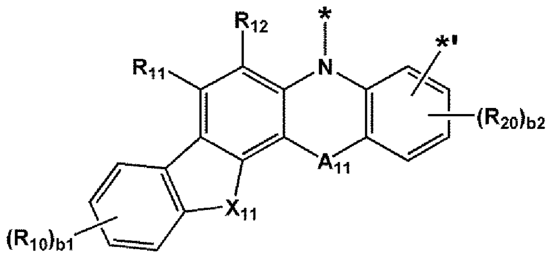

Formule 11(6)

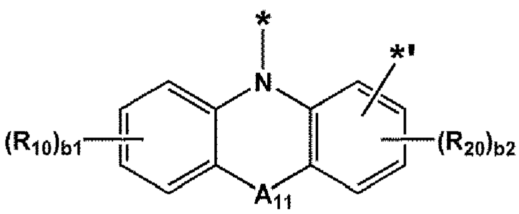

Formule 11(7)

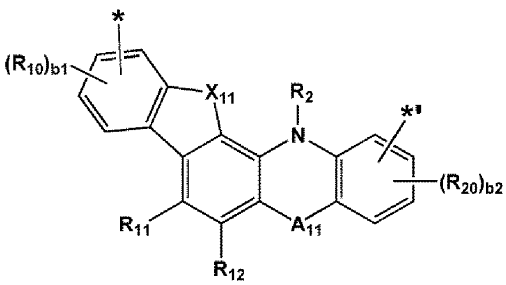

Formule 11(8)

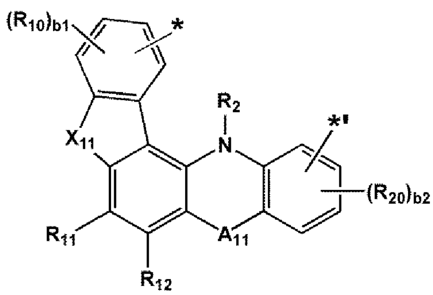

Formule 11(9)

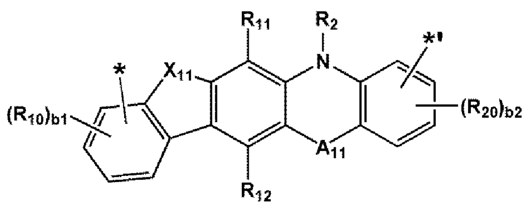

**Formule 11(10)**

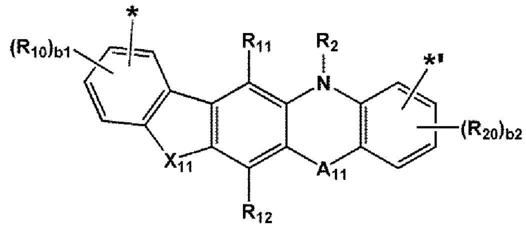

**Formule 11(11)**

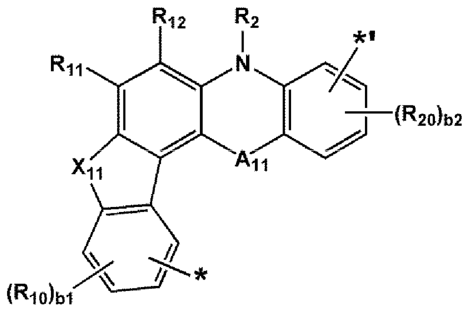

**Formule 11(12)**

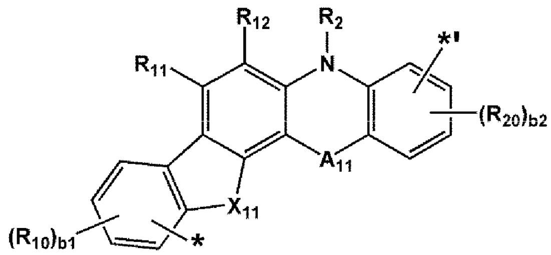

**Formule 11(13)**

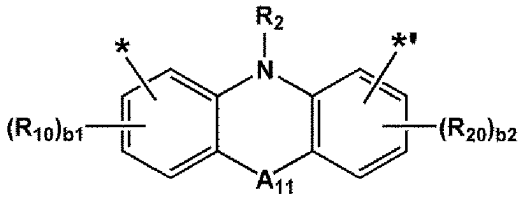

**Formule 11(14)**

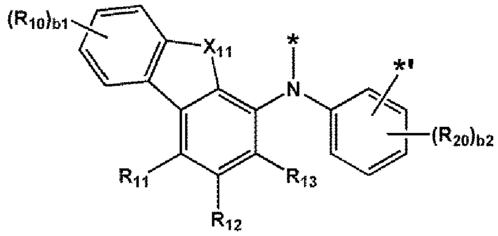

**Formule 11(15)**

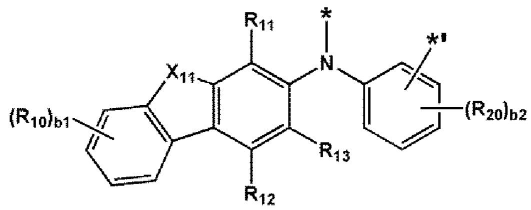

**Formule 11(16)**

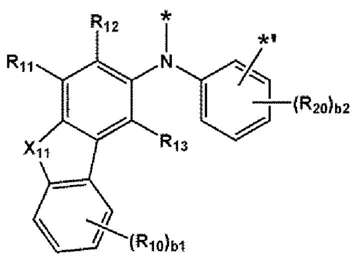

**Formule 11(17)**

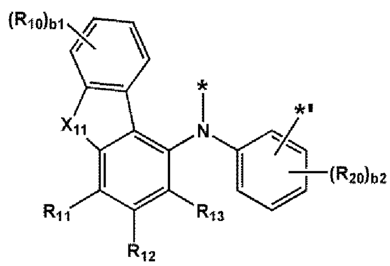

**Formule 11(18)**

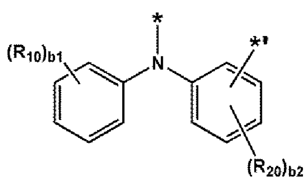

**Formule 11(19)**

dans les formules 11(1) à 11(19),
$X_{11}$ est O, S, $C(R_{14})$, ou $N(R_{15})(R_{16})$,
$A_{11}$, $R_2$, $R_{10}$, $R_{20}$, b1 et b2 étant chacun indépendamment les mêmes que ceux décrits ci-dessus,

$R_{11}$ à $R_{16}$ étant chacun indépendamment les mêmes que ceux décrits en relation avec $R_{10}$, et
* et *' indiquant chacun un site de liaison à un atome voisin.

**6.** Dispositif électroluminescent organique selon la revendication 5,
$R_{10}$ à $R_{16}$ et $R_{20}$ étant chacun indépendamment choisis parmi l'hydrogène, le deutérium, un groupe cyano, un groupe alkyle en $C_1$-$C_{20}$, un groupe alcoxy en $C_1$-$C_{20}$, un groupe phényle, un groupe biphényle, un groupe terphényle, un groupe naphtyle, un groupe fluorényle, un groupe diméthylfluorényle, un groupe diphénylfluorényle, un groupe carbazolyle, un groupe phénylcarbazolyle, un groupe biphénylcarbazolyle, un groupe dibenzofuranyle et un groupe dibenzothiophényle.

**7.** Dispositif électroluminescent organique selon l'une quelconque des revendications 1 à 6, d1 valant 1.

**8.** Dispositif électroluminescent organique selon l'une quelconque des revendications 1 à 7,

$A_1$ étant choisi parmi les groupes représentés par les formules 3-1 à 3-14 et un groupe contenant un sulfonyle :

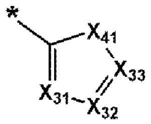

**Formule 3-1**

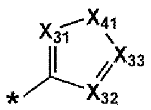

**Formule 3-2**

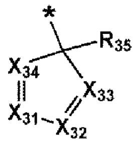

**Formule 3-3**

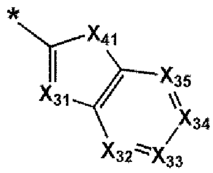

**Formule 3-4**

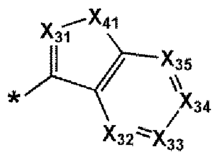

**Formule 3-5**

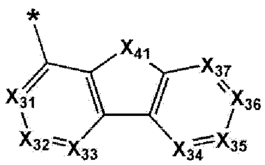

**Formule 3-6**

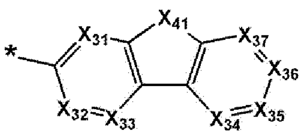

**Formule 3-7**

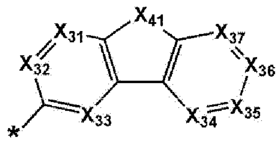

**Formule 3-8**

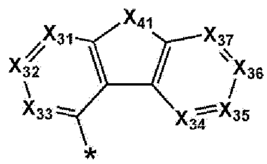

**Formule 3-9**

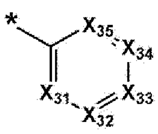

**Formule 3-10**

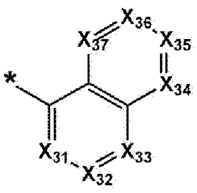

**Formule 3-11**

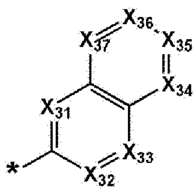

**Formule 3-12**

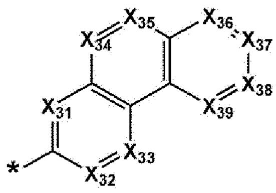

**Formule 3-13**

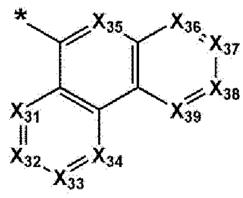

**Formule 3-14**

dans les formules 3-1 à 3-14, $X_{31}$ étant N ou $C(R_{31})$, $X_{32}$ étant N ou $C(R_{32})$, $X_{33}$ étant N ou $C(R_{33})$, $X_{34}$ étant N ou $C(R_{34})$, $X_{35}$ étant N ou $C(R_{35})$, $X_{36}$ étant N ou $C(R_{36})$, $X_{37}$ étant N ou $C(R_{37})$, $X_{38}$ étant N ou $C(R_{38})$ et $X_{39}$ étant N ou $C(R_{39})$,
$X_{41}$ dans les formules 3-1, 3-2 et 3-4 à 3-9 étant $N(R_{41})$, $C(R_{42})(R_{43})$, O ou S,
au moins un des $X_{31}$ à $X_{33}$ dans les formules 3-1 et 3-2 étant N, au moins un des $X_{31}$ à $X_{34}$ dans la formule 3-3 étant N, au moins un des $X_{31}$ à $X_{35}$ dans les formules 3-4, 3-5 et 3-10 étant N, au moins un élément parmi $X_{31}$ à $X_{37}$ dans les formules 3-6 à 3-9, 3-11 et 3-12 étant N, et au moins un élément parmi $X_{31}$ à $X_{39}$ dans les formules 3-13 et 3-14 étant N,
$R_{31}$ à $R_{39}$ et $R_{41}$ à $R_{43}$ étant chacun indépendamment choisis parmi l'hydrogène, le deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{20}$, un groupe alcoxy en $C_1$-$C_{20}$, un groupe phényle, un groupe (alkyle en $C_1$-$C_{20}$) phényle, un groupe di(alkyle en $C_1$-$C_{20}$)phényle, un groupe tri(alkyle en $C_1$-$C_{20}$)phényle, un groupe (aryle en $C_6$-$C_{20}$)phényle, un groupe di(aryle en $C_6$-$C_{20}$)phényle, un groupe tri(aryle en $C_6$-$C_{20}$)phényle, un groupe (hétéroaryle en $C_3$-$C_{20}$)phényle, un groupe di(hétéroaryle en $C_3$-$C_{20}$)phényle, un groupe pyridinyle, un groupe

(alkyle en $C_1$-$C_{20}$)pyridinyle, un groupe di(alkyle en $C_1$-$C_{20}$)pyridinyle, un groupe (aryle en $C_6$-$C_{20}$)pyridinyle, un groupe di(aryle en $C_6$-$C_{20}$)pyridinyle, un groupe (hétéroaryle en $C_3$-$C_{20}$)pyridinyle, un groupe di(hétéroaryle en $C_3$-$C_{20}$)pyridinyle, un groupe pyrimidinyle, un groupe (alkyle en $C_1$-$C_{20}$)pyrimidinyle, un groupe di(alkyle en $C_1$-$C_{20}$)pyrimidinyle, un groupe (aryle en $C_6$-$C_{20}$)pyrimidinyle, un groupe di(aryle en $C_6$-$C_{20}$)pyrimidinyle, un groupe (hétéroaryle en $C_3$-$C_{20}$)pyrimidinyle, un groupe di(hétéroaryle en $C_3$-$C_{20}$)pyrimidinyle, un groupe triazinyle, un groupe (alkyle en $C_1$-$C_{20}$)triazinyle, un groupe di(alkyle en $C_1$-$C_{20}$)triazinyle, un groupe (aryle en $C_6$-$C_{20}$)triazinyle, un groupe di(aryle en $C_6$-$C_{20}$)triazinyle, un groupe (hétéroaryle en $C_3$-$C_{20}$)triazinyle et un groupe di(hétéroaryle en $C_3$-$C_{20}$)triazinyle, et

* indiquant un site de liaison à un atome voisin.

**9.** Dispositif électroluminescent organique selon l'une quelconque des revendications 1 à 7,

$A_1$ étant choisi parmi les groupes représentés par les formules 3-4(1) à 3-4(4), 3-5(1) à 3-5(4), 3-6(1), 3-7(1), 3-8(1), 3-9(1), 3-10(1) à 3-10(8), 3-11 (1) à 3-11(23) et 3-12(1) à 3-12(24) :

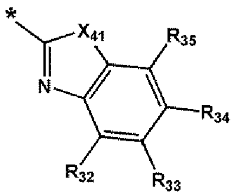
Formule 3-4(1)

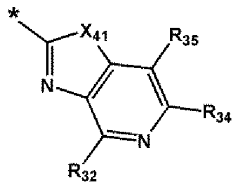
Formule 3-4(2)

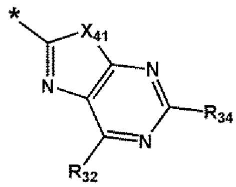
Formule 3-4(3)

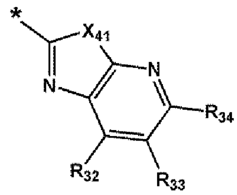
Formule 3-4(4)

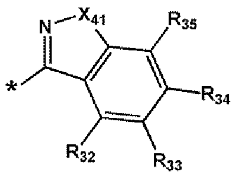
Formule 3-5(1)

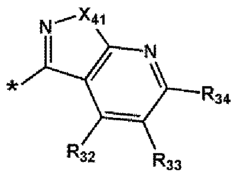
Formule 3-5(2)

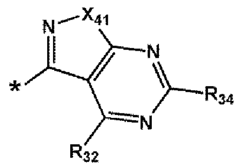
Formule 3-5(3)

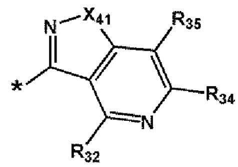
Formule 3-5(4)

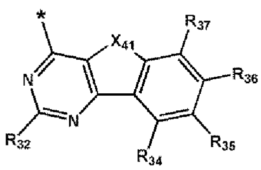
Formule 3-6(1)

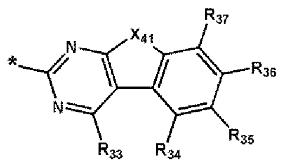
Formule 3-7(1)

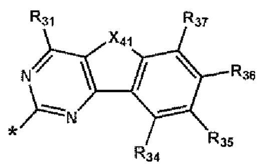
Formule 3-8(1)

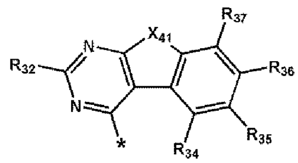
Formule 3-9(1)

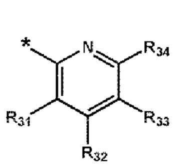
Formule 3-10(1)

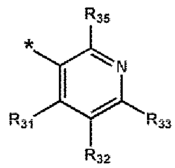
Formule 3-10(2)

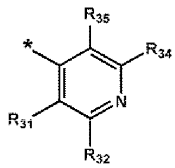
Formule 3-10(3)

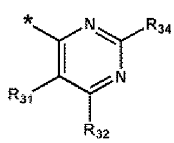
Formule 3-10(4)

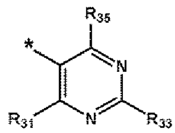
Formule 3-10(5)

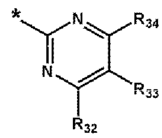
Formule 3-10(6)

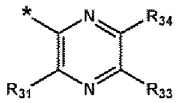
**Formule 3-10(7)**

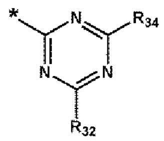
**Formule 3-10(8)**

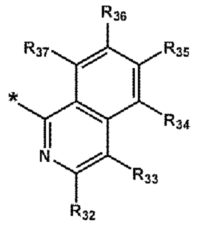
**Formule 3-11(1)**

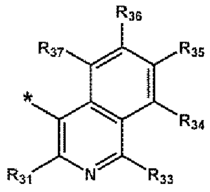
**Formule 3-11(2)**

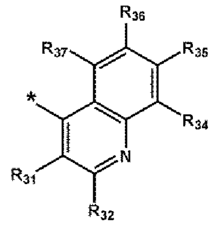
**Formule 3-11(3)**

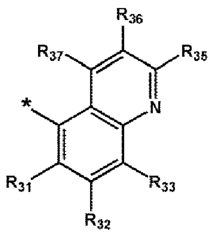
**Formule 3-11(4)**

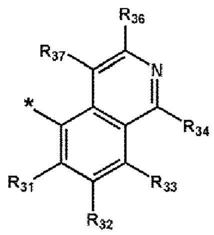
**Formule 3-11(5)**

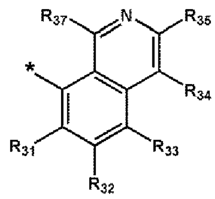
**Formule 3-11(6)**

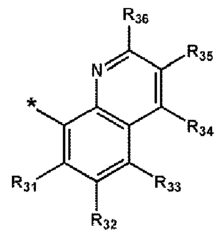
**Formule 3-11(7)**

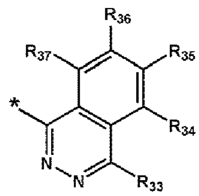
**Formule 3-11(8)**

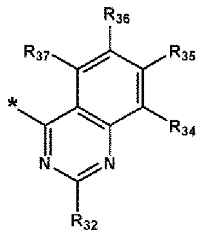
**Formule 3-11(9)**

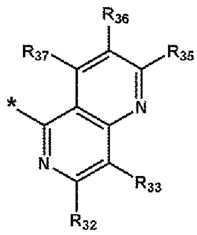
**Formule 3-11(10)**

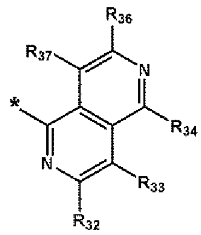
**Formule 3-11(11)**

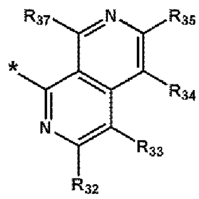
**Formule 3-11(12)**

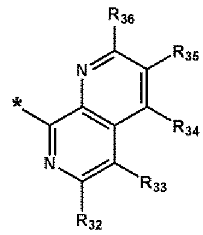
**Formule 3-11(13)**

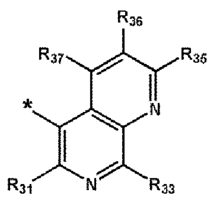
**Formule 3-11(14)**

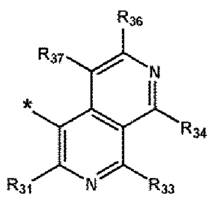
**Formule 3-11(15)**

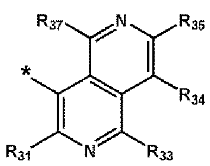
**Formule 3-11(16)**

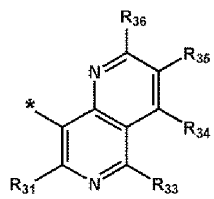
**Formule 3-11(17)**

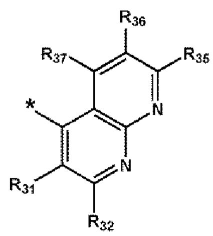
**Formule 3-11(18)**

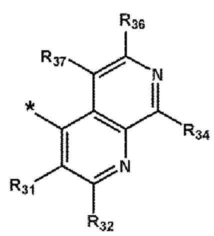
**Formule 3-11(19)**

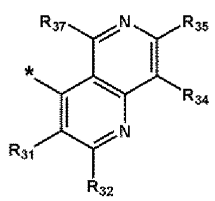
**Formule 3-11(20)**

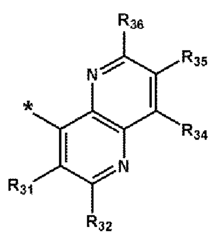
**Formule 3-11(21)**

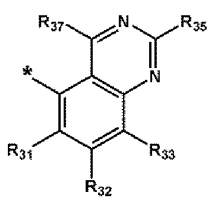
**Formule 3-11(22)**

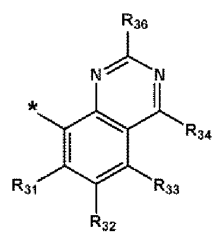
**Formule 3-11(23)**

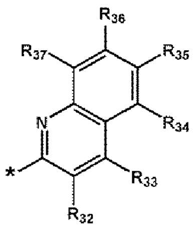 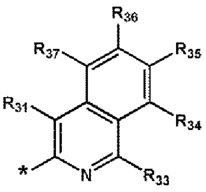 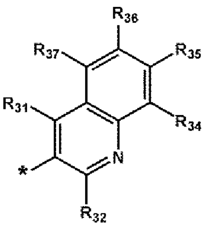 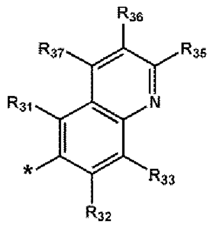 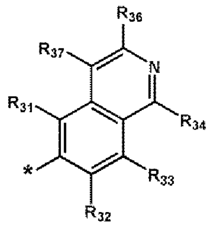

**Formule 3-12(1) Formule 3-12(2) Formule 3-12(3) Formule 3-12(4) Formule 3-12(5)**

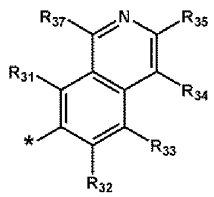 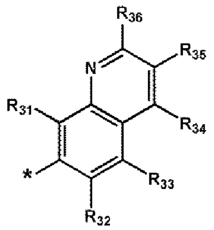 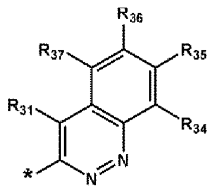 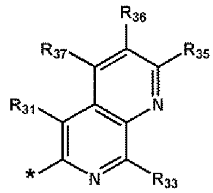 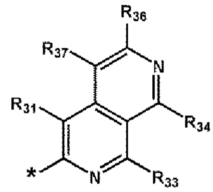

**Formule 3-12(6) Formule 3-12(7) Formule 3-12(8) Formule 3-12(9) Formule 3-12(10)**

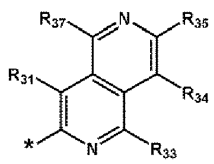 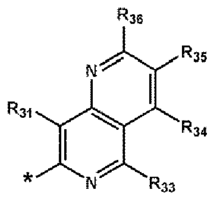 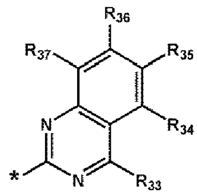 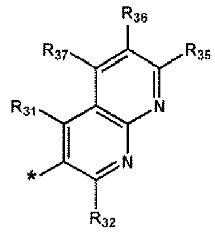 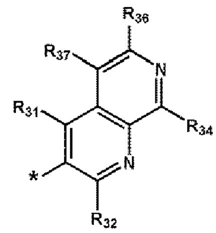

**Formule 3-12(11) Formule 3-12(12) Formule 3-12(13) Formule 3-12(14) Formule 3-12(15)**

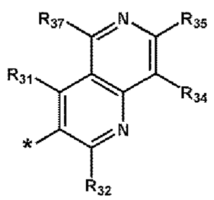 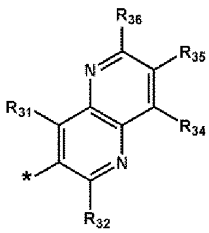 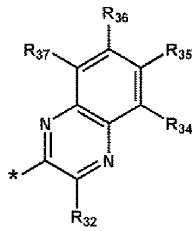 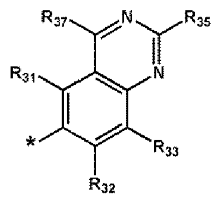 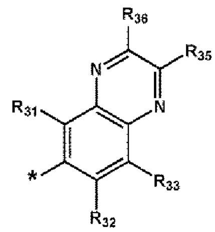

**Formule 3-12(16) Formule 3-12(17) Formule 3-12(18) Formule 3-12(19) Formule 3-12(20)**

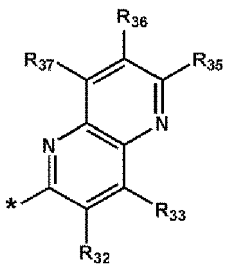 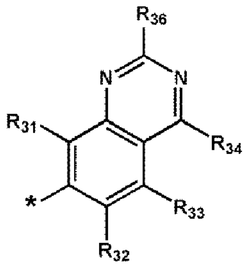 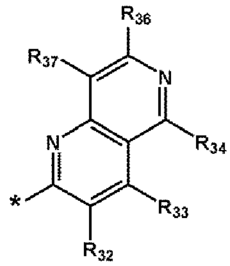 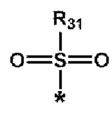

**Formule 3-12(21) Formule 3-12(22) Formule 3-12(23) Formule 3-12(24)**

dans les formules 3-4(1) à 3-4(4), 3-5(1) à 3-5(4), 3-6(1), 3-7(1), 3-8(1), 3-9(1), 3-10(1) à 3-10(8), 3-11 (1) à 3-11 (23) et 3-12(1) à 3-12(24),

$X_{41}$ étant $N(R_{41})$, $C(R_{42})(R_{43})$, O ou S,

$R_{31}$ à $R_{37}$ et $R_{41}$ à $R_{43}$ étant chacun indépendamment choisis parmi l'hydrogène, le deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe

amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{10}$, un groupe alcoxy en $C_1$-$C_{10}$, un groupe phényle, un groupe (alkyle en $C_1$-$C_{10}$) phényle, un groupe di(alkyle en $C_1$-$C_{10}$)phényle, un groupe tri(alkyle en $C_1$-$C_{10}$)phényle, un groupe biphényle, un groupe di(phényl)phényle, un groupe tri(phényl)phényle, un groupe (pyridinyl)phényle, un groupe di(pyridinyl) phényle, groupe (pyrimidinyl)phényle, un groupe di(pyrimidinyl)phényle, un groupe (triazinyl)phényle, un groupe di(triazinyl)phényle, un groupe (carbazolyl)phényle, un groupe pyridinyle, un groupe (alkyle en $C_1$-$C_{10}$)pyridinyle, un groupe di(alkyle en $C_1$-$C_{10}$)pyridinyle, un groupe (phényl)pyridinyle, un groupe di(phényl)pyridinyle, un groupe (pyridinyl)pyridinyle, un groupe di(pyridinyl)pyridinyle, un groupe (pyrimidinyl)pyridinyle, un groupe di(pyrimidinyl)pyridinyle, un groupe (triazinyle)pyridinyle, un groupe di(triazinyle)pyridinyle, un groupe triazinyle, un groupe (alkyle en $C_1$-$C_{10}$)triazinyle, un groupe di(alkyle en $C_1$-$C_{10}$)triazinyle, un groupe (phényl)triazinyle, un groupe di(phényl)triazinyle, un groupe (pyridinyl)triazinyle, un groupe di(pyridinyl)triazinyle, un groupe (pyrimidinyl)triazinyle, un groupe di(pyrimidinyl)triazinyle, un groupe (triazinyle)triazinyle et un groupe di(triazinyle) triazinyle, et
* indiquant un site de liaison à un atome voisin ;
de préférence
$A_1$ étant choisi parmi les formules 3-6(1), 3-10(4), 3-10(8) et 3-12(24).

**10.** Dispositif électroluminescent organique selon l'une quelconque des revendications 1 à 7,

$A_1$ étant un groupe contenant de la triazine ou un groupe contenant un sulfonyle ; et/ou
$R_1$ étant choisi parmi l'hydrogène, le deutérium, un groupe cyano, un groupe alkyle en $C_1$-$C_{20}$, un groupe alcoxy en $C_1$-$C_{29}$, un groupe phényle, un groupe biphényle, un groupe terphényle, un groupe naphtyle, un groupe fluorényle, un groupe diméthylfluorényle, un groupe diphénylfluorényle, un groupe carbazolyle, un groupe phénylcarbazolyle, un groupe biphénylcarbazolyle, un groupe dibenzofuranyle et un groupe dibenzothiophényle.

**11.** Dispositif électroluminescent organique selon l'une quelconque des revendications 1 à 10,

l'émetteur TADF étant choisi parmi les composés 1 à 11 :

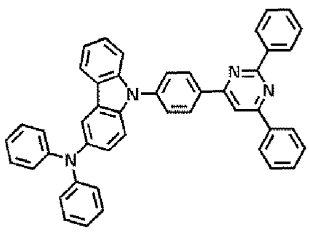
1

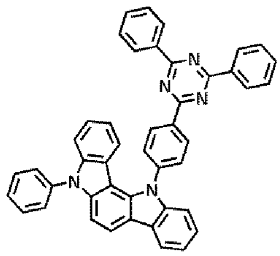
2

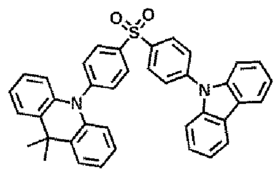
3

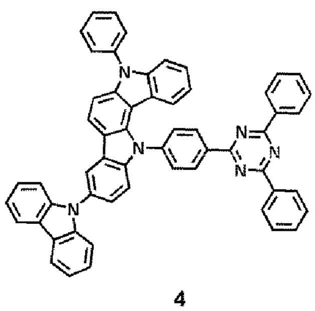
4

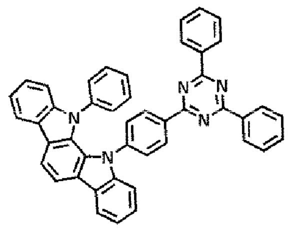
5

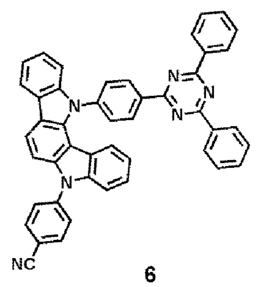
6

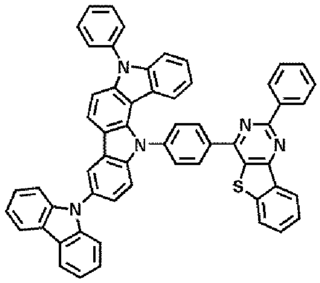

7

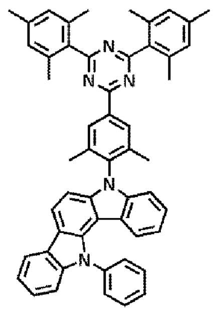

8

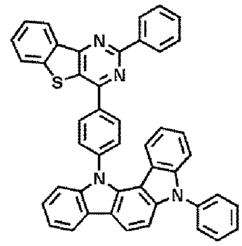

9

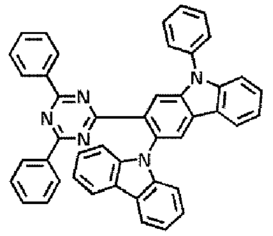

10

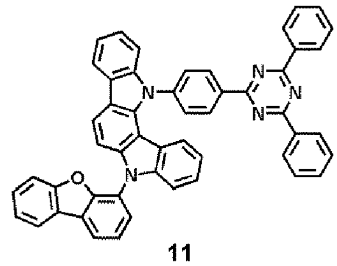

11

; et/ou

dans lequel

l'hôte comprenant au moins un composé choisi parmi un composé contenant du fluorène, un composé contenant du carbazole, un composé contenant du dibenzofurane, un composé contenant du dibenzothiophène, un composé contenant de l'indénocarbazole, un composé contenant de l'indolocarbazole, un composé contenant du benzofurocarbazole, un composé contenant du benzothiénocarbazole, un composé contenant de l'acridine, un composé contenant de la dihydroacridine, un composé contenant du triindolobenzène, un composé contenant de la pyridine, un composé contenant de la pyrimidine, un composé contenant de la triazine, un composé contenant du silicium, un composé contenant un groupe cyano, un composé contenant de l'oxyde de phosphine, un composé contenant du sulfoxyde et un composé contenant un sulfonyle.

**12.** Dispositif électroluminescent organique selon l'une quelconque des revendications 1 à 11,

ledit hôte étant un composé comprenant au moins un cycle carbazole et au moins un groupe cyano ou un composé contenant de l'oxyde de phosphine ; ou

dans lequel

l'hôte comprenant au moins un composé choisi parmi les composés H1 à H22 et le composé H24 :

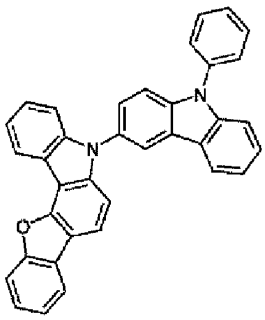

H1

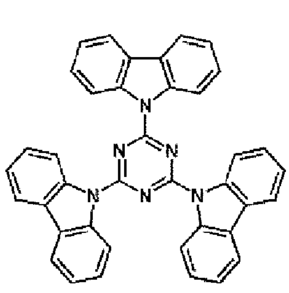

H2

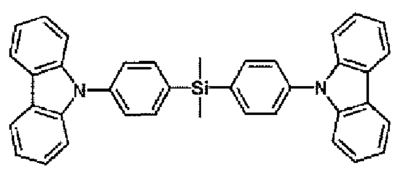

H3

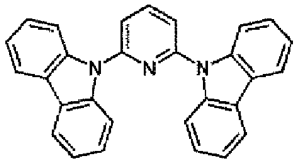

H4

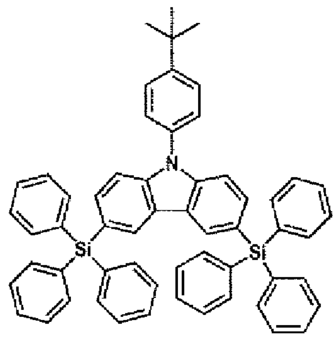

H5

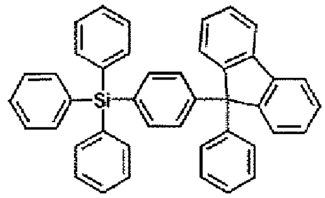

H6

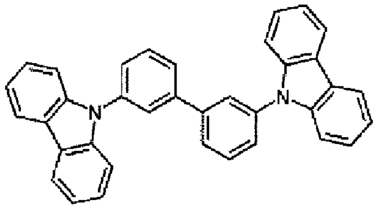

H7

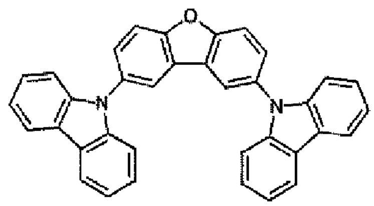

H8

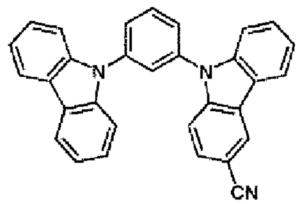

H9

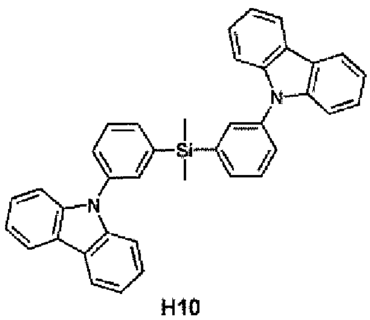

H10

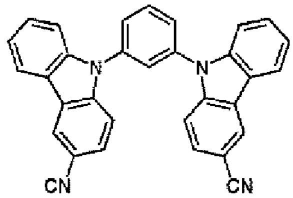

H11

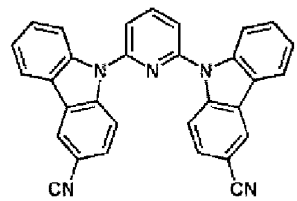

H12

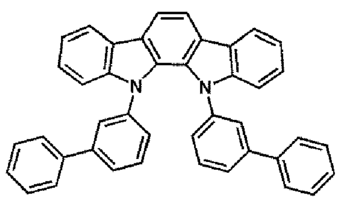

H13

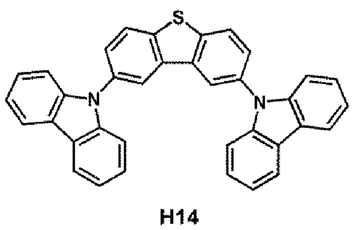

H14

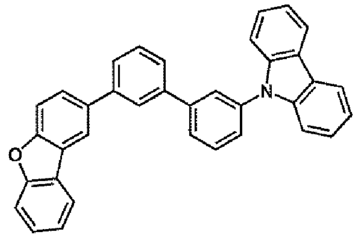

H15

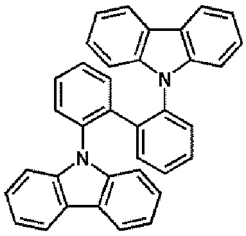

H16

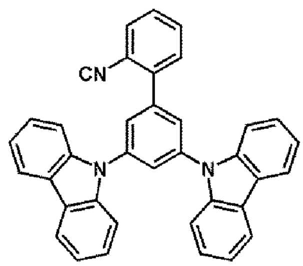

H17

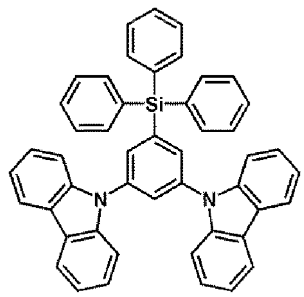

H18

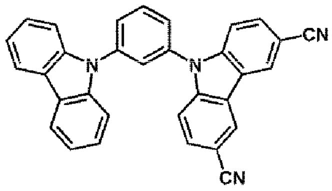
H19

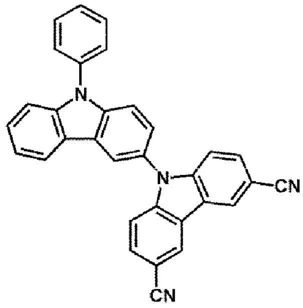
H20

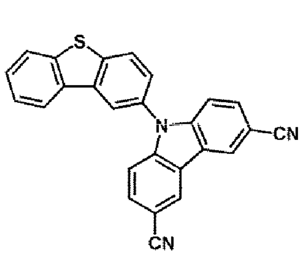
H21

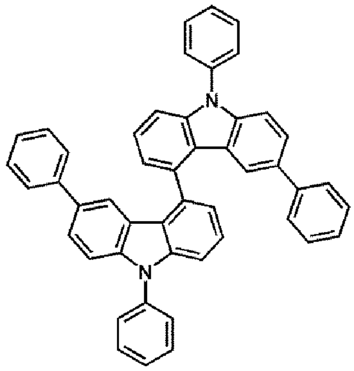
H22

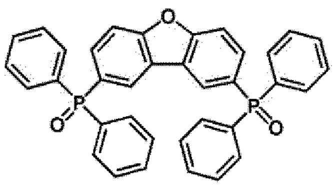
H24

**13.** Dispositif électroluminescent organique selon l'une quelconque des revendications 1 à 12, un rapport entre une composante de fluorescence retardée émise par l'émetteur TADF et une composante d'émission totale de la couche d'émission étant de 30 % ou plus.

**14.** Dispositif électroluminescent organique selon l'une quelconque des revendications 1 à 13,

une quantité de l'émetteur TADF étant inférieure à une quantité de l'hôte ; et/ou
une quantité de l'émetteur TADF dans la couche d'émission étant choisie dans une plage de 0,01 partie en poids à 20 parties en poids sur la base de 100 parties en poids de la couche d'émission.

FIG. 1

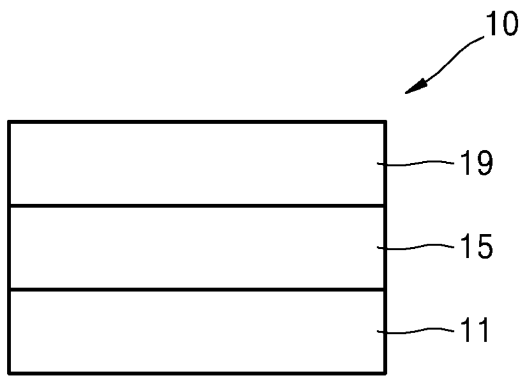

FIG. 2

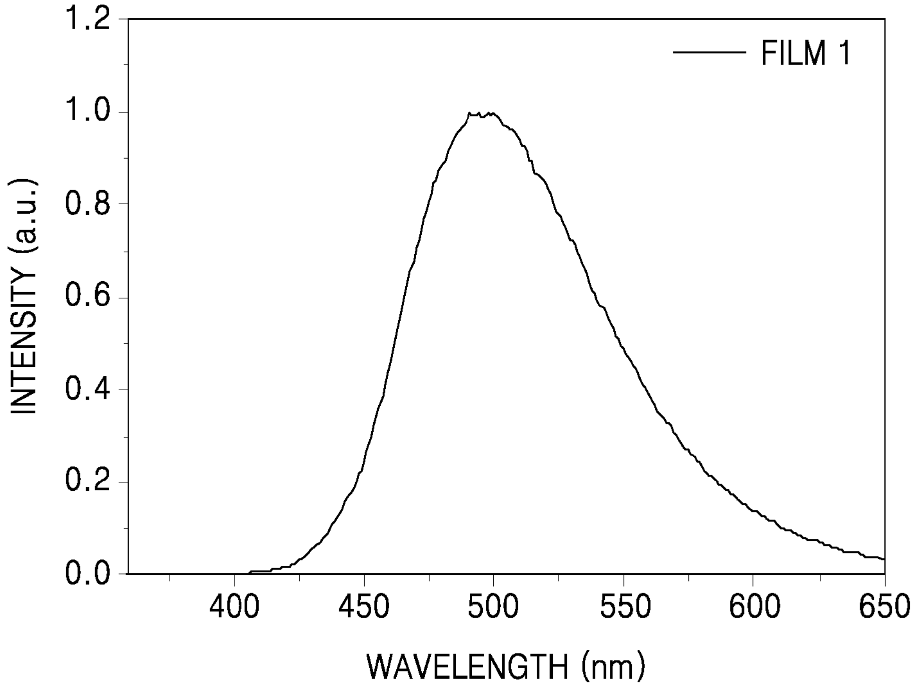
1.2
1.0
0.8
0.6
0.4
0.2
0.0
INTENSITY (a.u.)
FILM 1
400
450
500
550
600
650
WAVELENGTH (nm)

FIG. 3

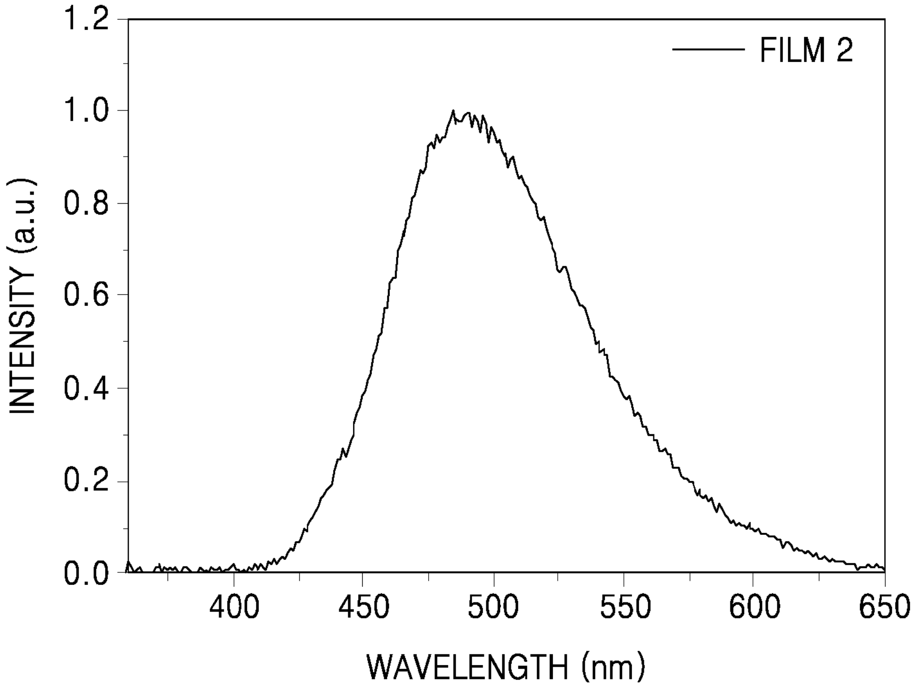
1.2
1.0
0.8
0.6
0.4
0.2
0.0
INTENSITY (a.u.)
FILM 2
400
450
500
550
600
650
WAVELENGTH (nm)

FIG. 4

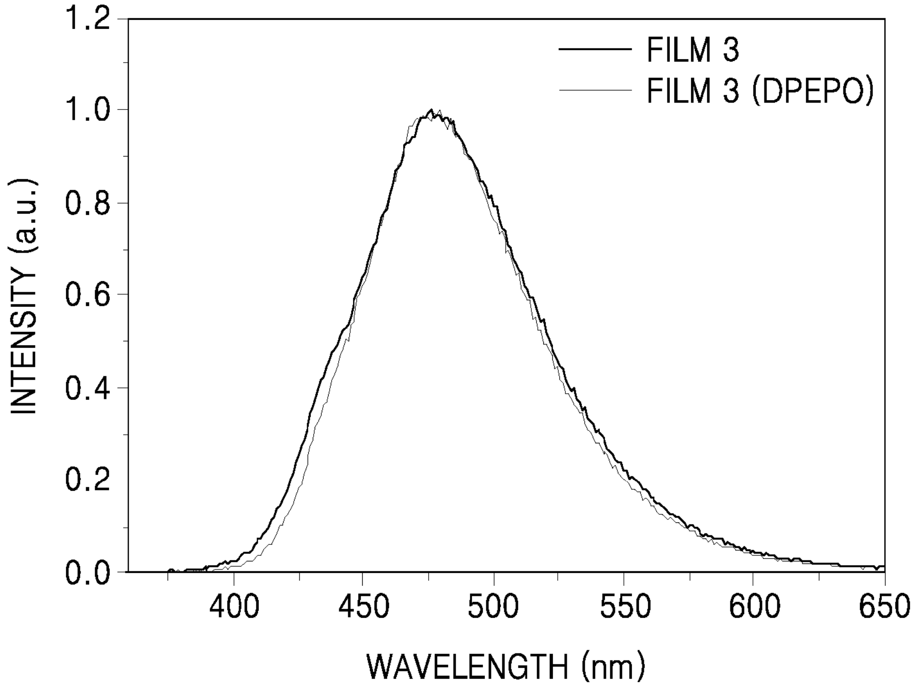
1.2
1.0
0.8
0.6
0.4
0.2
0.0
INTENSITY (a.u.)
400
450
500
550
600
650
WAVELENGTH (nm)
FILM 3
FILM 3 (DPEPO)

FIG. 5

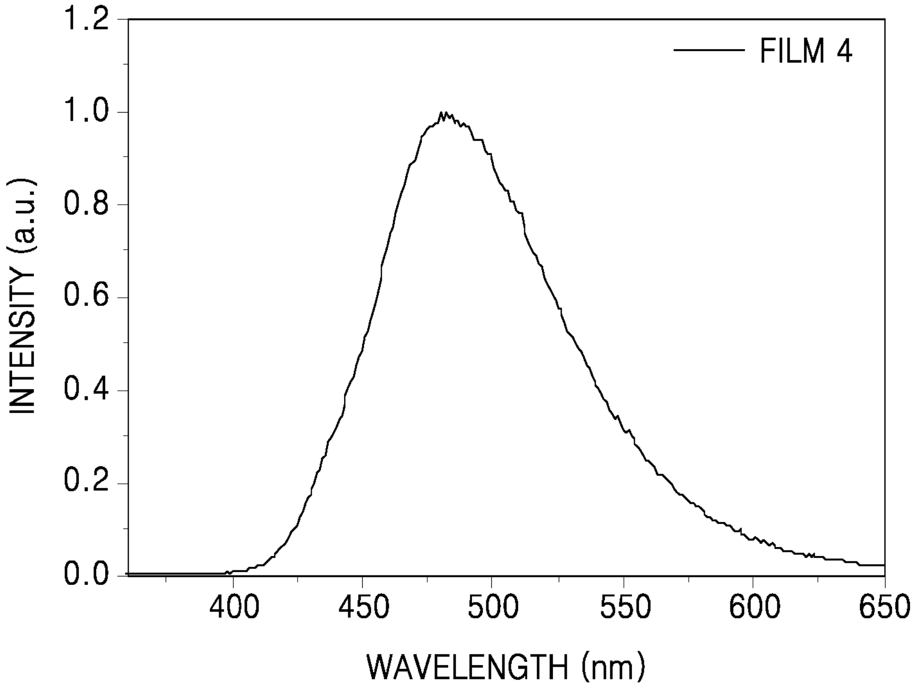
1.2
1.0
0.8
0.6
0.4
0.2
0.0
INTENSITY (a.u.)
400
450
500
550
600
650
WAVELENGTH (nm)
FILM 4

FIG. 6

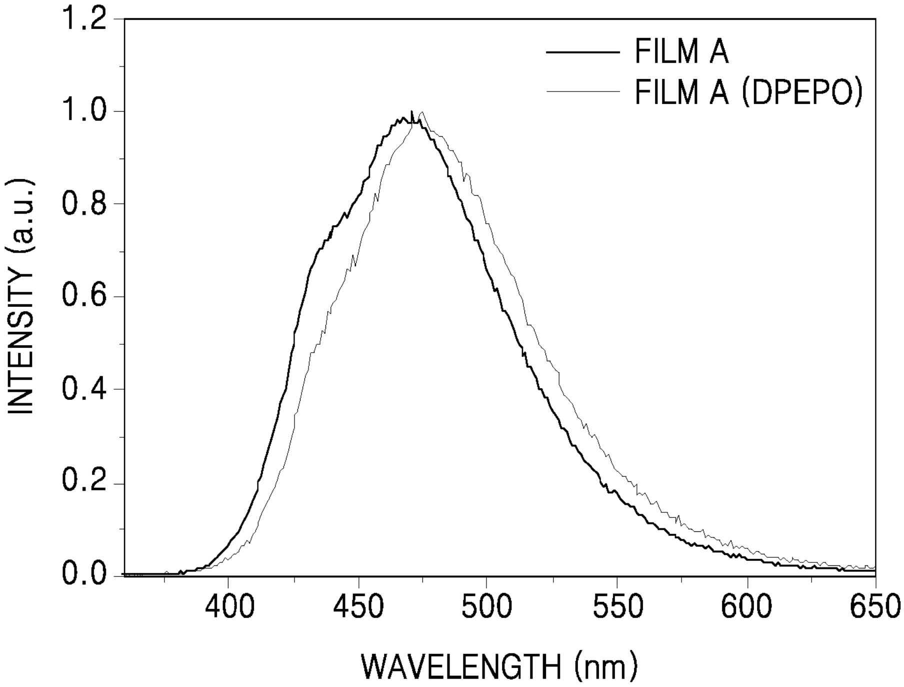
1.2
1.0
0.8
0.6
0.4
0.2
0.0
INTENSITY (a.u.)
400
450
500
550
600
650
WAVELENGTH (nm)
FILM A
FILM A (DPEPO)

FIG. 7

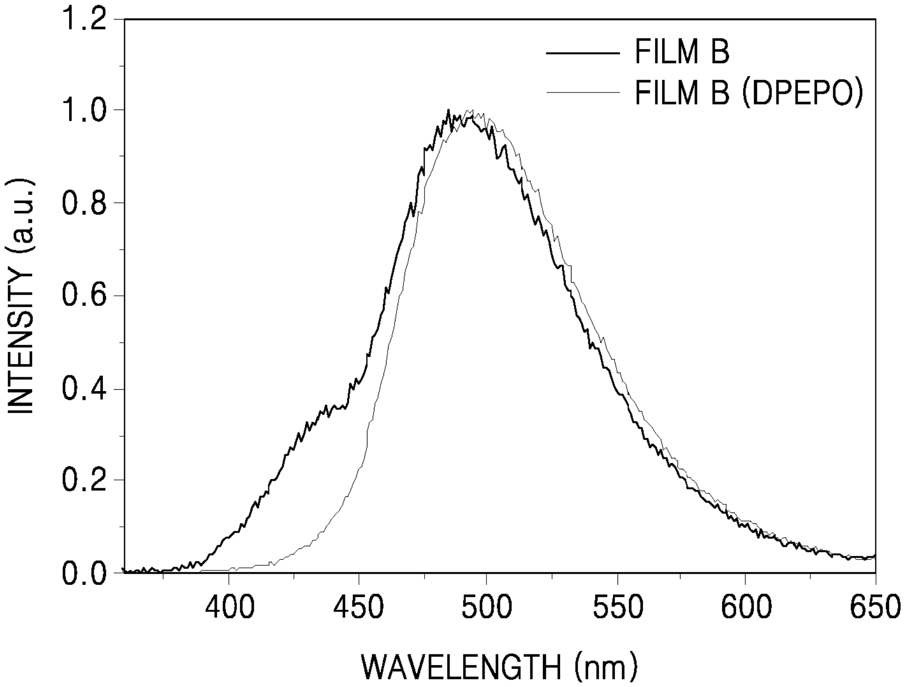
1.2
1.0
0.8
0.6
0.4
0.2
0.0
INTENSITY (a.u.)
400
450
500
550
600
650
WAVELENGTH (nm)
FILM B
FILM B (DPEPO)

FIG. 8

| 10x | ATTACHMENT-DETACHMENT OVERLAP DENSITY OF ROTAMER (10X°) OF COMPOUND 1 |
|---|---|
| -180 | 0.7013 |
| -170 | 0.6979 |
| -160 | 0.5976 |
| -150 | 0.5616 |
| -140 | 0.5779 |
| -130 | 0.7001 |
| -120 | 0.6991 |
| -110 | 0.6986 |
| -100 | 0.6964 |
| -90 | 0.6958 |
| -80 | 0.6925 |
| -70 | 0.6891 |
| -60 | 0.6917 |
| -50 | 0.6937 |
| -40 | 0.6946 |
| -30 | 0.6958 |
| -20 | 0.6963 |
| -10 | 0.6966 |
| 0 | 0.7013 |
| 10 | 0.5786 |
| 20 | 0.5575 |
| 30 | 0.568 |
| 40 | 0.7022 |
| 50 | 0.7026 |
| 60 | 0.7031 |
| 70 | 0.7016 |
| 80 | 0.7006 |
| 90 | 0.6951 |
| 100 | 0.6951 |
| 110 | 0.6891 |
| 120 | 0.6918 |
| 130 | 0.6954 |
| 140 | 0.6986 |
| 150 | 0.7 |
| 160 | 0.6984 |
| 170 | 0.6976 |
| 180 | 0.7013 |

# FIG. 9

| 10x | ATTACHMENT-DETACHMENT OVERLAP DENSITY OF ROTAMER (10X°) OF COMPOUND 2 |
|---|---|
| -180 | 0.46 |
| -170 | 0.46 |
| -160 | 0.47 |
| -150 | 0.48 |
| -140 | 0.53 |
| -130 | 0.84 |
| -120 | 0.85 |
| -110 | 0.85 |
| -100 | 0.85 |
| -90 | 0.85 |
| -80 | 0.85 |
| -70 | 0.85 |
| -60 | 0.85 |
| -50 | 0.84 |
| -40 | 0.62 |
| -30 | 0.48 |
| -20 | 0.47 |
| -10 | 0.46 |
| 0 | 0.46 |
| 10 | 0.46 |
| 20 | 0.47 |
| 30 | 0.48 |
| 40 | 0.53 |
| 50 | 0.84 |
| 60 | 0.85 |
| 70 | 0.85 |
| 80 | 0.85 |
| 90 | 0.85 |
| 100 | 0.85 |
| 110 | 0.85 |
| 120 | 0.85 |
| 130 | 0.84 |
| 140 | 0.62 |
| 150 | 0.48 |
| 160 | 0.47 |
| 170 | 0.46 |
| 180 | 0.46 |

FIG. 10

| 10x | ATTACHMENT-DETACHMENT OVERLAP DENSITY OF ROTAMER (10X°) OF COMPOUND 3 |
|---|---|
| -180 | 0.2 |
| -170 | 0.2 |
| -160 | 0.2 |
| -150 | 0.2 |
| -140 | 0.21 |
| -130 | 0.21 |
| -120 | 0.21 |
| -110 | 0.21 |
| -100 | 0.21 |
| -90 | 0.21 |
| -80 | 0.21 |
| -70 | 0.21 |
| -60 | 0.21 |
| -50 | 0.21 |
| -40 | 0.21 |
| -30 | 0.2 |
| -20 | 0.2 |
| -10 | 0.2 |
| 0 | 0.2 |
| 10 | 0.2 |
| 20 | 0.2 |
| 30 | 0.2 |
| 40 | 0.21 |
| 50 | 0.21 |
| 60 | 0.21 |
| 70 | 0.21 |
| 80 | 0.21 |
| 90 | 0.22 |
| 100 | 0.21 |
| 110 | 0.21 |
| 120 | 0.21 |
| 130 | 0.21 |
| 140 | 0.21 |
| 150 | 0.2 |
| 160 | 0.2 |
| 170 | 0.2 |
| 180 | 0.2 |

FIG. 11

| 10x | ATTACHMENT-DETACHMENT OVERLAP DENSITY OF ROTAMER (10X°) OF COMPOUND 4 |
|---|---|
| -180 | 0.46 |
| -170 | 0.46 |
| -160 | 0.47 |
| -150 | 0.52 |
| -140 | 0.86 |
| -130 | 0.86 |
| -120 | 0.86 |
| -110 | 0.86 |
| -100 | 0.86 |
| -90 | 0.86 |
| -80 | 0.86 |
| -70 | 0.86 |
| -60 | 0.86 |
| -50 | 0.86 |
| -40 | 0.86 |
| -30 | 0.47 |
| -20 | 0.46 |
| -10 | 0.46 |
| 0 | 0.46 |
| 10 | 0.46 |
| 20 | 0.47 |
| 30 | 0.52 |
| 40 | 0.86 |
| 50 | 0.86 |
| 60 | 0.86 |
| 70 | 0.86 |
| 80 | 0.86 |
| 90 | 0.86 |
| 100 | 0.86 |
| 110 | 0.86 |
| 120 | 0.86 |
| 130 | 0.86 |
| 140 | 0.86 |
| 150 | 0.47 |
| 160 | 0.46 |
| 170 | 0.46 |
| 180 | 0.46 |

FIG. 12

| 10x | ATTACHMENT-DETACHMENT OVERLAP DENSITY OF ROTAMER (10X°) OF COMPOUND A |
|---|---|
| -180 | 0.5395 |
| -170 | 0.5312 |
| -160 | 0.5318 |
| -150 | 0.531 |
| -140 | 0.5468 |
| -130 | 0.7165 |
| -120 | 0.8329 |
| -110 | 0.8396 |
| -100 | 0.8403 |
| -90 | 0.8394 |
| -80 | 0.8382 |
| -70 | 0.8374 |
| -60 | 0.8369 |
| -50 | 0.8367 |
| -40 | 0.8361 |
| -30 | 0.8336 |
| -20 | 0.8213 |
| -10 | 0.644 |
| 0 | 0.5395 |
| 10 | 0.5271 |
| 20 | 0.527 |
| 30 | 0.5267 |
| 40 | 0.5382 |
| 50 | 0.6005 |
| 60 | 0.8313 |
| 70 | 0.8423 |
| 80 | 0.8442 |
| 90 | 0.8432 |
| 100 | 0.8419 |
| 110 | 0.8418 |
| 120 | 0.8419 |
| 130 | 0.8412 |
| 140 | 0.839 |
| 150 | 0.8343 |
| 160 | 0.8203 |
| 170 | 0.6182 |
| 180 | 0.5395 |

# FIG. 13

| 10x | ATTACHMENT-DETACHMENT OVERLAP DENSITY OF ROTAMER (10X°) OF COMPOUND B |
|---|---|
| -180 | 0.73 |
| -170 | 0.73 |
| -160 | 0.73 |
| -150 | 0.73 |
| -140 | 0.73 |
| -130 | 0.8 |
| -120 | 0.85 |
| -110 | 0.85 |
| -100 | 0.85 |
| -90 | 0.85 |
| -80 | 0.85 |
| -70 | 0.85 |
| -60 | 0.85 |
| -50 | 0.84 |
| -40 | 0.73 |
| -30 | 0.73 |
| -20 | 0.73 |
| -10 | 0.73 |
| 0 | 0.73 |
| 10 | 0.73 |
| 20 | 0.73 |
| 30 | 0.73 |
| 40 | 0.73 |
| 50 | 0.81 |
| 60 | 0.85 |
| 70 | 0.85 |
| 80 | 0.85 |
| 90 | 0.85 |
| 100 | 0.85 |
| 110 | 0.85 |
| 120 | 0.85 |
| 130 | 0.84 |
| 140 | 0.73 |
| 150 | 0.73 |
| 160 | 0.73 |
| 170 | 0.73 |
| 180 | 0.73 |

FIG. 14

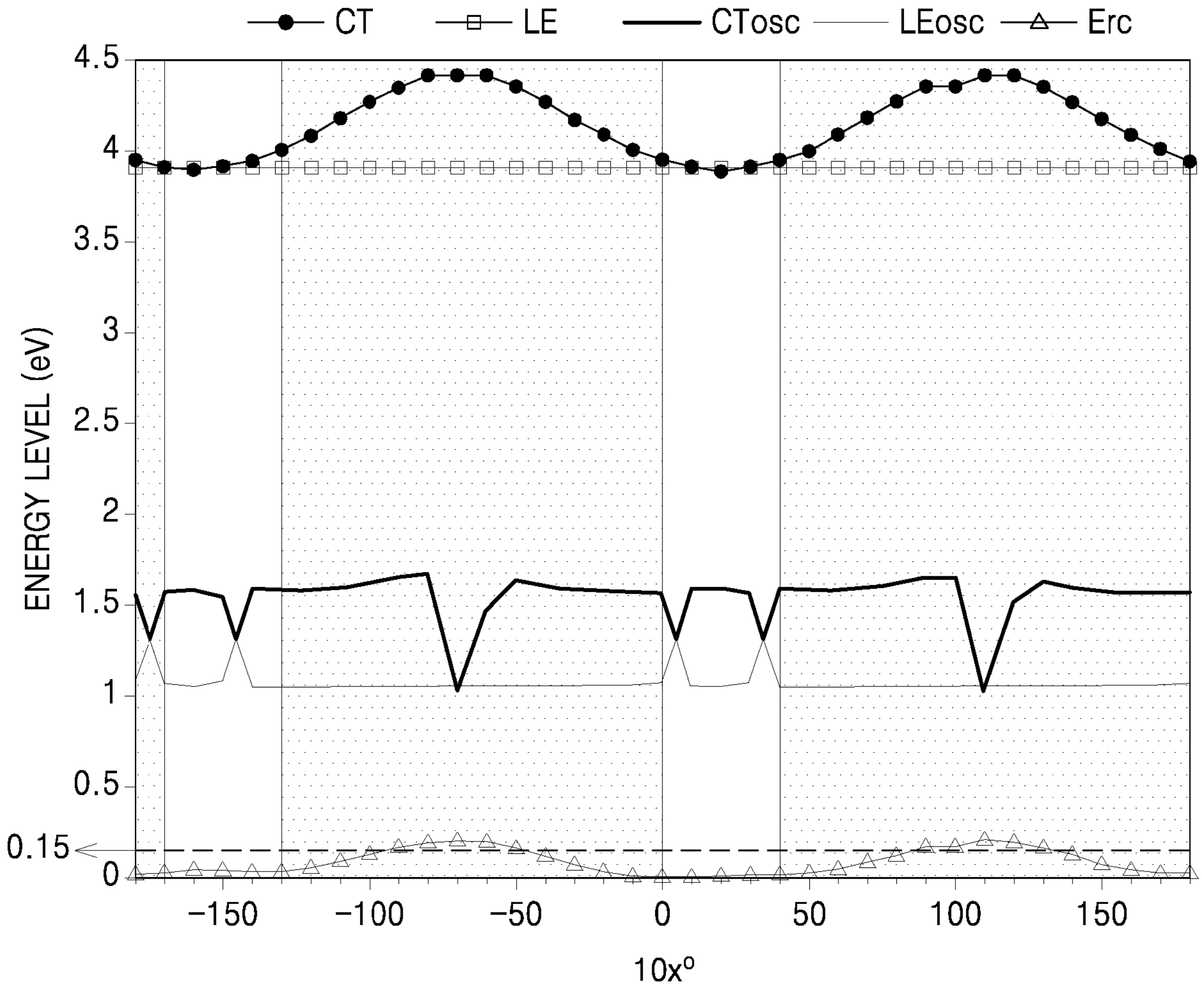
CT
LE
CTosc
LEosc
Erc
4.5
4
3.5
3
2.5
2
1.5
1
0.5
0.15
0
ENERGY LEVEL (eV)
−150
−100
−50
0
50
100
150
10x°

FIG. 15

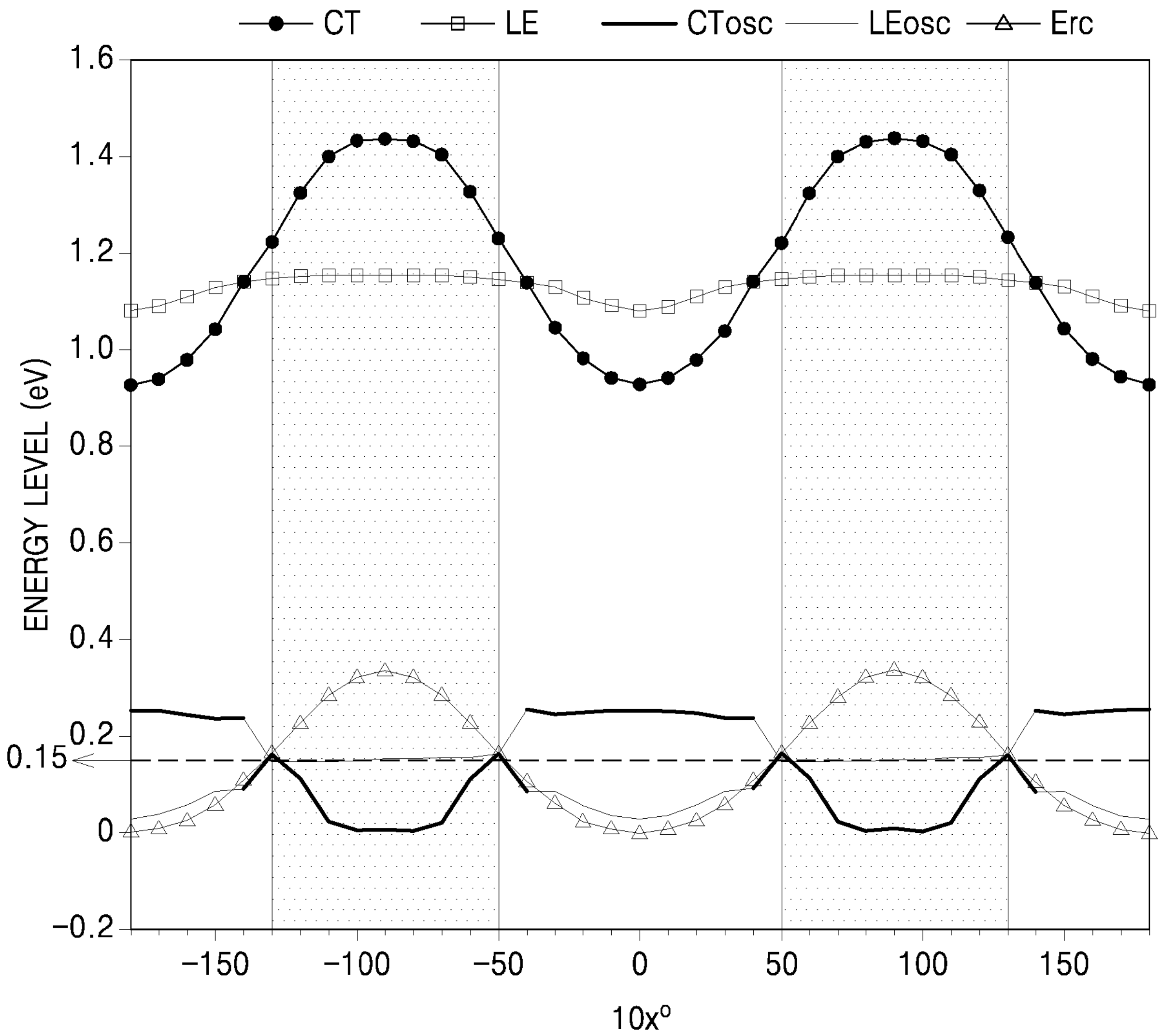
CT
LE
CTosc
LEosc
Erc
1.6
1.4
1.2
1.0
0.8
0.6
0.4
0.2
0.15
0
−0.2
ENERGY LEVEL (eV)
−150
−100
−50
0
50
100
150
10x°

FIG. 16

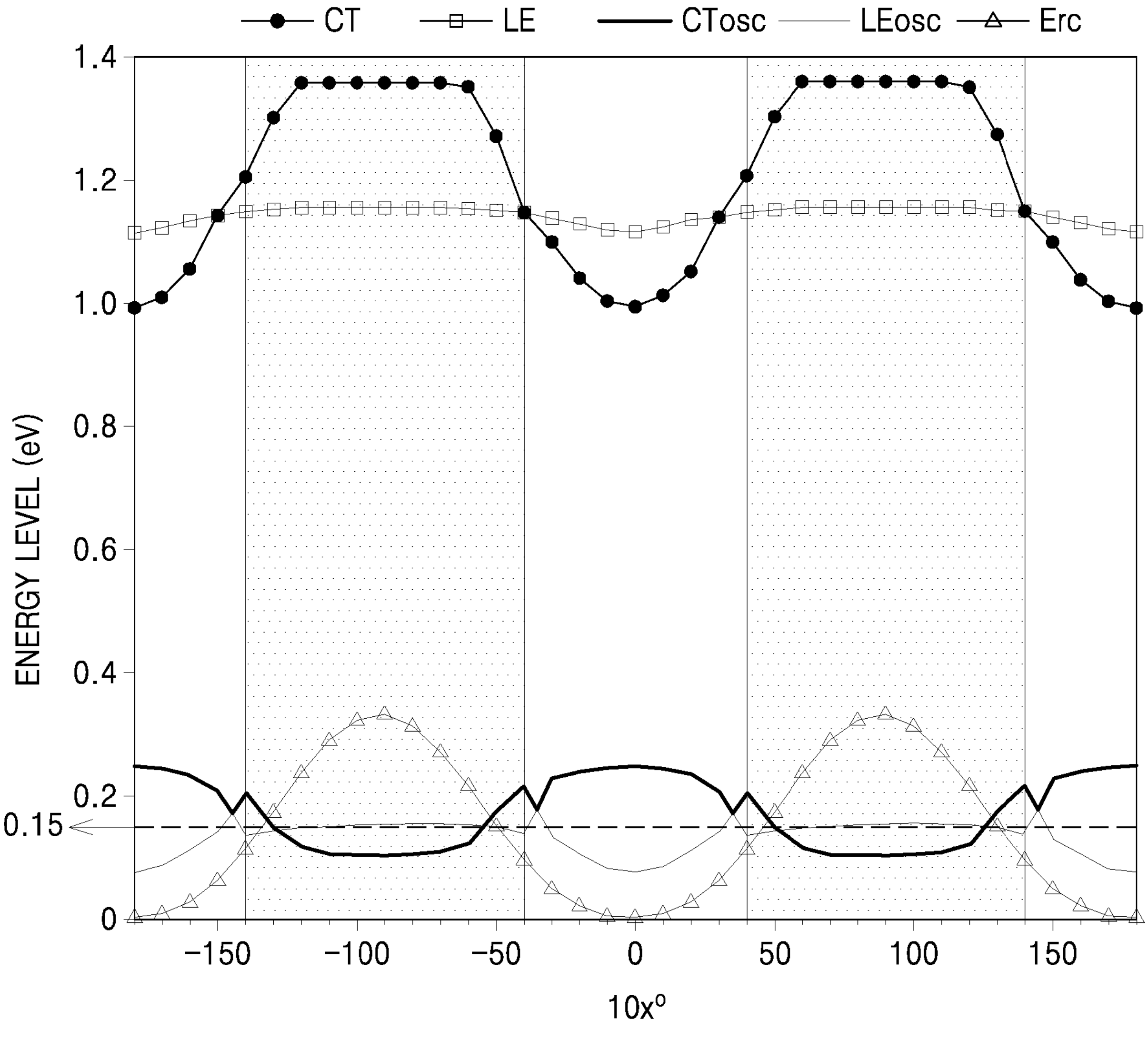

CT
LE
CTosc
LEosc
Erc
1.4
1.2
1.0
0.8
0.6
0.4
0.2
0.15
0
ENERGY LEVEL (eV)
−150
−100
−50
0
50
100
150
10x°

FIG. 17

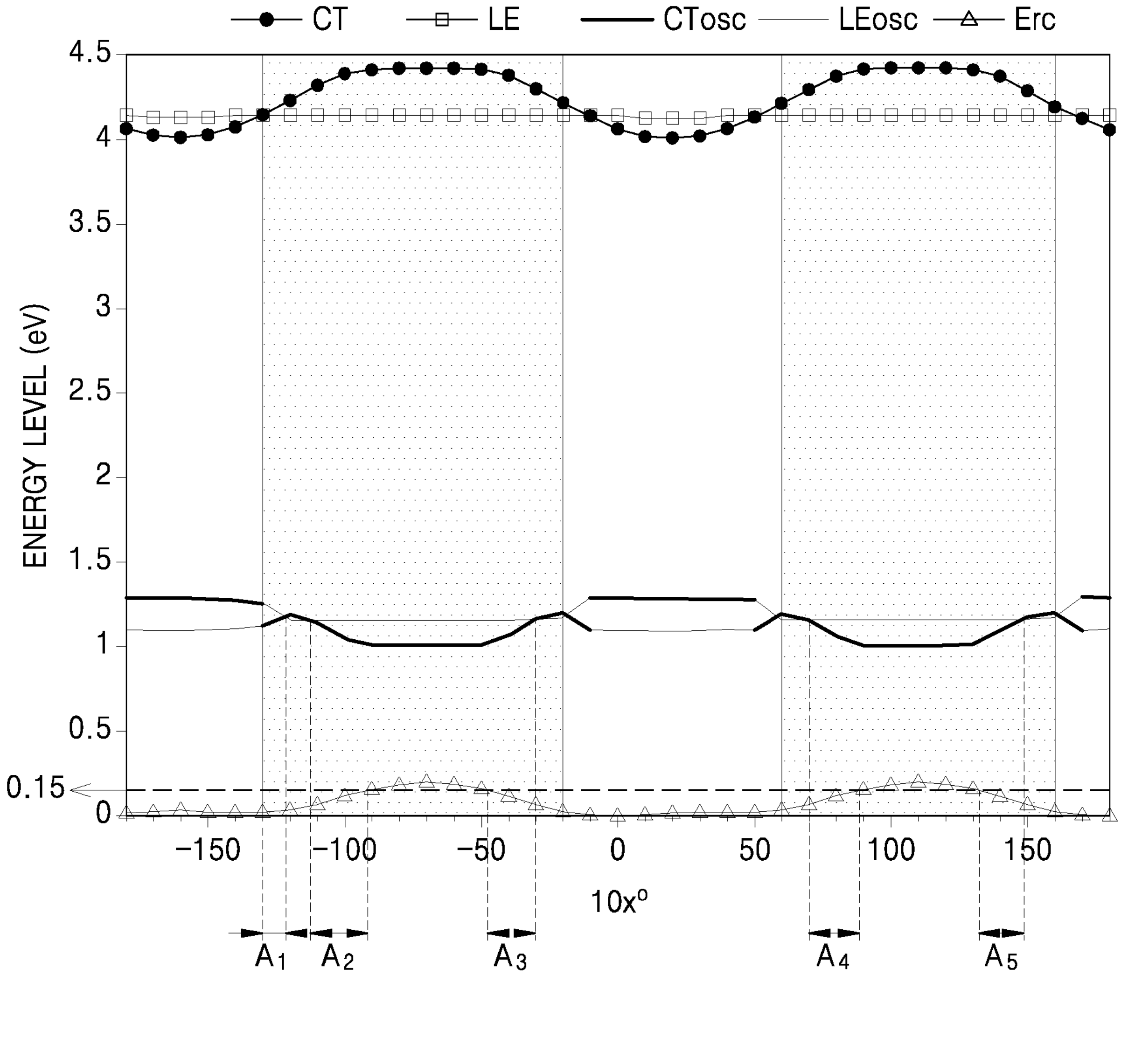
CT
LE
CTosc
LEosc
Erc
ENERGY LEVEL (eV)
4.5
4
3.5
3
2.5
2
1.5
1
0.5
0.15
0
-150
-100
-50
0
50
100
150
10x°
A1
A2
A3
A4
A5

FIG. 18

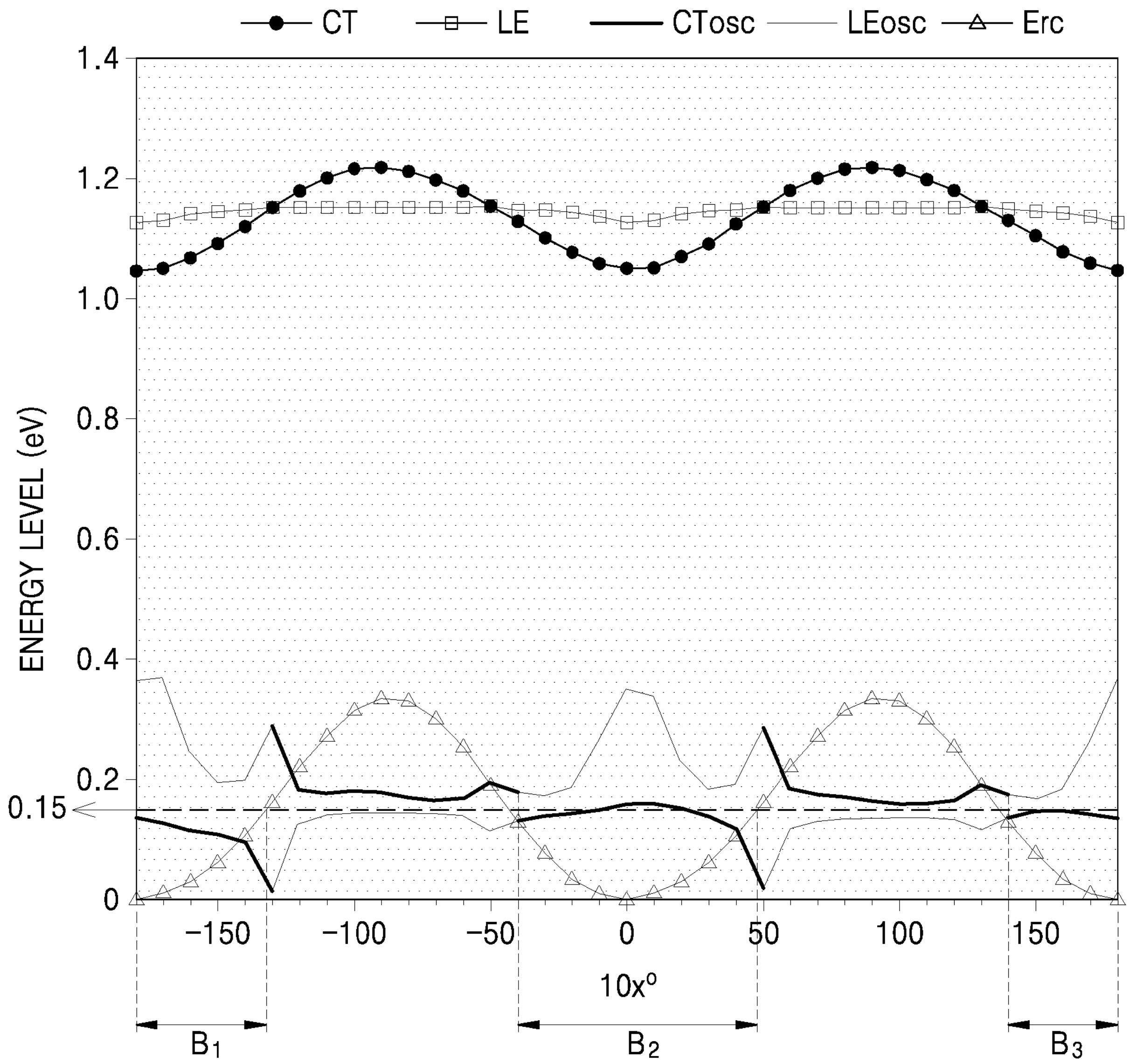
CT
LE
CTosc
LEosc
Erc
ENERGY LEVEL (eV)
1.4
1.2
1.0
0.8
0.6
0.4
0.2
0.15
0
−150
−100
−50
0
50
100
150
10x°
B1
B2
B3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 2733762 A1
- US 20120241732 A1

### Non-patent literature cited in the description


- **IN HO LEE et al.** High efficiency blue fluorescent organic light-emitting diodes using a conventional blue fluorescent emitter. *JOURNAL OF MATERIALS CHEMISTRY C: MATERIALS FOR OPTICAL AND ELECTRONIC DEVICES*, 01 January 2015, vol. 3 (34), 8834-8838
- **RAFAEL GOMEZ-BOMBARELLI et al.** Design of efficient molecular organic light-emitting diodes by a high-throughput virtual screening and experimental approach. *NATURE MATERIALS*, 01 October 2016, vol. 15 (10), 1120-1127
- **HIROKI UOYAMA et al.** Highly efficient organic light-emitting diodes from delayed fluorescence. *Nature*, 12 December 2012, vol. 492 (7428), 234-238